(19) Europäisches Patentamt
European Patent Office
Office européen des brevets

(11) EP 4 082 804 B1

(12) **EUROPEAN PATENT SPECIFICATION**

(45) Date of publication and mention of the grant of the patent:
**14.02.2024 Bulletin 2024/07**

(21) Application number: **20904721.6**

(22) Date of filing: **25.12.2020**

(51) International Patent Classification (IPC):
***B41N 1/08*** *(2006.01)* ***B41N 3/03*** *(2006.01)*
***B41C 1/10*** *(2006.01)*

(52) Cooperative Patent Classification (CPC):
**B41C 1/1008; B41C 1/1016; B41N 1/083; B41N 3/034;** B41C 2210/04; B41C 2210/08; B41C 2210/22

(86) International application number:
**PCT/JP2020/048963**

(87) International publication number:
**WO 2021/132647 (01.07.2021 Gazette 2021/26)**

(54) **LITHOGRAPHIC PRINTING PLATE PRECURSOR, METHOD OF PRODUCING LITHOGRAPHIC PRINTING PLATE, AND PRINTING METHOD**

LITHOGRAFISCHERDRUCKPLATTENVORLÄUFER, VERFAHREN ZUM HERSTELLEN EINER LITHOGRAFISCHEN DRUCKPLATTE UND DRUCKVERFAHREN

PRÉCURSEUR DE PLAQUE D'IMPRESSION LITHOGRAPHIQUE, PROCÉDÉ DE FABRICATION DE PLAQUE D'IMPRESSION LITHOGRAPHIQUE ET PROCÉDÉ D'IMPRESSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.12.2019 JP 2019237970**

(43) Date of publication of application:
**02.11.2022 Bulletin 2022/44**

(73) Proprietor: **FUJIFILM Corporation**
**Tokyo 106-8620 (JP)**

(72) Inventors:
- **MATSUURA Atsushi**
  **Haibara-gun, Shizuoka 421-0396 (JP)**
- **ARIMURA Keisuke**
  **Haibara-gun, Shizuoka 421-0396 (JP)**

(74) Representative: **HGF**
**HGF Limited**
**1 City Walk**
**Leeds LS11 9DX (GB)**

(56) References cited:
**EP-A1- 1 974 912**
**EP-A1- 3 511 172**
**WO-A1-2019/013268**
**WO-A1-2019/044700**
**JP-A- 2006 110 786**
**JP-A- 2011 068 014**
**JP-B1- 6 461 447**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

## BACKGROUND OF THE INVENTION

1. Field of the Invention

The present invention relates to a lithographic printing plate precursor, a method of producing a lithographic printing plate, and a printing method.

2. Description of the Related Art

In recent years, lithographic printing plates are obtained using a computer-to-plate (CTP) technology, and accordingly various research has been conducted

For example, WO2019/087516A discloses a lithographic printing plate precursor formed of a support for a lithographic printing plate that includes an anodized film having predetermined micropores The document EP3511172 A1 discloses a lithographic printing plate precursor comprising an aluminum support; and an image recording layer, wherein the aluminum support includes an aluminum plate and an anodized aluminum film disposed on the aluminum plate, the anodized film is positioned on a side of the image recording layer with respect to the aluminum plate, the anodized film has micropores extending from a surface of the anodized film on the side of the image recording layer in a depth direction. The steepness a45 indicating an area ratio of a portion having an inclining degree of 45° or greater on the surface of the anodized film on the side of the image recording layer, which is obtained by extracting a component having a wavelength of 0.2 to 2 μm, is preferably in a range of 5% to 25%.

## SUMMARY OF THE INVENTION

As a result of research on the lithographic printing plate precursor described in WO2019/087516A, the present inventors clarified that the lithographic printing plate has excellent on-press developability and printing durability of a lithographic printing plate obtained from the lithographic printing plate precursor is also satisfactory, but spot-like stains (hereinafter, also referred to as "slip stains") may be generated in a printed material in a case where printing is performed in a state in which the rotation speed of a watering roller is decreased relative to the rotation speed of the plate cylinder for the purpose of removing foreign matter on the lithographic printing plate precursor.

Therefore, an object of the present invention is to provide a lithographic printing plate precursor which has excellent on-press developability and is capable of suppressing generation of slip stains and from which a lithographic printing plate with satisfactory printing durability is obtained, and a method of producing a lithographic printing plate and a printing method using the lithographic printing plate precursor.

As a result of intensive research conducted by the present inventors in order to achieve the above-described object, it was found that the on-press developability is excellent, the printing durability of a lithographic printing plate obtained from a lithographic printing plate precursor is satisfactory, and generation of slip stains can be suppressed, by using a lithographic printing plate precursor which includes an aluminum support having an anodized film with micropores having a predetermined opening ratio, in which a steepness a45 and an arithmetic average roughness Ra on a surface on an image recording layer side are respectively in a predetermined range, thereby completing the present invention.

That is, the present inventors found that the above-described object can be achieved by employing the following configurations.

A lithographic printing plate precursor comprising: an aluminum support; and an image recording layer, in which the aluminum support includes an aluminum plate and an anodized aluminum film disposed on the aluminum plate, the anodized film is positioned on a side of the image recording layer with respect to the aluminum plate, the anodized film has micropores extending from a surface of the anodized film on the side of the image recording layer in a depth direction, the micropores have an opening ratio of 20% to 70%, a steepness a45 indicating an area ratio of a portion having an inclining degree of 45° or greater on the surface of the anodized film on the side of the image recording layer, which is obtained by extracting a component having a wavelength of 0.2 to 2 μm, is in a range of 3% to 25%, and an arithmetic average roughness Ra on the surface of the anodized film on the side of the image recording layer is in a range of 0.25 to 0.60 μm.

A method of producing a lithographic printing plate, comprising: an exposing step of imagewise-exposing the lithographic printing plate precursor to form an exposed portion and an unexposed portion; and a removing step of removing the unexposed portion of the imagewise-exposed lithographic printing plate precursor.

A printing method comprising: an exposing step of imagewise-exposing the lithographic printing plate precursor to form an exposed portion and an unexposed portion; and a printing step of performing printing by supplying at least one of printing ink or dampening water to remove the unexposed portion of the imagewise-exposed lithographic printing

plate precursor on a printing press.

According to the present invention, it is possible to provide a lithographic printing plate precursor which has excellent on-press developability and is capable of suppressing generation of slip stains and from which a lithographic printing plate with satisfactory printing durability is obtained, and a method of producing a lithographic printing plate and a printing method using the lithographic printing plate precursor.

**BRIEF DESCRIPTION OF THE DRAWINGS**

Fig. 1 is a schematic cross-sectional view illustrating an embodiment of a lithographic printing plate precursor of the present invention.
Fig. 2 is a schematic cross-sectional view illustrating an embodiment of an aluminum support.
Fig. 3 is a graph showing an example of an alternating waveform current waveform diagram used for an electrochemical roughening treatment according to a method of producing an aluminum support.
Fig. 4 is a side view illustrating an example of a radial type cell in the electrochemical roughening treatment carried out using an alternating current according to the method of producing an aluminum support.
Fig. 5 is a schematic cross-sectional view illustrating another embodiment of an aluminum support.
Fig. 6 is a schematic view illustrating an anodization treatment device used for an anodization treatment in preparation of the aluminum support.

**DESCRIPTION OF THE PREFERRED EMBODIMENTS**

Hereinafter, the present invention will be described in detail.

The description of constituent elements below is made based on representative embodiments of the present invention in some cases, but the present invention is not limited to such embodiments.

In addition, in the present specification, a numerical range shown using "to" indicates a range including numerical values described before and after "to" as a lower limit and an upper limit.

Further, in the present specification, materials corresponding to respective components may be used alone or in combination of two or more kinds thereof. Here, in a case where two or more kinds of materials corresponding to respective components are used in combination, the content of the components indicates the total content of the combined materials unless otherwise specified.

Further, in the present specification, in a case where substitution or unsubstitution is not noted in regard to the notation of a group in a compound represented by a formula and the group may further have a substituent, the group includes not only an unsubstituted group but also a group having a substituent unless otherwise specified. For example, in a formula, the description of "R represents an alkyl group, an aryl group, or a heterocyclic group" means that "R represents an unsubstituted alkyl group, a substituted alkyl group, an unsubstituted aryl group, a substituted aryl group, an unsubstituted heterocyclic group, or a substituted heterocyclic group".

[Lithographic printing plate precursor]

A lithographic printing plate precursor according to the embodiment of the present invention is a lithographic printing plate precursor including an aluminum support and an image recording layer, in which the aluminum support includes an aluminum plate and an anodized aluminum film disposed on the aluminum plate, the anodized film is positioned on a side of the image recording layer with respect to the aluminum plate.

Further, in the lithographic printing plate precursor according to the embodiment of the present invention, the anodized film has micropores extending from a surface of the anodized film on the side of the image recording layer in a depth direction, and the micropores have an opening ratio of 20% to 70%.

Further, in the lithographic printing plate precursor according to the embodiment of the present invention, a steepness a45 indicating an area ratio of a portion having an inclining degree of 45° or greater on the surface of the anodized film on the side of the image recording layer (hereinafter, also simply referred to as "anodized film surface"), which is obtained by extracting a component having a wavelength of 0.2 to 2 $\mu$m, is in a range of 3% to 25%.

Further, in the lithographic printing plate precursor according to the embodiment of the present invention, an arithmetic average roughness Ra on the anodized film surface is in a range of 0.25 to 0.60 $\mu$m.

In the present invention, as described above, the on-press developability is excellent, the printing durability of a lithographic printing plate obtained from a lithographic printing plate precursor is satisfactory, and generation of slip stains can be suppressed, by using a lithographic printing plate precursor which includes an aluminum support having an anodized film with micropores having a predetermined opening ratio, in which the steepness a45 and the arithmetic

average roughness Ra on the anodized film surface are respectively in a predetermined range.

The reason for this is not specifically clear, but the present inventors presume as follows.

That is, it is considered that since the opening ratio of the micropores of the anodized film is in a range of 20% to 70%, an ink is easily landed, and easily removed during on-press development, and thus the on-press developability is excellent and the printing durability of a lithographic printing plate obtained from the lithographic printing plate precursor is satisfactory.

Further, it is considered that since the steepness a45 is in a range of 3% to 25% and the arithmetic average roughness Ra is in a range of 0.25 to 0.60 $\mu$m on the anodized film surface, catching of the ink by grain projections or accumulation of the ink on the grain projections can be suppressed, and thus generation of slip stains in a case where a lithographic printing plate is obtained can be suppressed.

Fig. 1 is a schematic cross-sectional view illustrating an embodiment of the lithographic printing plate precursor of the present invention.

A lithographic printing plate precursor 10 shown in Fig. 1 includes an aluminum support 12a, an undercoat layer 14, and an image recording layer 16.

Fig. 2 is a schematic cross-sectional view illustrating an embodiment of the aluminum support 12a. The aluminum support 12a has a laminated structure in which an aluminum plate 18 and an anodized aluminum film 20a (hereinafter, also simply referred to as "anodized film 20a") are laminated in this order. Further, the anodized film 20a in the aluminum support 12a is positioned on a side of the image recording layer 16 with respect to the aluminum plate 18. That is, the lithographic printing plate precursor 10 includes the aluminum plate 18, the anodized film 20a, an undercoat layer 14, and the image recording layer 16 in this order.

The anodized film 20a has micropores 22a extending from the surface thereof to the aluminum plate 18 side. Further, the term "micropores" here is a general term used to indicate pores in the anodized film and does not specify the size of the pore.

As described in detail below, the undercoat layer 14 is not an indispensable component and is a layer to be disposed as necessary.

Hereinafter, each configuration of the lithographic printing plate 10 will be described in detail.

[Aluminum plate]

The aluminum plate 18 (aluminum support) is a metal, which is dimensionally stable and contains aluminum as a main component, and is formed of aluminum or an aluminum alloy. Examples of the aluminum plate 18 include a pure aluminum plate, an alloy plate containing aluminum as a main component and a trace amount of foreign elements, and a plastic film or paper formed by laminating or depositing aluminum (alloy).

Examples of the foreign elements contained in the aluminum alloy include a silicon element, an iron element, a manganese element, a copper element, a magnesium element, a chromium element, a zinc element, a bismuth element, a nickel element, and a titanium element, and the content of the foreign elements in the alloy is 10% by mass or less. As the aluminum plate 18, a pure aluminum plate is suitable, but completely pure aluminum is difficult to produce in terms of smelting technology, and thus the aluminum plate may contain a trace amount of foreign elements.

The composition of the aluminum plate 18 is not particularly limited, and publicly known materials can be appropriately used (for example, JIS A 1050, JIS A 1100, JIS A 3103, and JIS A 3005).

In the present invention, from the viewpoints of the strength and the electrolytic treatment, it is preferable that the aluminum plate 18 is an aluminum alloy plate containing 0.05% by mass or less of Cu, 0.1% to 0.4% by mass of Fe, 0.02% to 0.3% by mass of Si and that the remainder consists of Al and inevitable impurities.

The width of the aluminum plate 18 is preferably approximately 400 to 2000 mm, and the thickness thereof is preferably approximately 0.1 to 0.6 mm. The width and the thickness thereof can be appropriately changed depending on the size of the printing press, the size of the printing plate, and the user's desire.

[Anodized film]

The anodized film 20a is a film to be prepared on a surface of the aluminum plate 18 by performing an anodization treatment, and this film is substantially perpendicular to the film surface and has extremely fine micropores 22a uniformly distributed. The micropores 22a extend along the thickness direction (the aluminum plate 18 side) from the surface of the anodized film 20a on the side of the image recording layer 16 (the surface of the anodized film 20a on a side opposite to a side where the aluminum plate 18 is provided).

The average diameter (average opening diameter) of the micropores 22a in the surface of the anodized film 20a is preferably in a range of 15 to 100 nm and more preferably in a range of 30 to 100 nm. The diameter inside the pores may be larger or smaller than that of the surface layer.

The average diameter of micropores 22a is obtained by observing 4 sheets (N = 4) of the surfaces of the

anodized film 20a using a field emission scanning electron microscope (FE-SEM) at a magnification of 150000, measuring the diameters of 50 micropores present in a range of 400 × 600 $nm^2$ in the obtained four sheets of images, and averaging the values.

Further, in a case where the shape of the micropores 22a is not circular, an equivalent circle diameter is used. The "equivalent circle diameter" is a diameter of a circle obtained by assuming the shape of an opening portion of a micropore as a circle having the same projected area as the projected area of the opening portion.

In the present invention, the density of the micropores 22a is not particularly limited, but from the viewpoint of the adhesiveness to the image recording layer, the density thereof is preferably in a range of 400 to 2000 pc/$\mu m^2$, more preferably in a range of 500 to 1800 pc/$\mu m^2$, and still more preferably in a range of 600 to 1500 pc/μm2.

In the present invention, the opening ratio of the micropores 22a is in a range of 20% to 70%, preferably in a range of 30% to 70%, and more preferably in a range of 40% to 65%.

Here, the opening ratio is a value calculated by the following equation using a value (total area of opening portions) obtained by multiplying, by the density of the micropores 22a, the average area of the opening portions of the micropores 22a calculated using the average radius obtained by dividing the average diameter of the micropores 22a by 2 and the value of the surface area of the anodized film 20a.

$$\text{Opening ratio (\%)} = 100 \times \text{total area of opening portions/surface area of anodized film 20a}$$

The depth of the micropores 22a is not particularly limited, but is preferably in a range of 10 nm to 3000 nm, more preferably in a range of 50 nm to 2000 nm, and still more preferably 300 nm to 1600 nm.

Further, the depth thereof is a value obtained by capturing (150000 times) an image of a cross section of the anodized film 20a, measuring the depth of 25 or more micropores 22a, and averaging the obtained values.

The shape of the micropores 22a is not particularly limited, and the shape thereof in Fig. 2 may be a substantially straight tubular shape (substantially columnar shape), but may be a conical shape whose diameter decreases toward the depth direction (thickness direction). Further, the shape of the bottom portion of the micropores 22a is not particularly limited, but may be a curved shape (projection shape) or a planar shape.

In the present invention, the steepness a45 indicating the area ratio of a portion having an inclining degree of 45° or greater on the surface of the anodized film 20a on the side of the image recording layer 16, which is obtained by extracting a component having a wavelength of 0.2 to 2 μm, is in a range of 3% to 25%, preferably in a range of 4% to 23%, and more preferably in a range of 5% to 20%.

Here, the steepness a45 is a factor representing the surface shape and is a value acquired according to the following procedures (1) to (3).

(1) The surface shape is measured to acquire three-dimensional data.

Further, the surface shape of the aluminum support 12a on the anodized film 20a side is measured using an atomic force microscope (AFM) to acquire three-dimensional data.

The measurement is performed under the following conditions. Specifically, the aluminum support 12a is cut into a size of 1 $cm^2$ and set on a horizontal sample stand that is provided on a piezo scanner, a cantilever is allowed to approach the surface of the sample, scanning is performed in the XY direction when reaching a region where atomic force works, and the unevenness of the sample is captured by the displacement of the piezo in the Z direction. A piezo scanner capable of performing scanning a distance of 150 μm in the XY direction and a distance of 10 μm in the Z direction is used as the piezo scanner. The measurement is performed using a cantilever having a resonance frequency of 120 kHz to 150 kHz and a spring constant of 12 to 20 N/m (SI-DF20, manufactured by Nanoprobes Inc.) in a dynamic force mode (DFM) as the cantilever. Further, by carrying out the least squares approximation of the acquired three-dimensional data, the slight inclination of the sample is corrected to acquire a reference surface.

During the measurement, 512 × 512 points in an area having a size of 25 × 25 μm on the surface are measured. The resolution in the XY direction is 1.9 μm, the resolution in the Z direction is 1 nm, and the scanning speed is 60 μm/sec.

(2) The correction is performed.

In the calculation of the steepness a45, a component having a wavelength of 0.2 to 2 μm which is subjected to correction to be selected from the three-dimensional data acquired in (1) described above is used. Due to this correction, in a case where a surface of an aluminum support or the like used in the lithographic printing plate precursor which has deep unevenness is scanned using a probe of an AFM, a noise occurring in a case where the probe strikes an edge portion of a projection and springs so that a portion other than a pointed end of the probe is brought into contact with a

wall surface of a deep depression can be eliminated.

The correction is carried out by performing fast Fourier transformation on the three-dimensional data acquired in (1) described above to acquire the frequency distribution, selecting a component having a wavelength of 0.2 to 2 μm, and performing Fourier inverse transformation.

(3) The steepness a45 is calculated.

Three points adjacent to one another are extracted using the three-dimensional data (f(x, y)) obtained by performing correction in (2) described above, an angle between a small triangle formed of these three points and the reference surface is calculated for all pieces of data to acquire the inclining degree distribution curve. In addition, the sum of the area of the small triangle is acquired and this area is set as the actual area. Based on the inclining degree distribution curve, the steepness a45 (unit: %) which is a ratio of the area of a portion having an inclining degree of 45° or greater to the actual area is calculated.

The range of a specific surface area ΔS which is a value acquired by Equation (i) based on a geometrically measured area $S_0$ and an actual area $S_x$ obtained by an approximate three-point method from the three-dimensional data to be obtained by measuring 512 × 512 points in an area having a size of 25 μm × 25 μm on the surface of the anodized film 20a on the side of the image recording layer 16 using an atomic force microscope is not particularly limited, and is 15% or greater in many cases. From the viewpoints of more excellent stain resistance, deinking capability after being left to stand, and image visibility, the specific surface area ΔS is preferably 20% or greater, more preferably in a range of 20% to 40%, and still more preferably in a range of 25% to 35%.

$$\Delta S = (S_x - S_0)/S_0 \times 100\ (\%) \cdots \text{(i)}$$

In the measurement of ΔS described above, the three-dimensional data (f(x, y)) is obtained according to the same procedures as in (1) that is to be performed at the time of calculating the steepness a45.

Next, three points adjacent to one another are extracted using the three-dimensional data (f(x, y)) obtained in the above-described manner, the sum of the area of the small triangle formed of these three points is acquired, and this area is set as an actual area $S_x$. The specific surface area difference ΔS is acquired by Equation (i) described above based on the obtained actual area $S_x$ and the geometrically measured area $S_0$.

In the present invention, the arithmetic average roughness Ra on the surface of the anodized film 20a on the side of the image recording layer 16 is in a range of 0.25 to 0.60 μm, preferably in a range of 0.30 to 0.60 μm, and more preferably in a range of 0.35 to 0.55 μm.

Here, the arithmetic average roughness Ra is obtained by measuring the two-dimensional roughness of the surface of the anodized film 20a on the side of the image recording layer 16 using a stylus type roughness meter (Surfcom 575), measuring the average roughness Ra defined in ISO04287 five times under the following measurement conditions, and employing the average value thereof.

<Measurement conditions>

Cutoff value: 0.8 mm
Inclination correction: FLAT-ML
Measurement length: 3 mm
Scanning speed: 0.3 mm/sec
Diameter of stylus tip: 2 μm

In the present invention, the ratio of the value of the steepness a45 to the value of the arithmetic average roughness Ra on the surface of the anodized film 20a on the side of the image recording layer 16, that is, the ratio (a45/Ra) is preferably in a range of 9 to 80, more preferably in a range of 20 to 70, and still more preferably in a range of 20 to 50.

In the present invention, from the viewpoint of further enhancing the printing durability in a case where a lithographic printing plate is obtained, the density of recesses having a depth of 0.7 μm or greater from a center line (hereinafter, also referred to as "specific recesses"), which is obtained by measurement in a range of 400 μm × 400 μm on the surface of the anodized film 20a on the side of the image recording layer 16, is preferably 900 recesses or more, more preferably in a range of 400 to 900 recesses, and still more preferably in a range of 500 to 850 recesses.

Here, the density of the specific recesses denotes a value measured as follows.

First, a range of 400 μm × 400 μm on the surface of the anodized film is scanned with a resolution of 0.01 μm in a non-contact manner using a non-contact three-dimensional roughness meter (for example, VertScan, manufactured by Ryoka Systems Inc.) to acquire three-dimensional data.

Next, the obtained three-dimensional data is image-analyzed using software (for example, SX Viewer, manufactured by Ryoka System Inc.), and the number of recesses having a depth of 0.70 μm or greater from the center line to be obtained is acquired.

In the present invention, Al-Fe-based intermetallic compounds are precipitated on the surface of the anodized film 20a on the side of the image recording layer 16, the equivalent circle diameter of the Al-Fe-based intermetallic compounds on the surface of the anodized film 20a on the side of the image recording layer 16 is preferably in a range of 0.5 to 3.0 μm, and among the Al-Fe-based intermetallic compounds, the density of intermetallic compounds having an equivalent circle diameter of 0.2 μm or greater on the surface of the anodized film 20a on the side of the image recording layer 16 is preferably 3000/mm$^2$ or greater.

Here, examples of the Al-Fe-based intermetallic compound include $Al_3Fe$, $Al_6Fe$, $Al_mFe$, α-AlFeSi, and β-AlFeSi.

Further, the density of the intermetallic compound is measured by the method described below.

First, the oil content on the surface of the anodized film 20a on the side of the image recording layer 16 is wiped off with acetone and the surface is used as a measurement sample.

Next, an image of reflection electrons on the surface of the aluminum alloy plate is imaged using a scanning electron microscope (PC-SEM7401F, manufactured by JEOL Ltd.) under the conditions of an acceleration voltage of 12.0 kV and a magnification of 2000 times.

Next, images of five sites optionally selected from the obtained image of reflection electrons are stored in a JPEG format, and the format is converted into a bitmap file (bmf) format using MS-Paint (manufactured by Microsoft Corporation).

The particle size distribution is obtained by performing image analysis by allowing image analysis software ImageFactory Ver. 3.2 (manufactured by Asahi Hi-Tech Co., Ltd., Japanese version) to read the bmf format file, performing a static binarization treatment on the images, counting the number of portions corresponding to white intermetallic compounds, and designating the equivalent circle diameter as a feature quantity.

Based on the results of the particle size distribution, the density of the intermetallic compounds having an equivalent circle diameter of 0.2 μm or greater is calculated. Further, the calculation is performed by rounding off the average value of the densities obtained by calculating each of the five pieces of image data (particle size distribution) to the hundreds digit.

[Undercoat layer]

The undercoat layer 14 is a layer disposed between the aluminum support 12a and the image recording layer 16 and improves the adhesiveness between the aluminum support and the image recording layer. As described above, the undercoat layer 14 is a layer provided as necessary and may not be provided in the lithographic printing plate precursor.

The configuration of the undercoat layer is not particularly limited, but it is preferable that the undercoat layer contains a compound having a betaine structure from the viewpoint that the stain resistance and deinking capability after being left to stand are more excellent.

First, the betaine structure is a structure having at least one cation and at least one anion. Further, the number of cations is typically the same as the number of anions so as to be neutral as a whole. However, according to the present invention, in a case where the number of cations is not the same as the number of anions, the charge is cancelled by having a required amount of counter ions so that the betaine structure is obtained.

It is preferable that the betaine structure is a structure represented by Formula (1), a structure represented by Formula (2), or a structure represented by Formula (3).

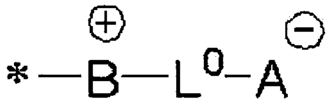

Formula (1)

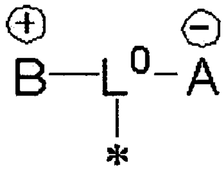

Formula (2)

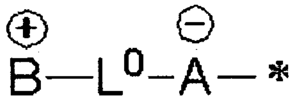

Formula (3)

In the formulae, $A^-$ represents a structure having an anion, $B^+$ represents a structure having a cation, and $L^0$ represents a linking group. The symbol "*" represents a linking site (linking position).

It is preferable that $A^-$ represents a structure having an anion such as a carboxylate, a sulfonate, a phosphonate, or a phosphinate and $B^+$ represents a structure having a cation such as ammonium, phosphonium, iodonium, or sulfonium.

$L^0$ represents a linking group. In Formulae (1) and (3), examples of $L^0$ include divalent linking groups. Among these, -CO-, -O-, -NH-, a divalent aliphatic group, a divalent aromatic group, or a combination thereof is preferable. In Formula (2), examples of $L^0$ include trivalent linking groups.

A linking group having 30 or less carbon atoms including the number of carbon atoms of the following substituent which may be included is preferable as the linking group.

Specific examples of the linking group include an alkylene group (having preferably 1 to 20 carbon atoms and more preferably 1 to 10 carbon atoms) and an arylene group (having preferably 5 to 15 carbon atoms and more preferably 6 to 10 carbon atoms) such as a phenylene group or a xylylene group.

Further, these linking groups may further have substituents.

Examples of the substituent include a halogen atom, a hydroxyl group, a carboxyl group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, a monoarylamino group, and a diarylamino group.

From the viewpoint that at least one of the printing durability, the stain resistance, the deinking capability after being left to stand, or the image visibility is more excellent (hereinafter, also simply referred to as "the viewpoint of further improving the effects of the present invention"), as the betaine structure, a structure represented by Formula (i), a structure represented by Formula (ii), or a structure represented by Formula (iii) is preferable. Among these, a structure represented by Formula (i) is more preferable. The symbol "*" represents a linking site.

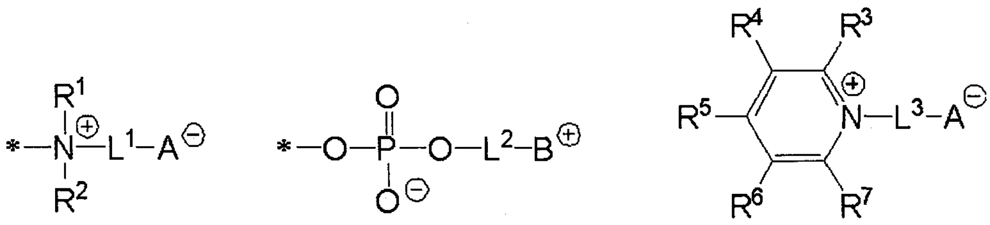

(i) (ii) (iii)

In Formula (i), $R^1$ and $R^2$ each independently represent a hydrogen atom, an alkyl group, an alkenyl group, an alkynyl group, an aryl group, or a heterocyclic group, and $R^1$ and $R^2$ may be linked to each other to form a ring structure.

The ring structure may have heteroatoms such as an oxygen atom. As the ring structure, a 5- to 10-membered ring is preferable and a 5- or 6-membered ring is more preferable.

The number of carbon atoms in $R^1$ and $R^2$ is preferably in a range of 1 to 30 and more preferably in a range of 1 to 20.

From the viewpoint of further improving the effects of the present invention, it is preferable that $R^1$ and $R^2$ represent a hydrogen atom, a methyl group, or an ethyl group.

$L^1$ represents a divalent linking group and preferably -CO-, -O-, -NH-, a divalent aliphatic group (such as an alkylene group), a divalent aromatic group (such as a phenylene group), or a combination thereof.

It is preferable that $L^1$ represents a linear alkylene group having 3 to 5 carbon atoms.

In Formula (i), $A^-$ represents a structure having an anion and preferably a carboxylate, a sulfonate, a phosphonate, or a phosphinate.

Specific examples thereof include the following structures.

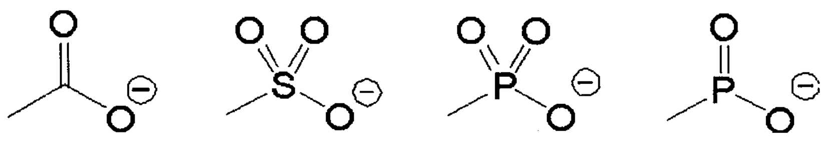

In Formula (i), a combination in which $L^1$ represents a linear alkylene group having 4 or 5 carbon atoms and $A^-$ represents a sulfonate is preferable, and a combination in which $L^1$ represents a linear alkylene group having 4 carbon atoms and $A^-$ represents a sulfonate is more preferable.

In Formula (ii), $L^2$ represents a divalent linking group and preferably -CO-, -O-, -NH-, a divalent aliphatic group (such as an alkylene group), a divalent aromatic group (such as a phenylene group), or a combination thereof.

$B^+$ represents a structure having a cation and preferably a structure having ammonium, phosphonium, iodonium,

or sulfonium. Among these, a structure having ammonium or phosphonium is preferable, and a structure having ammonium is more preferable.

Examples of the structure having a cation include a trimethylammonio group, a triethylammonio group, a tributylammonio group, a benzyldimethylammonio group, a diethylhexylammonio group, a (2-hydroxyethyl)diethylammonio group, a pyridinio group, a N-methylimidazolio group, a N-acridinio group, a trimethylphosphonio group, a triethylphosphonio group, and a triphenylphosphonio group.

In Formula (iii), $L^3$ represents a divalent linking group and preferably -CO-, -O-, -NH-, a divalent aliphatic group (such as an alkylene group), a divalent aromatic group (such as a phenylene group), or a combination thereof.

$A^-$ represents a structure having an anion and preferably a carboxylate, a sulfonate, a phosphonate, or a phosphinate. Further, the details and preferred examples thereof are the same as those for A- in Formula (i).

$R^3$ to $R^7$ each independently represent a hydrogen atom or a substituent (having preferably 1 to 30 carbon atoms), and at least one of $R^3$ to $R^7$ represents a linking site.

At least one of $R^3$ to $R^7$ as a linking site may be linked to another site in the compound through a substituent as at least one of $R^3$ to $R^7$ or may be directly linked to another site in the compound through a single bond.

Examples of the substituents represented by $R^3$ to $R^7$ include a halogen atom, an alkyl group, (such as a cycloalkyl group or a bicycloalkyl group), an alkenyl group (such as a cycloalkenyl group or a bicycloalkenyl group), an alkynyl group, an aryl group, a heterocyclic group, a cyano group, a hydroxyl group, a nitro group, a carboxyl group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group (such as an anilino group), an acylamino group, an aminocarbonylamino group, an alkoxycarbonylamino group, an aryloxycarbonylamino group, a sulfamoylamino group, an alkyl and arylsulfonylamino group, a mercapto group, an alkylthio group, an arylthio group, a heterocyclic thio group, a sulfamoyl group, a sulfo group, an alkyl and arylsulfinyl group, an alkyl and arylsulfonyl group, an acyl group, an aryloxycarbonyl group, an alkoxycarbonyl group, a carbamoyl group, an aryl and heterocyclic azo group, an imide group, a phosphino group, a phosphinyl group, a phosphinyloxy group, a phosphinylamino group, and a silyl group.

From the viewpoint of further improving the effects of the present invention, it is preferable that the compound is a polymer having a repeating unit with a betaine structure (hereinafter, also simply referred to as a "specific polymer"). As the repeating unit with a betaine structure, a repeating unit represented by Formula (A1) is preferable.

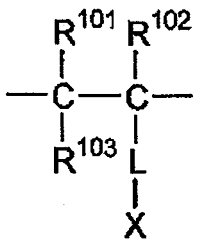

(A1)

In the formula, $R^{101}$ to $R^{103}$ each independently represent a hydrogen atom, an alkyl group, or a halogen atom. L represents a single bond or a divalent linking group.

Examples of the divalent linking group include -CO-, -O-, -NH-, a divalent aliphatic group, a divalent aromatic group, and a combination thereof.

Specific examples of L formed of the above-described combination are listed below. In each of the following examples, the left side is bonded to the main chain and the right side is bonded to X.

L1: -CO-O-divalent aliphatic group-
L2: -CO-O-divalent aromatic group-
L3: -CO-NH-divalent aliphatic group-
L4: -CO-NH-divalent aromatic group-
L5: -CO-divalent aliphatic group-
L6: -CO-divalent aromatic group-
L7: -CO-divalent aliphatic group-CO-O-divalent aliphatic group-
L8: -CO-divalent aliphatic group-O-CO-divalent aliphatic group-
L9: -CO-divalent aromatic group-CO-O-divalent aliphatic group-
L10: -CO-divalent aromatic group-O-CO-divalent aliphatic group-
L11: -CO-divalent aliphatic group-CO-O-divalent aromatic group-
L12: -CO-divalent aliphatic group-O-CO-divalent aromatic group-
L13: -CO-divalent aromatic group-CO-O-divalent aromatic group-
L14: -CO-divalent aromatic group-O-CO-divalent aromatic group-

L15: -CO-O-divalent aromatic group-O-CO-NH-divalent aliphatic group-
L16: -CO-O-divalent aliphatic group-O-CO-NH-divalent aliphatic group-

Examples of the divalent aliphatic group include an alkylene group, an alkenylene group, and an alkynylene group.

Examples of the divalent aromatic group include an aryl group. Further, a phenylene group or a naphthylene group is preferable.

X represents a betaine structure. It is preferable that X represents a structure represented by Formula (i), a structure represented by Formula (ii), or a structure represented by Formula (iii).

Particularly, in Formula (A1), a combination in which L represents L1 or L3, X represents a structure represented by Formula (i), and $A^-$ in Formula (i) represents a sulfonate group is preferable.

The content of the repeating unit having a betaine structure in the specific polymer is not particularly limited, but is in a range of 20% to 95% by mass in many cases, and from the viewpoint of further improving the effects of the present invention, preferably in a range of 50% to 95% by mass and more preferably in a range of 60% to 90% by mass with respect to the total amount of all repeating units constituting the specific polymer.

The specific polymer may have repeating units other than the repeating unit having a betaine structure.

The specific polymer may have a repeating unit having a structure (hereinafter, also simply referred to as an "interaction structure") that interacts with the surface of the aluminum support 12a.

Examples of the interaction structure include a carboxylic acid structure, a carboxylate structure, a sulfonic acid structure, a sulfonate structure, a phosphonic acid structure, a phosphonate structure, a phosphoric acid ester structure, a phosphoric acid ester salt structure, a β-diketone structure, and a phenolic hydroxyl group. Among these, a carboxylic acid structure, a carboxylate structure, a sulfonic acid structure, a sulfonate structure, a phosphonic acid structure, a phosphonate structure, a phosphoric acid ester structure, or a phosphoric acid ester salt structure is preferable.

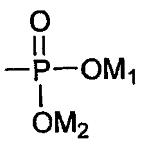 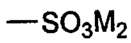 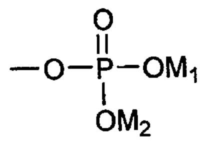 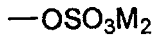

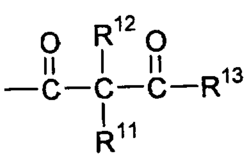 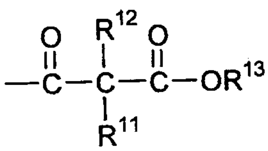 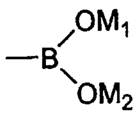 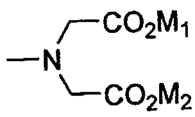

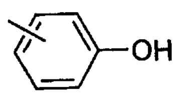 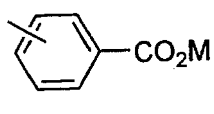 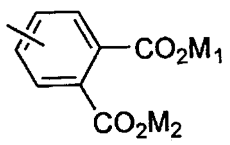

In the formulae, $R^{11}$ to $R^{13}$ each independently represent a hydrogen atom, an alkyl group, an aryl group, an alkynyl group, or an alkenyl group, and M, Mi, and $M_2$ each independently represent a hydrogen atom, a metal atom (such as an alkali metal atom such as Na or Li), or an ammonium group. B represents a boron atom.

As the repeating unit having an interaction structure, a repeating unit represented by Formula (A2) is preferable.

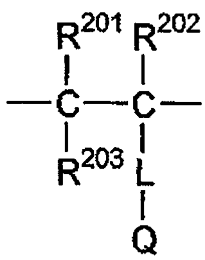 (A2)

In the formula, $R^{201}$ to $R^{203}$ each independently represent a hydrogen atom, an alkyl group (having preferably

1 to 6 carbon atoms), or a halogen atom.

L represents a single bond or a divalent linking group. Examples of the divalent linking group include -CO-, -O-, -NH-, a divalent aliphatic group, a divalent aromatic group, and a combination thereof.

Specific examples of L formed of the above-described combination include the same structures for Formula (A1), and L17 and L18.

L17: -CO-NH-
L18: -CO-O-
Among L1 to L18, L1 to L4, L17, or L18 is preferable.

Q represents an interaction structure, and the preferable aspect thereof is the same as described above.

The content of the repeating unit having an interaction structure in the specific polymer is not particularly limited, but is preferably in a range of 1% to 40% by mass and more preferably in a range of 3% to 30% by mass with respect to the total amount of all repeating units constituting the specific polymer from the viewpoint of further improving the effects of the present invention.

The specific polymer may have a repeating unit that contains a radically polymerizable group.

Examples of the radically polymerizable group include an addition-polymerizable unsaturated bonding group (such as a (meth)acryloyl group, a (meth)acrylamide group, a (meth)acrylonitrile group, an allyl group, a vinyl group, a vinyloxy group, or an alkynyl group) and a functional group capable of chain transfer (such as a mercapto group).

The specific polymer having a repeating unit that contains a radically polymerizable group can be obtained by introducing a radically polymerizable group according to the method described in JP2001-312068A. Excellent developability is exhibited in an unexposed portion, the permeability of the developer is suppressed by the polymerization in an exposed portion, and the adhesion property and the adhesiveness between the aluminum support 12a and the image recording layer 16 are further improved, by using the specific polymer having a repeating unit that contains a radically polymerizable group.

The content of the repeating unit that contains a radically polymerizable group in the specific polymer is not particularly limited, but is preferably in a range of 1% to 30% by mass and more preferably in a range of 3% to 20% by mass with respect to the total amount of all repeating units constituting the specific polymer from the viewpoint of further improving the effects of the present invention.

The content of the compound having a betaine structure in the undercoat layer 14 is not particularly limited, but is preferably 80% by mass or greater and more preferably 90% by mass or greater with respect to the total mass of the undercoat layer. The upper limit thereof is, for example, 100% by mass.

Hereinbefore, the undercoat layer 14 that contains a compound with a betaine structure has been described, but the undercoat layer may contain another compound.

For example, the undercoat layer may contain a compound that contains a hydrophilic group. Examples of the hydrophilic group include a carboxylic acid group and a sulfonic acid group.

The compound that contains a hydrophilic group may further contain a radically polymerizable group.

[Image recording layer]

As an image recording layer 16, an image recording layer which can be removed by printing ink and/or dampening water is preferable.

Hereinafter, each constituent component of the image recording layer 16 will be described.

<Infrared absorbing agent>

It is preferable that the image recording layer 16 contains an infrared absorbing agent.

It is preferable that the infrared absorbing agent has maximum absorption at a wavelength range of 750 to 1400 nm. Particularly, since on-press development is carried out by a printing press under white light in an on-press development type lithographic printing plate precursor, a lithographic printing plate precursor with excellent developability can be obtained by using an infrared absorbing agent having maximum absorption at a wavelength range of 750 to 1400 nm, which is not easily affected by the white light.

A dye or a pigment is preferable as the infrared absorbing agent.

As the dye, commercially available dyes and known dyes described in the literatures, for example, "Dye Handbook" (edited by The Society of Synthetic Organic Chemistry, Japan, published in 1970) are exemplified.

Examples of the dye include a cyanine coloring agent, a leuco coloring agent, a squarylium coloring agent, a pyrylium salt, a nickel thiolate complex, and an indolenine cyanine coloring agent. Among these, a cyanine coloring agent, a leuco coloring agent, or an indolenine cyanine coloring agent is preferable, and a cyanine coloring agent or a

leuco coloring agent is more preferable.

(Cyanine coloring agent)

Suitable examples of the cyanine coloring agent include a cyanine coloring agent represented by Formula (a).

Formula (a)

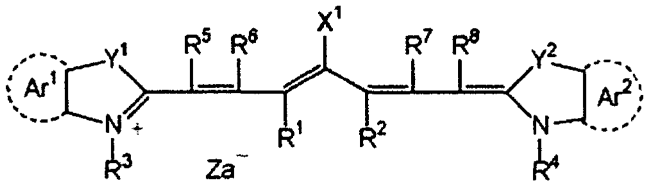

In Formula (a), $X^1$ represents a hydrogen atom, a halogen atom, $-N(R^9)(R^{10})$, $-X^2-L^1$, or a group shown below.

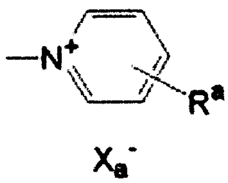

$R^9$ and $R^{10}$ each independently represent an aromatic hydrocarbon group, an alkyl group, or a hydrogen atom, and $R^9$ and $R^{10}$ may be bonded to each other to form a ring. Among these, a phenyl group is preferable.

$X^2$ represents an oxygen atom or a sulfur atom, and $L^1$ represents a hydrocarbon group having 1 to 12 carbon atoms which may have heteroatoms (such as N, S, O, a halogen atom, and Se).

$X_a^-$ has the same definition as that for $Z_a^-$ described below, and $R^a$ represents a hydrogen atom, an alkyl group, an aryl group, an amino group, or a halogen atom.

$R^1$ and $R^2$ each independently represent a hydrocarbon group having 1 to 12 carbon atoms. Further, $R^1$ and $R^2$ may be bonded to each other to form a ring, and it is preferable that a 5- or 6-membered ring is formed during the formation of a ring.

$Ar^1$ and $Ar^2$ each independently represent an aromatic hydrocarbon group which may have a substituent (for example, an alkyl group). As the aromatic hydrocarbon group, a benzene ring group or a naphthalene ring group is preferable.

$Y^1$ and $Y^2$ each independently represent a sulfur atom or a dialkyl methylene group having 12 or less carbon atoms.

$R^3$ and $R^4$ each independently represent a hydrocarbon group having 20 or less carbon atoms which may have a substituent (such as an alkoxy group).

$R^5$, $R^6$, $R^7$, and $R^8$ each independently represent a hydrogen atom or a hydrocarbon group having 12 or less carbon atoms.

Further, $Za^-$ represents a counter anion. Here, $Za^-$ is not necessary in a case where the cyanine coloring agent represented by Formula (a) has an anionic substituent in the structure thereof and neutralization of the charge is not required. Examples of $Za^-$ include a halide ion, a perchlorate ion, a tetrafluoroborate ion, a hexafluorophosphate ion, and a sulfonate ion. Among these, a perchlorate ion, a hexafluorophosphate ion, or an arylsulfonate ion is preferable.

(Leuco coloring agent)

The leuco coloring agent is not particularly limited as long as the leuco coloring agent is a coloring agent having a leuco structure, and from the viewpoints of the color developability and the visibility of the exposed portion, a leuco coloring agent having a phthalide structure or a fluorane structure is preferable.

Further, from the viewpoints of the color developability and the visibility of the exposed portion, the leuco coloring agent having a phthalide structure or a fluorane structure is preferably a compound represented by any of Formulae (Le-1) to (Le-3) and more preferably a compound represented by Formula (Le-2).

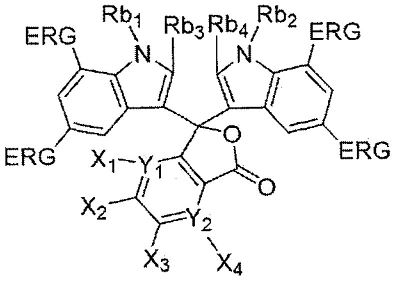
( Le - 1 )

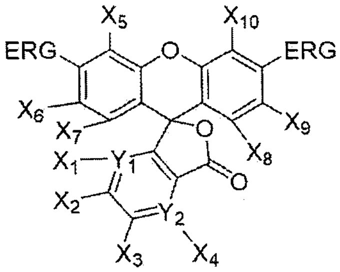
( Le - 2 )

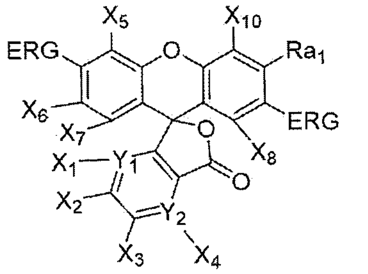
( Le - 3 )

In Formulae (Le-1) to (Le-3), ERG's each independently represent an electron-donating group, $X_1$ to $X_4$ each independently represent a hydrogen atom, a halogen atom, or a dialkylanilino group, $X_5$ to $X_{10}$ each independently represent a hydrogen atom, a halogen atom, or a monovalent organic group, $Y_1$ and $Y_2$ each independently represent C or N, $X_1$ is not present in a case where $Y_1$ represents N, and $X_4$ is not present in a case where $Y_2$ represents N, Rai represents a hydrogen atom, an alkyl group, or an alkoxy group, and $Rb_1$ to $Rb_4$ each independently represent a hydrogen atom, an alkyl group, or an aryl group.

From the viewpoints of the color developability and the visibility of the exposed portion, as the electron-donating group represented by ERG in Formulae (Le-1) to (Le-3), an amino group, an alkylamino group, an arylamino group, a dialkylamino group, a monoalkyl monoarylamino group, a diarylamino group, an alkoxy group, an aryloxy group, or an alkyl group is preferable, an amino group, an alkylamino group, an arylamino group, a dialkylamino group, or a monoalkyl monoarylamino group, a diarylamino group, an alkoxy group, or an aryloxy group is more preferable, a monoalkyl monoarylamino group or a diarylamino group is still more preferable, and a monoalkyl monoarylamino group is particularly preferable.

From the viewpoints of the color developability and the visibility of the exposed portion, $X_1$ to $X_4$ in Formulae (Le-1) to (Le-3) each independently represent preferably a hydrogen atom or a chlorine atom and more preferably a hydrogen atom.

From the viewpoints of the color developability and the visibility of the exposed portion, $X_5$ to $X_{10}$ in Formula (Le-2) or Formula (Le-3) each independently represent preferably a hydrogen atom, a halogen atom, an alkyl group, an aryl group, an amino group, an alkylamino group, an arylamino group, a dialkylamino group, a monoalkyl monoarylamino group, a diarylamino group, a hydroxy group, an alkoxy group, an aryloxy group, an acyl group, an alkoxycarbonyl group, an aryloxycarbonyl group, or a cyano group, more preferably a hydrogen atom, a halogen atom, an alkyl group, an aryl group, an alkoxy group, or an aryloxy group, still more preferably a hydrogen atom, a halogen atom, an alkyl group, or an aryl group, and particularly preferably a hydrogen atom.

From the viewpoints of the color developability and the visibility of the exposed portion, it is preferable that at least one of $Y_1$ or $Y_2$ in Formulae (Le-1) to (Le-3) represents C and more preferable that both $Y_1$ and $Y_2$ represent C.

From the viewpoints of the color developability and the visibility of the exposed portion, Rai in Formulae (Le-1) to (Le-3) represents preferably an alkyl group or an alkoxy group, more preferably an alkoxy group, and particularly preferably a methoxy group.

From the viewpoints of the color developability and the visibility of the exposed portion, $Rb_1$ to $Rb_4$ in Formulae (Le-1) to (Le-3) each independently represent preferably a hydrogen atom or an alkyl group, more preferably an alkyl group, and particularly preferably a methyl group.

Further, from the viewpoints of the color developability and the visibility of the exposed portion, as the leuco coloring agent having a phthalide structure or a fluorane structure, a compound represented by any of Formulae (Le-4) to (Le-6) is more preferable, and a compound represented by Formula (Le-5) is still more preferable.

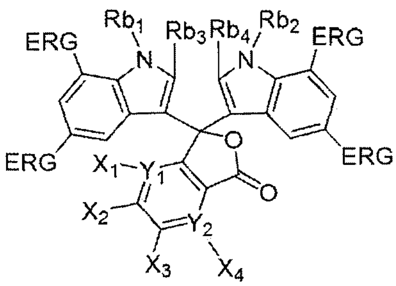
( Le - 4 )

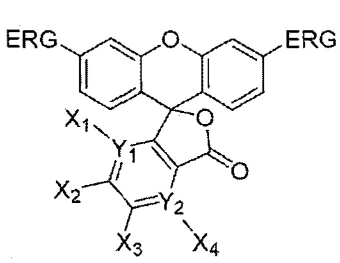
( Le - 5 )

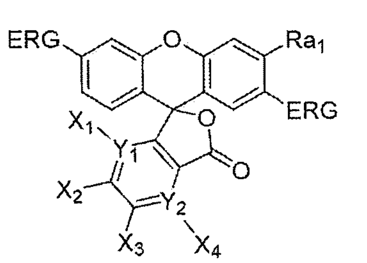
( Le - 6 )

In Formulae (Le-4) to (Le-6), ERG's each independently represent an electron-donating group, $X_1$ to $X_4$ each independently represent a hydrogen atom, a halogen atom, or a dialkylanilino group, $Y_1$ and $Y_2$ each independently represent C or N, $X_1$ is not present in a case where $Y_1$ represents N, and $X_4$ is not present in a case where $Y_2$ represents N, Rai represents a hydrogen atom, an alkyl group, or an alkoxy group, and $Rb_1$ to $Rb_4$ each independently represent a hydrogen atom, an alkyl group, or an aryl group.

ERG, $X_1$ to $X_4$, $Y_1$, $Y_2$, Rai, and $Rb_1$ to $Rb_4$ in Formulae (Le-4) to (Le-6) each have the same definition as that for ERG, $X_1$ to $X_4$, $Y_1$, $Y_2$, $Ra_1$, and $Rb_1$ to $Rb_4$ in Formulae (Le-1) to (Le-3), and the preferable aspects thereof are also the same as described above.

Further, from the viewpoints of the color developability and the visibility of the exposed portion, as the leuco coloring agent having a phthalide structure or a fluorane structure, a compound represented by any of Formulae (Le-7) to (Le-9) is still more preferable, and a compound represented by Formula (Le-8) is particularly preferable.

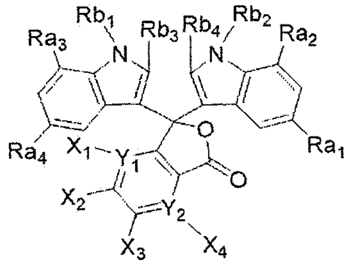

(Le-7)

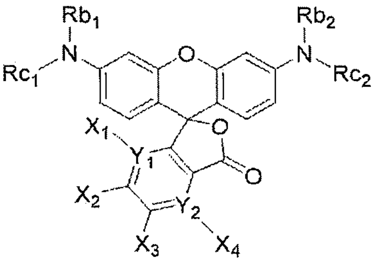

(Le-8)

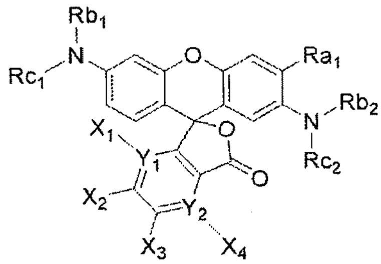

(Le-9)

In Formulae (Le-7) to (Le-9), $X_1$ to $X_4$ each independently represent a hydrogen atom, a halogen atom, or a dialkylanilino group, $Y_1$ and $Y_2$ each independently represent C or N, $X_1$ is not present in a case where $Y_1$ represents N, and $X_4$ is not present in a case where $Y_2$ represents N, $Ra_1$ to $Ra_4$ each independently represent a hydrogen atom, an alkyl group, or an alkoxy group, $Rb_1$ to $Rb_4$ each independently represent a hydrogen atom, an alkyl group, or an aryl group, and $Rc_1$ and $Rc_2$ each independently represent an aryl group.

$X_1$ to $X_4$, $Y_1$, and $Y_2$ in Formulae (Le-7) to (Le-9) each have the same definition as that for $X_1$ to $X_4$, $Y_1$, and $Y_2$ in Formulae (Le-1) to (Le-3), and the preferable aspects thereof are also the same as described above.

From the viewpoints of the color developability and the visibility of the exposed portion, Rai to $Ra_4$ in Formulae (Le-7) to (Le-9) each independently represent preferably an alkyl group or an alkoxy group, more preferably an alkoxy group, and particularly preferably a methoxy group.

From the viewpoints of the color developability and the visibility of the exposed portion, $Rb_1$ to $Rb_4$ in Formulae (Le-7) to (Le-9) each independently represent preferably a hydrogen atom, an alkyl group, or an aryl group substituted with an alkoxy group, more preferably an alkyl group, and particularly preferably a methyl group.

From the viewpoints of the color developability and the visibility of the exposed portion, $Rc_1$ and $Rc_2$ in Formulae (Le-7) to (Le-9) each independently represent preferably a phenyl group or an alkylphenyl group and more preferably a phenyl group.

In Formula (Le-8), from the viewpoints of the color developability and the visibility of the exposed portion, it is preferable that $X_1$ to $X_4$ represent a hydrogen atom and that $Y_1$ and $Y_2$ represent C.

Further, in Formula (Le-8), from the viewpoints of the color developability and the visibility of the exposed portion, it is preferable that $Rb_1$ and $Rb_2$ each independently represent a hydrogen atom or an alkyl group.

The alkyl group in Formulae (Le-1) to (Le-9) may be linear or branched or may have a ring structure.

Further, the number of carbon atoms of the alkyl group in Formulae (Le-1) to (Le-9) is preferably in a range of 1 to 20, more preferably in a range of 1 to 8, still more preferably in a range of 1 to 4, and particularly preferably 1 or 2.

The number of carbon atoms of the aryl group in Formulae (Le-1) to (Le-9) is preferably in a range of 6 to 20, more preferably in a range of 6 to 10, and particularly preferably in a range of 6 to 8.

Further, each of the monovalent organic group, the alkyl group, the aryl group, the dialkylanilino group, the alkylamino group, and the alkoxy group in Formulae (Le-1) to (Le-9) may have a substituent. Examples of the substituent include an alkyl group, an aryl group, a halogen atom, an amino group, an alkylamino group, an arylamino group, a dialkylamino group, a monoalkyl monoarylamino group, a diarylamino group, a hydroxy group, an alkoxy group, an aryloxy group, an acyl group, an alkoxycarbonyl group, an aryloxycarbonyl group, and a cyano group. Further, these substituents may be further substituted with these substituents.

Specific examples of the leuco coloring agent having a phthalide structure or a fluorane structure that are suitably used include the following compounds (S-1 to S-15).

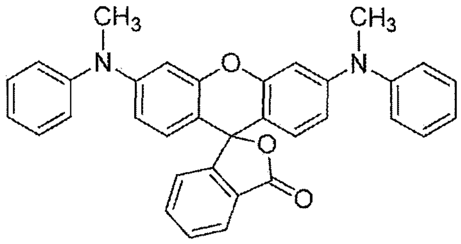

S - 1

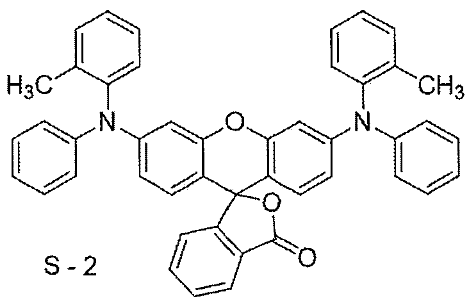

S - 2

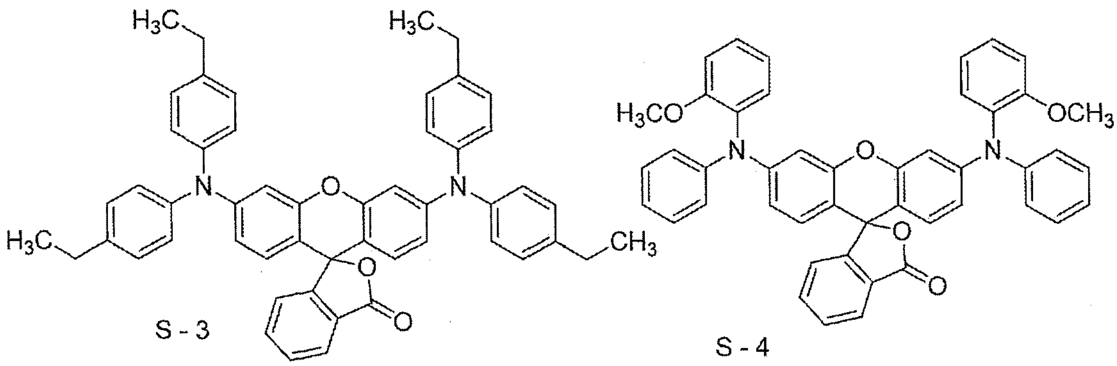

S - 3

S - 4

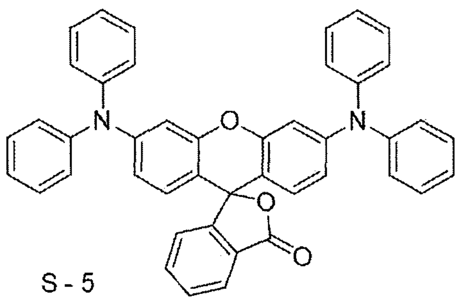

S - 5

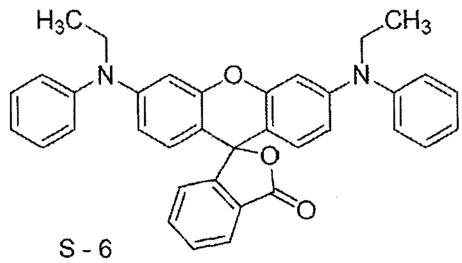

S - 6

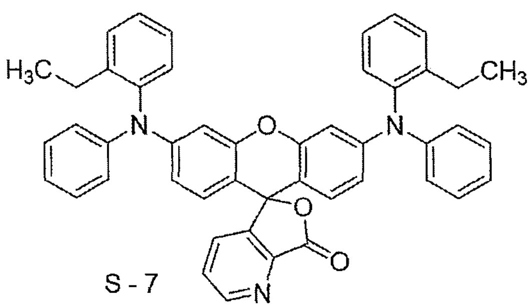

S - 7

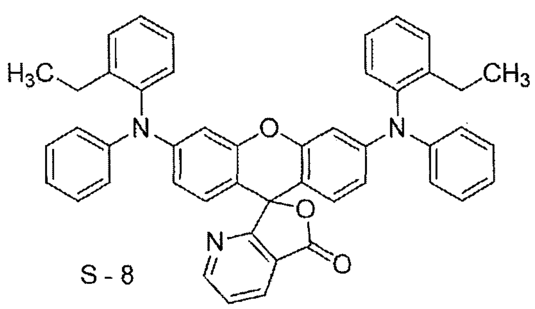

S - 8

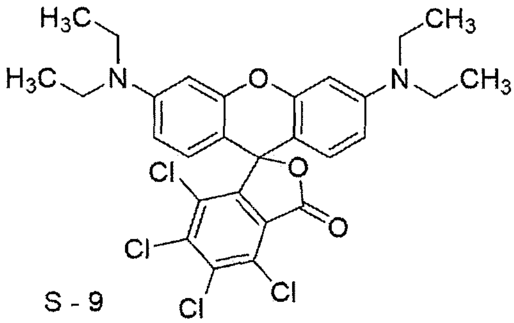

S - 9

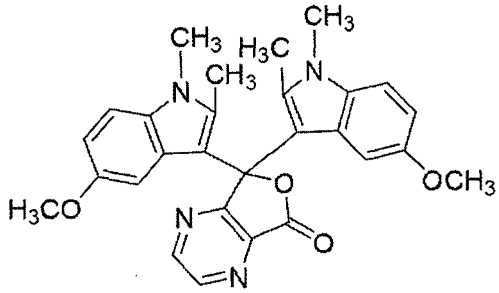

S - 10

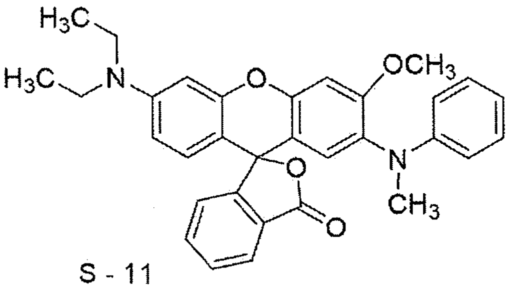

S - 11

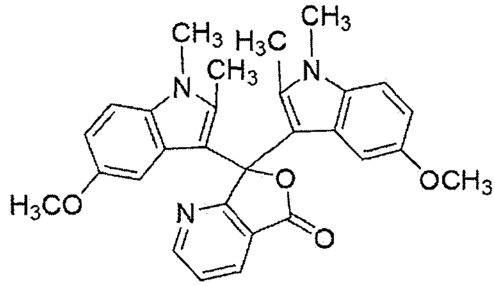

S - 12

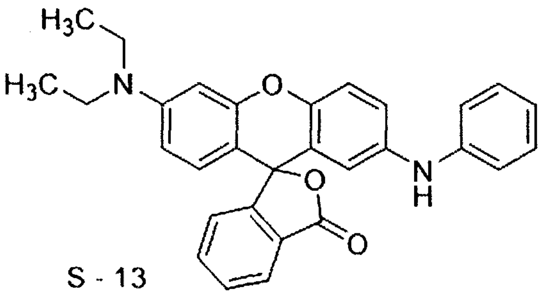

S - 13

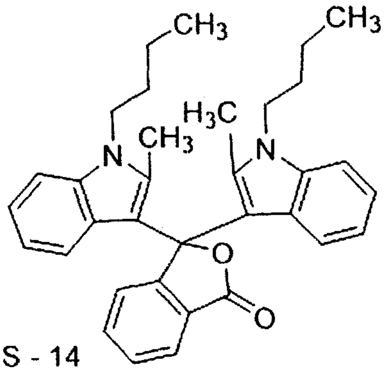

S - 14

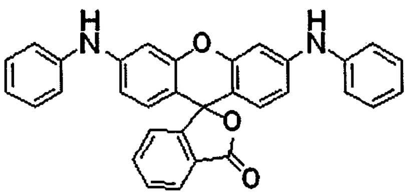

S - 15

The above-described infrared absorbing dyes may be used alone or in combination of two or more kinds thereof. Further, infrared absorbing agents other than the infrared absorbing dyes such as pigments may be used in combination. As the pigments, the compounds described in paragraphs 0072 to 0076 in JP2008-195018A are preferable.

The content of the infrared absorbing agent is preferably in a range of 0.05% to 30% by mass and more preferably in a range of 0.1% to 20% by mass with respect to the total mass of the image recording layer 16.

<Polymerization initiator>

It is preferable that the image recording layer 16 contains a polymerization initiator.

As the polymerization initiator, a compound (so-called radical polymerization initiator) that generates a radical using light, heat, or the energy of both light and heat and initiates polymerization of a compound containing a polymerizable

unsaturated group is preferable. Examples of the polymerization initiator include a photopolymerization initiator and a thermal polymerization initiator.

As the polymerization initiator, specifically, the polymerization initiators described in paragraphs 0115 to 0141 described in JP2009-255434A can be used.

Further, from the viewpoints of the reactivity and the stability, an oxime ester compound or an onium salt such as a diazonium salt, an iodonium salt, or a sulfonium salt is preferable as the polymerization initiator.

In the present invention, the image recording layer 16 contains preferably an electron-accepting polymerization initiator and/or an electron-donating polymerization initiator and more preferably both an electron-accepting polymerization initiator and an electron-donating polymerization initiator as the polymerization initiator.

(Electron-accepting polymerization initiator)

The electron-accepting polymerization initiator is a compound that generates polymerization initiating species such as a radical or a cation by light, heat, or the energy of both light and heat and can be appropriately selected from known thermal polymerization initiators, compounds having bonds with small bond dissociation energy, and photopolymerization initiators and then used.

As the electron-accepting polymerization initiator, a radical polymerization initiator is preferable, and an onium compound is more preferable.

Further, an infrared photosensitive polymerization initiator is preferable as the electron-accepting polymerization initiator.

The electron-accepting polymerization initiator may be used alone or in combination of two or more kinds thereof.

Examples of the radical polymerization initiator include an organic halide (a), a carbonyl compound (b), an azo compound (c), an organic peroxide (d), a metallocene compound (e), an azide compound (f), a hexaaryl biimidazole compound (g), a disulfone compound (i), an oxime ester compound (j), and an onium compound (k).

As the organic halide (a), for example, the compounds described in paragraphs 0022 to 0023 of JP2008-195018A are preferable.

As the carbonyl compound (b), for example, the compounds described in paragraph 0024 of JP2008-195018A are preferable.

As the azo compound (c), for example, the azo compounds and the like described in JP1996-108621A (JP-H08-108621A) can be used.

As the organic peroxide (d), for example, the compounds described in paragraph 0025 of JP2008-195018A are preferable.

As the metallocene compound (e), for example, the compounds described in paragraph 0026 of JP2008-195018A are preferable.

Examples of the azide compound (f) include compounds such as 2,6-bis(4-azidobenzylidene)-4-methylcyclohexanone.

As the hexaaryl biimidazole compound (g), for example, the compounds described in paragraph 0027 of JP2008-195018A are preferable.

Examples of the disulfone compound (i) include the compounds described in JP1986-166544A (JP-S61-166544A) and JP2002-328465A.

As the oxime ester compound (j), for example, the compounds described in paragraphs 0028 to 0030 of JP2008-195018A are preferable.

Among the above-described electron-accepting polymerization initiators, an oxime ester compound and an onium compound are preferable from the viewpoint of the curing properties. Among the examples, from the viewpoint of the printing durability, particularly printing durability in a case where an ink cured by irradiation with ultraviolet rays (UV) is used as an ink during printing (hereinafter, also referred to as "UV printing durability"), an iodonium salt compound, a sulfonium salt compound, or an azinium salt compound is preferable, an iodonium salt compound or a sulfonium salt compound is more preferable, and an iodonium salt compound is still more preferable.

Hereinafter, specific examples of these compounds will be described, but the present invention is not limited thereto.

As an example of the iodonium salt compound, a diaryl iodonium salt compound is preferable, and particularly a diphenyl iodonium salt compound substituted with an electron-donating group such as an alkyl group or an alkoxyl group is more preferable. Further, an asymmetric diphenyl iodonium salt compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyliodonium=hexafluorophosphate, 4-hexyloxyphenyl-2,4-diethoxyphenyliodonium=tetrafluoroborate, 4-octyloxyphenyl-2,4,6-trimethoxyphenyliodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

As an example of the sulfonium salt compound, a triarylsulfonium salt compound is preferable, a triarylsulfonium salt compound in which at least some groups on an aromatic ring such as electron-withdrawing groups have been substituted with halogen atoms is particularly preferable, and a triarylsulfonium salt compound in which the total number of halogen atoms substituted on an aromatic ring is 4 or greater is still more preferable. Specific examples thereof include triphenylsulfonium=hexafluorophosphate, triphenylsulfonium=benzoylformate, bis(4-chlorophenyl)phenylsulfonium=benzoylformate, bis(4-chlorophenyl)-4-methylphenylsulfonium=tetrafluoroborate, tris(4-chlorophenyl)sulfonium=3,5-bis(methoxycarbonyl)benzene sulfonate, tris(4-chlorophenyl)sulfonium=hexafluorophosphate, and tris(2,4-dichlorophenyl)sulfonium=hexafluorophosphate.

Further, as the counter anion of the iodonium salt compound and the sulfonium salt compound, a sulfonamide anion or a sulfonimide anion is preferable, and a sulfonimide anion is more preferable.

As the sulfonamide anion, an aryl sulfonamide anion is preferable.

Further, as the sulfonimide anion, a bisaryl sulfonimide anion is preferable.

Specific examples of the sulfonamide anion or the sulfonimide anion are shown below, but the present invention is not limited thereto. In the specific examples below, Ph represents a phenyl group, Me represents a methyl group, and Et represents an ethyl group.

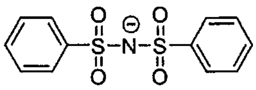

I-1

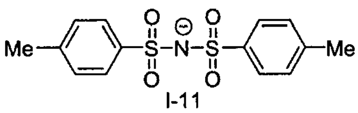

I-11

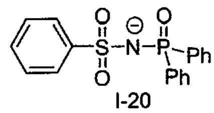

I-20

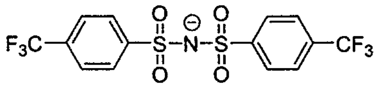
I-2

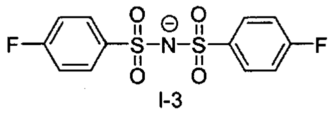
I-3

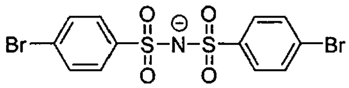
I-4

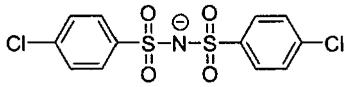
I-5

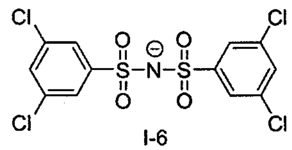
I-6

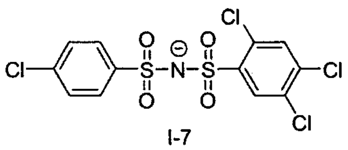
I-7

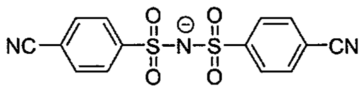
I-8

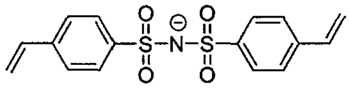
I-9

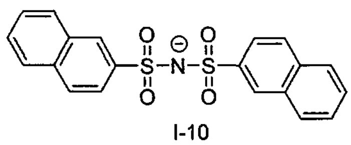
I-10

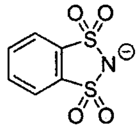
I-12

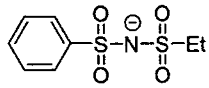
I-13

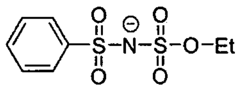
I-14

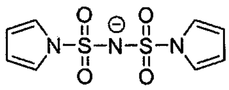
I-15

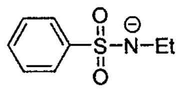
I-16

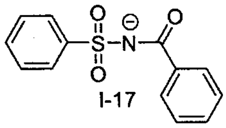
I-17

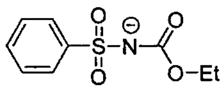
I-18

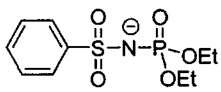
I-19

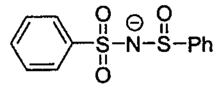
I-21

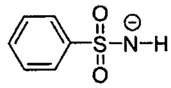
I-22

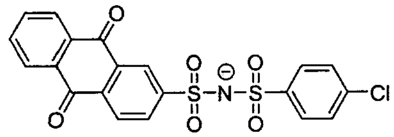
I-23

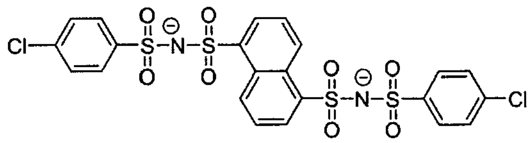
I-24

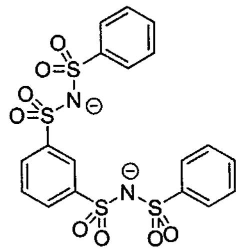
I-25

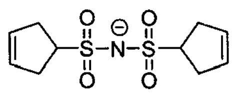
I-26

Specific examples of the aspect in which the electron-accepting polymerization initiator and the electron-donating polymerization initiator form a salt are shown below, but the present invention is not limited thereto.

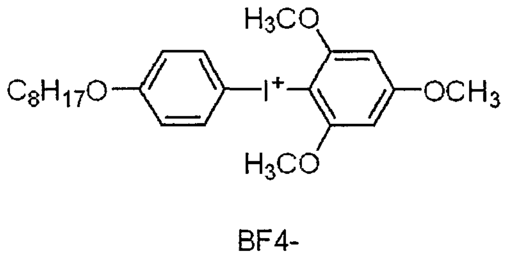

(IA-1)

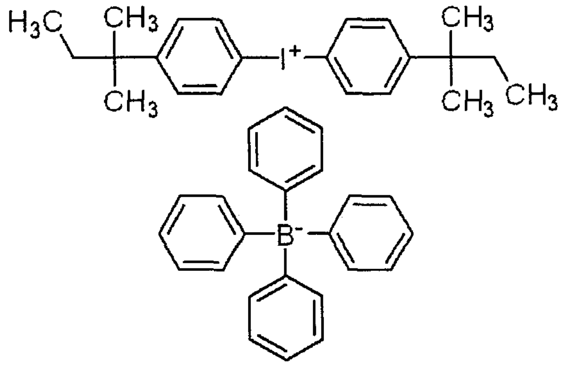

(IA-2)

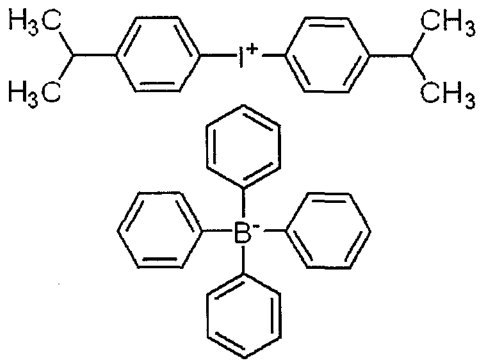

(IA-3)

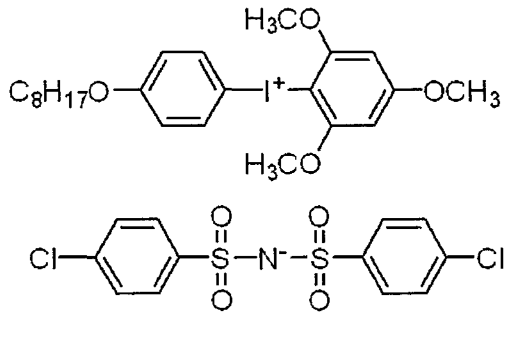

(IA-4)

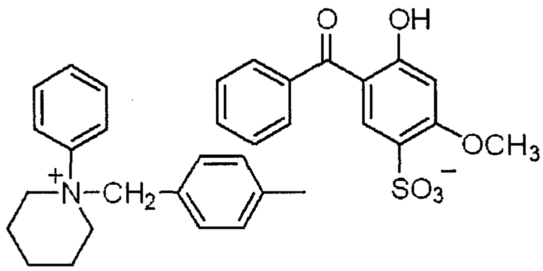

(IA-5)

Further, from the viewpoints of the color developability, the temporal color developability after exposure, the developability of the lithographic printing plate precursor to be obtained, and the UV printing durability in a case where a lithographic printing plate is obtained, a compound represented by Formula (I) can be suitably used as the electron-accepting polymerization initiator.

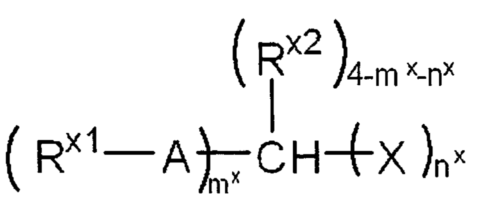

(I)

In the formula, X represents a halogen atom, and specific examples thereof include a fluorine atom, a chlorine atom, a bromine atom and an iodine atom. Among these, a chlorine atom or a bromine atom is preferable from the viewpoint of excellent sensitivity, and a bromine atom is particularly preferable.

A represents a divalent linking group selected from the group consisting of -CO-, -SO-, $-SO_2-$, -PO-, and $-PO_2-$.

Among these, -CO-, -SO- and -$SO_2$- are more preferable, and -CO- and -SOz- are particularly preferable. $R^{X1}$ and $R^{X2}$ each independently represent a hydrogen atom or a monovalent hydrocarbon group having 1 to 20 carbon atoms.

Examples of the hydrocarbon constituting the hydrocarbon group include the hydrocarbons described in paragraphs 0013 and 0014 of JP2002-162741A, and specific examples of the hydrocarbon include an aliphatic hydrocarbon having 1 to 30 carbon atoms such as methane, ethane, propane, butane, hexane, nonane, decane, octadecane, cyclopentane, cyclohexane, adamantane, norbornane, decahydronaphthalene, tricyclo[5.2.1.$0^{2,6}$]decane, ethylene, propylene, 1-butene, 1-hexene, 1-heptadecene, 2-butene, 2-hexene, 4-nonene, 7-tetradecene, butadiene, piperylene, 1,9-decadiene, cyclopentene, cyclohexene, cyclooctene, 1,4-cyclohexadiene, 1,5-cyclooctadiene, 1,5,9-cyclododecatriene, norbomylene, octahydronaphthalene, bicyclo[2.2.1]hepta-2,5-diene, acetylene, 1-propine, or 2-hexyne; and an aromatic hydrocarbon such as benzene, naphthalene, anthracene, indene, or fluorene.

One or more carbon atoms constituting such a hydrocarbon group may be substituted with heteroatoms selected from an oxygen atom, a nitrogen atom, and a sulfur atom.

Examples of the substituent include a monovalent non-metal atomic group excluding hydrogen, and specific examples thereof include a halogen atom (-F, -Br, -Cl, or -I), a hydroxyl group, an alkoxy group, an aryloxy group, a mercapto group, an alkylthio group, an arylthio group, an alkyldithio group, an aryldithio group, an amino group, a N-alkylamino group, a N,N-dialkylamino group, a N-arylamino group, a N,N-diarylamino group, a N-alkyl-N-arylamino group, an acyloxy group, a carbamoyloxy group, a N-alkylcarbamoyloxy group, a N-arylcarbamoyloxy group, N,N-dialkylcarbamoyloxy group, a N,N-diarylcarbamoyloxy group, a N-alkyl-N-arylcarbamoyloxy group, an alkylsulfoxy group, an arylsulfoxy group, an acylthio group, an acylamino group, a N-alkylacylamino group, a N-arylacylamino group, a ureido group, a N'-alkylureido group, a N',N'-dialkylureido group, a N'-arylureido group, a N',N'-diarylureido group, a N'-alkyl-N'-arylureido group, a N-alkylureido group, a N-arylureido group, a N'-alkyl-N-alkylureido group, a N'-alkyl-N-arylureido group, a N',N'-dialkyl-N-alkylureido group, a N',N'-dialkyl-N-arylureido group, a N'-aryl-N-alkylureido group, a N'-aryl-N-arylureido group, a N',N'-diaryl-N-alkylureido group, a N',N'-diaryl-N-arylureido group, a N'-alkyl-N'-aryl-N-alkylureido group, a N'-alkyl-N'-aryl-N-arylureido group, an alkoxycarbonylamino group, an aryloxycarbonylamino group, a N-alkyl-N-alkoxycarbonylamino group, a N-alkyl-N-aryloxycarbonylamino group, a N-aryl-N-alkoxycarbonylamino group, a N-aryl-N-aryloxycarbonylamino group, a formyl group, an acyl group, a carboxyl group and a conjugated base group thereof, an alkoxycarbonyl group, an aryloxycarbonyl group, a carbamoyl group, a N-alkylcarbamoyl group, a N,N-dialkylcarbamoyl group, a N-arylcarbamoyl group, a N,N-diarylcarbamoyl group, a N-alkyl-N-arylcarbamoyl group, an alkylsulfinyl group, an arylsulfinyl group, an alkylsulfonyl group, an arylsulfonyl group, a sulfo group (-$SO_3H$) and a conjugated base group thereof, an alkoxysulfonyl group, an aryloxysulfonyl group, a sulfinamoyl group, a N-alkylsulfinamoyl group, a N,N-dialkylsulfinamoyl group, a N-arylsulfinamoyl group, a N,N-diarylsulfinamoyl group, a N-alkyl-N-arylsulfinamoyl group, a sulfamoyl group, a N-alkylsulfamoyl group, a N,N-dialkylsulfamoyl group, a N-arylsulfamoyl group, a N,N-diarylsulfamoyl group, a N-alkyl-N-arylsulfamoyl group, a N-acylsulfamoyl group and a conjugated base group thereof, a N-alkylsulfonylsulfamoyl group (-$SO_2NHSO_2$(alkyl)) and a conjugated base group thereof, a N-arylsulfonylsulfamoyl group (-$SO_2NHSO_2$(aryl)) and a conjugated base group thereof, a N-alkylsulfonylcarbamoyl group (-$CONHSO_2$(alkyl)) and a conjugated base group thereof, a N-arylsulfonylcarbamoyl group (-$CONHSO_2$(aryl)) and a conjugated base group thereof, an alkoxysilyl group (-$Si(Oalkyl)_3$), an aryloxysilyl group (-$Si(Oaryl)_3$), a hydroxysilyl group (-$Si(OH)_3$) and a conjugated base group thereof, a phosphono group (-$PO_3H_2$) and a conjugated base group thereof, a dialkylphosphono group (-$PO_3(alkyl)_2$), a diarylphosphono group (-$PO_3(aryl)_2$), an alkylarylphosphono group (-$PO_3$(alkyl)(aryl)), a monoalkylphosphono group (-$PO_3H$(alkyl)) and a conjugated base group thereof, a monoarylphosphono group (-$PO_3H$(aryl)) and a conjugated base group thereof, a phosphonooxy group (-$OPO_3H_2$) and a conjugated base group thereof, a dialkylphosphonooxy group (-$OPO_3(alkyl)_2$), a diallylphosphonooxy group (-$OPO_3(aryl)_2$), an alkylarylphosphonooxy group (-$OPO_3$(alkyl)(aryl)), a monoalkylphosphonooxy group (-$OPO_3H$(alkyl)) and a conjugated base group thereof, a monoarylphosphonooxy group (-$OPO_3H$(aryl)) and a conjugated base group thereof, a cyano group, a nitro group, a dialkylboryl group (-$B(alkyl)_2$), a diarylboryl group (-$B(aryl)_2$), an alkylarylboryl group (-B(alkyl)(aryl)), a dihydroxyboryl group (-$B(OH)_2$) and a conjugated base group thereof, an alkylhydroxyboryl group (-B(alkyl)(OH)) and a conjugated base group thereof, an arylhydroxyboryl group (-B(aryl)(OH)) and a conjugated base group thereof, an aryl group, an alkyl group, an alkenyl group, and an alkynyl group.

If possible, these substituents may be bonded to each other or bonded to a hydrocarbon group which has been substituted to form a ring, and the substituents may be further substituted.

Preferred examples of the substituents include a halogen atom, an alkoxy group, an aryloxy group, an alkyl group, an alkenyl group, an alkynyl group, and an aryl group.

$m^x$ and $n^x$ each represent an integer of 1 to 3. Here, $m^x + n^x$ is 2 to 4. In terms of the sensitivity, it is preferable that $m^x$ represents 1 and $n^x$ represents 3, or $m^x$ represents 2 and $n^x$ represents 2. In a case where $m^x$ and $n^x$ represent 2 or greater, (R1-A) and X may be different from each other. Further, in a case where $m^x$ represents 1 and $n^x$ represents 1, $R^{x2}$'s may be different from each other.

Among the compounds represented by Formula (I), compounds represented by Formulae (II) and (III) are preferable from the viewpoint of excellent visibility.

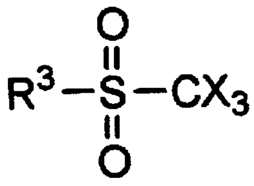 (II)

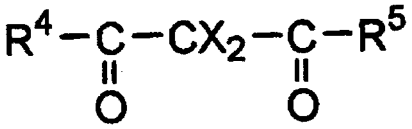 (III)

In Formulae (II) and (III), X has the same definition as that for X in Formula (I), and $R^3$, $R^4$, and $R^5$ each independently represent a monovalent hydrocarbon group having 1 to 20 carbon atoms.

Here, it is preferable that $R^3$, $R^4$, and $R^5$ represent an aryl group and more preferable that the aryl group is substituted with an amide group from the viewpoint that the balance between the sensitivity and the storability is excellent.

Among the compounds represented by Formulae (II) and (III), compounds represented by Formula (IV) are particularly preferable.

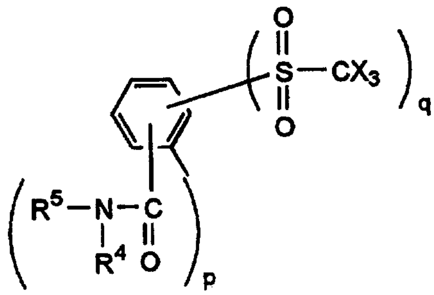 (IV)

In Formula (IV), $R^4$ and $R^5$ each independently represent a hydrogen atom or a monovalent hydrocarbon group having 1 to 20 carbon atoms. p and q represent an integer of 1 to 5. Here, p + q is 2 to 6.

Specific examples of the electron-accepting polymerization initiator represented by Formula (I) include compounds shown below, but the present invention is not limited thereto.

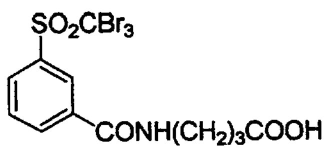 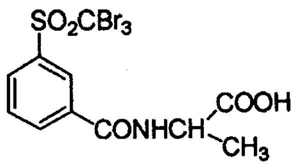 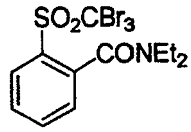

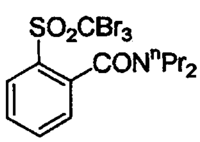 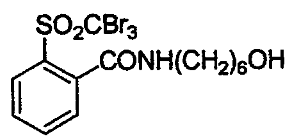 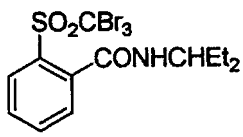

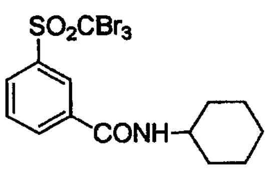 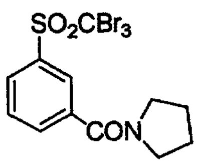 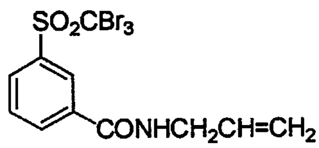

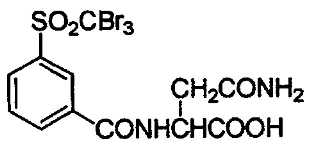 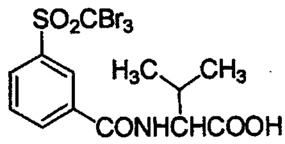 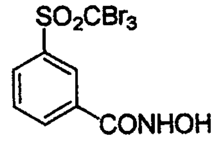

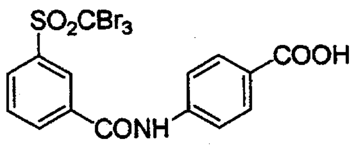 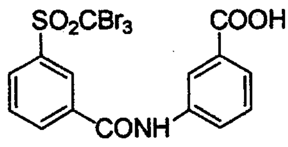 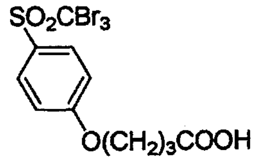

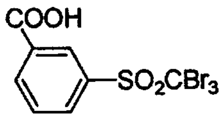 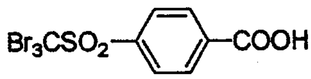 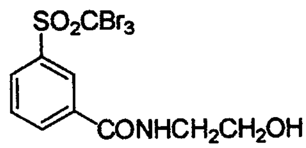

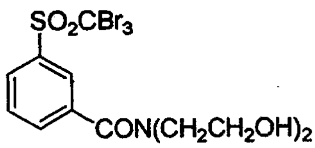 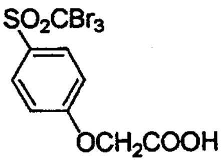 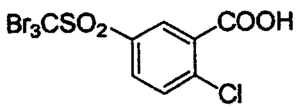

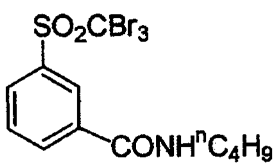 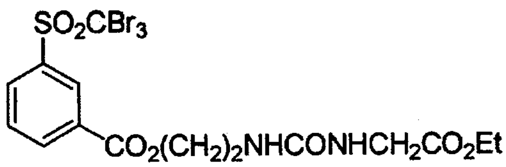

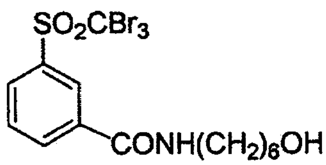 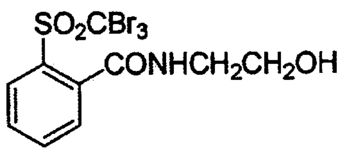

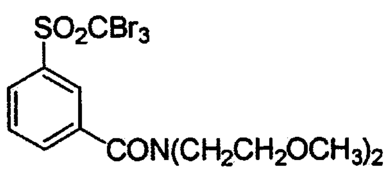 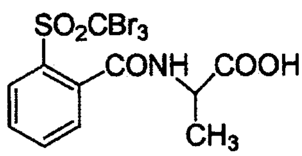

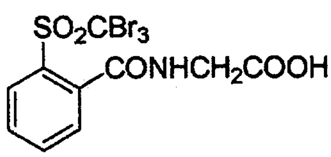 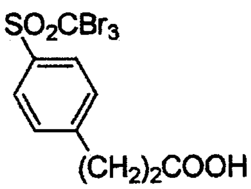 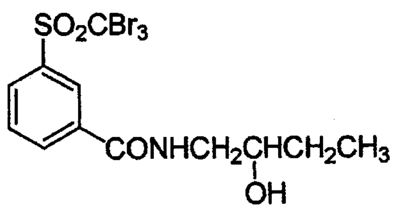

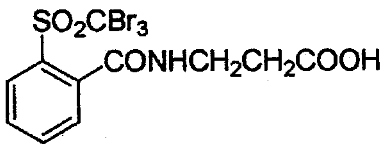
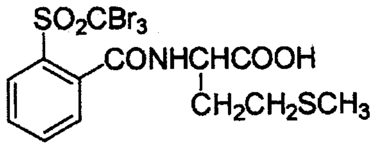

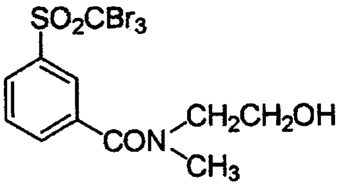
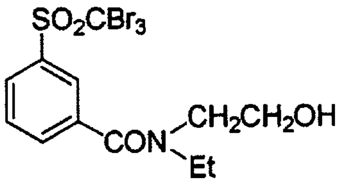
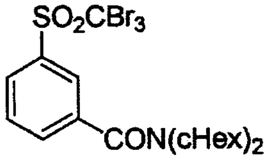

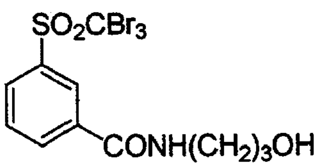
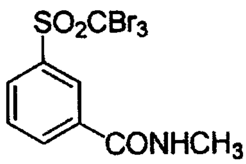
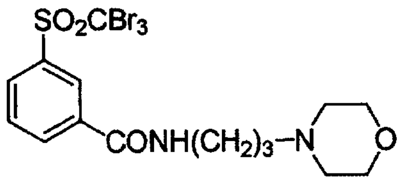

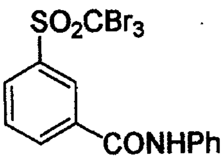
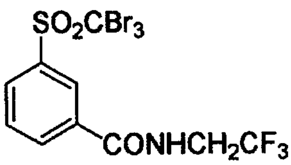
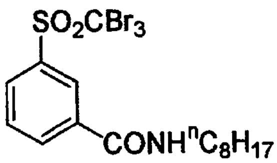

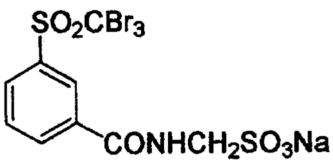
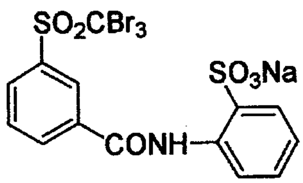
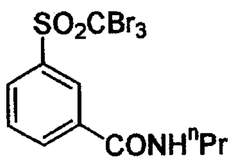

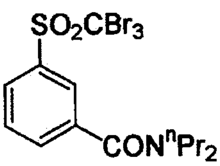
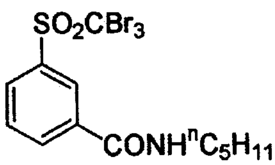
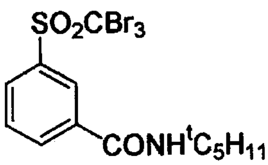

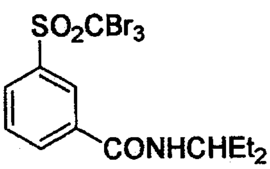
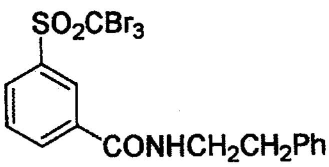
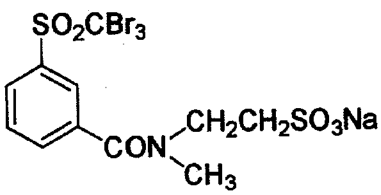

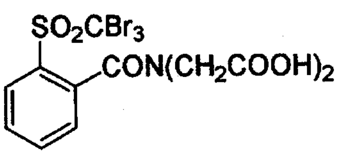
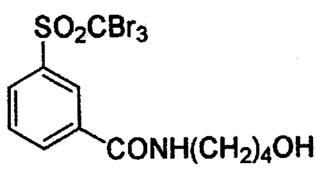

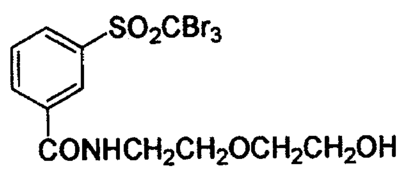
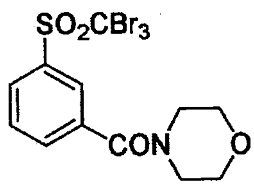
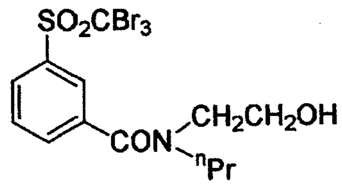

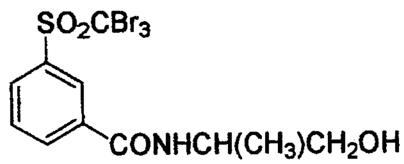
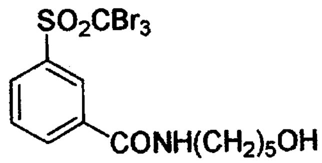

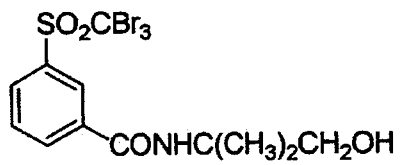
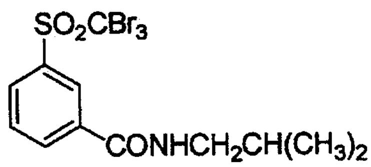

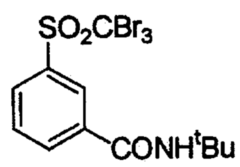
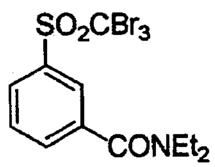
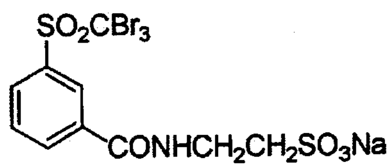

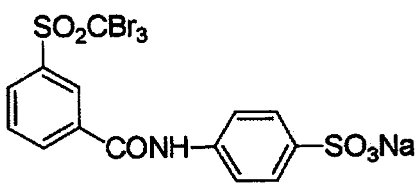
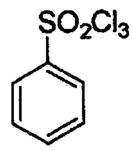
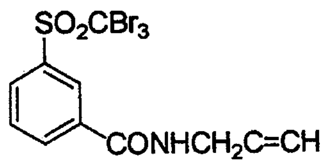

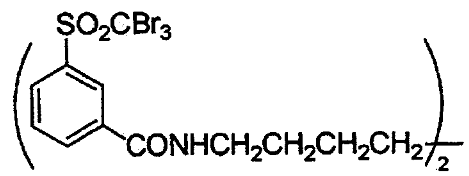
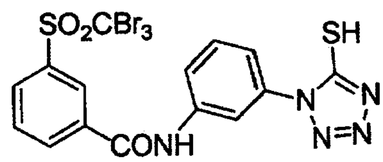

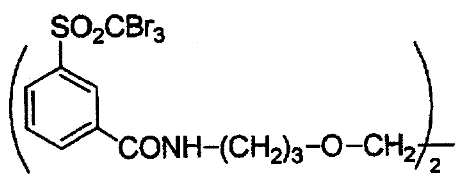
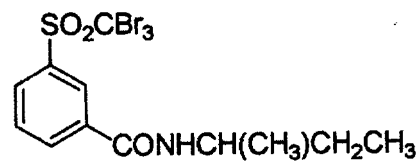

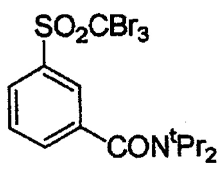
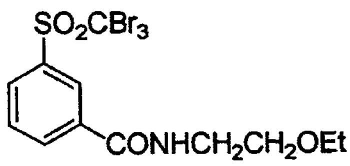
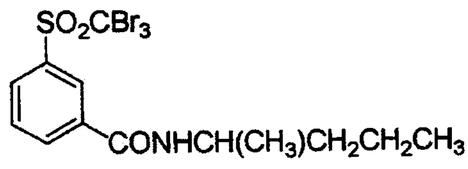

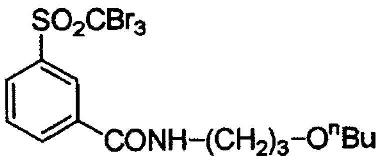

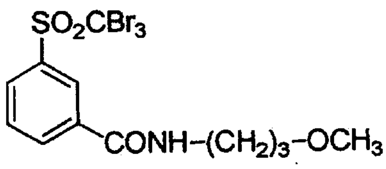

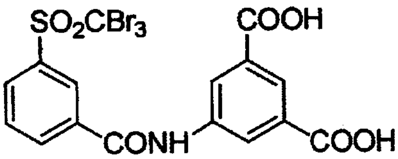

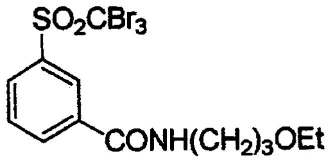

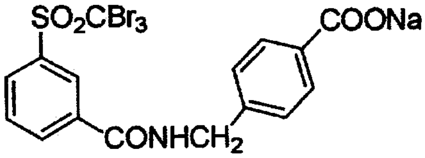

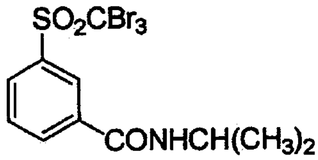

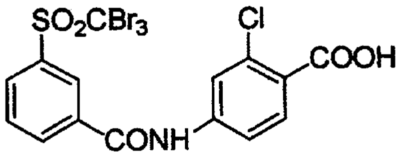

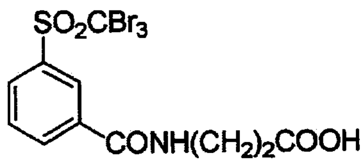

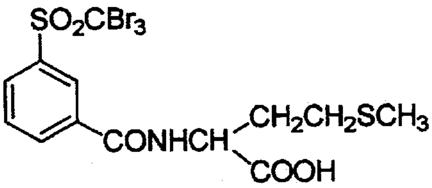

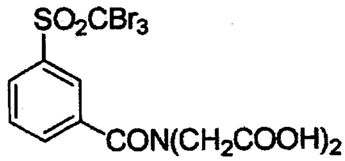

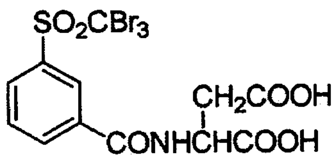

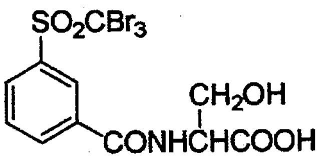

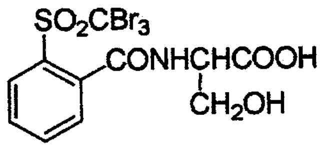

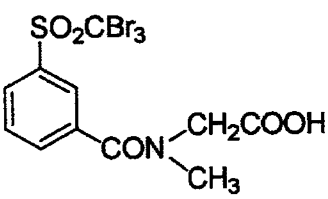

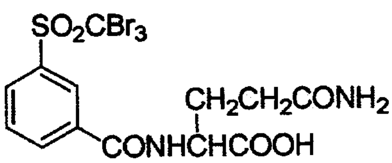

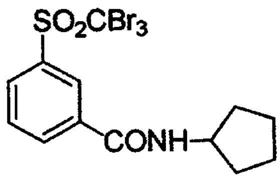

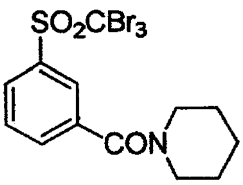

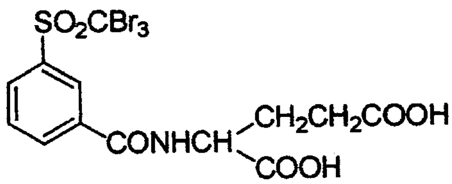

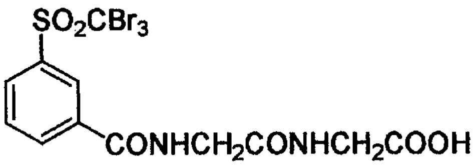

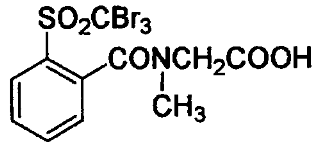

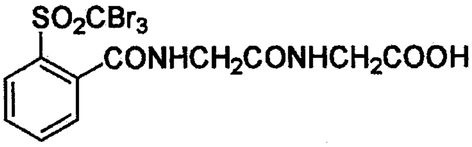

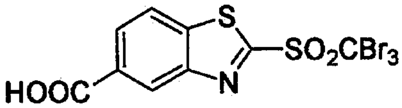

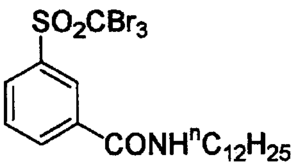

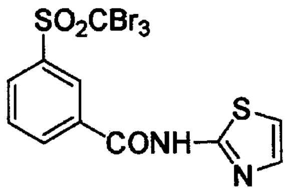

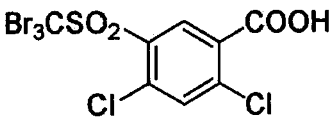

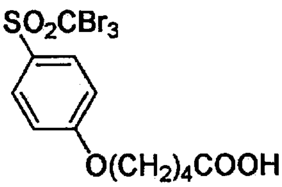

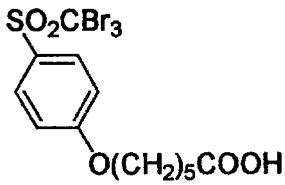

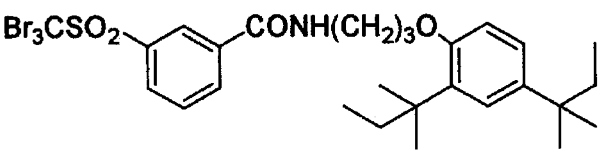

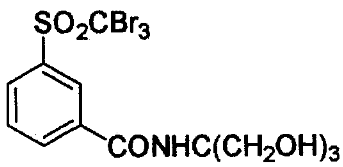

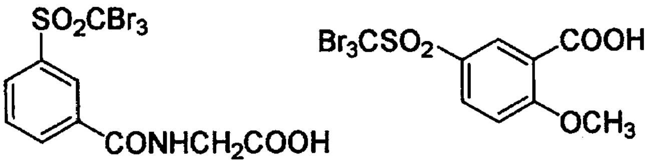

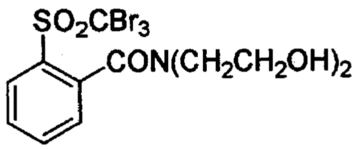

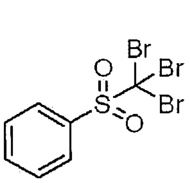

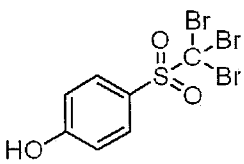

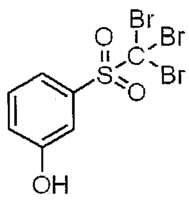

(IS-1) (IS-2) (IS-3)

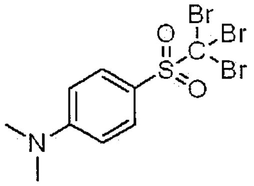

(IS-4)

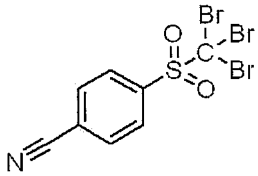

(IS-5)

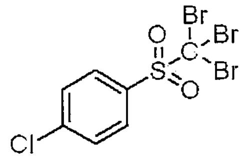

(IS-6)

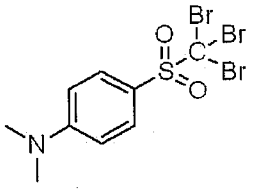

(IS-7)

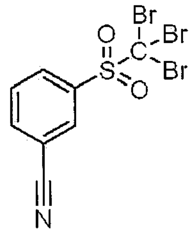

(IS-8)

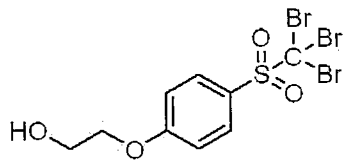

(IS-9)

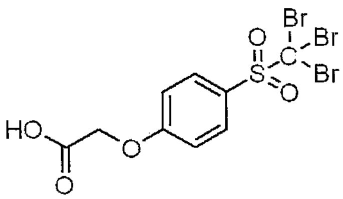

(IS-10)

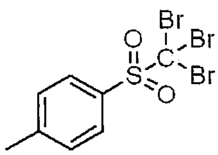

(IS-11)

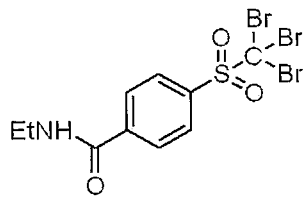

(IS-12)

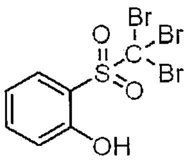

(IS-13)

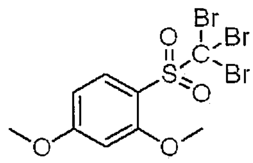

(IS-14)

From the viewpoints of the chemical resistance and the UV printing durability, the lowest unoccupied molecular orbital (LUMO) of the electron-accepting polymerization initiator is preferably -3.00 eV or less and more preferably -3.02 eV or less.

Further, the lower limit thereof is preferably -3.80 eV or greater and more preferably -3.60 eV or greater.

The content of the electron-accepting polymerization initiator is preferably in a range of 0.1% by mass to 50% by mass, more preferably in a range of 0.5% by mass to 30% by mass, and particularly preferably in a range of 0.8% by mass to 20% by mass with respect to the total mass of the image recording layer.

(Electron-donating polymerization initiator)

From the viewpoint of contributing to improvement of the UV printing durability and the chemical resistance of the lithographic printing plate, the polymerization initiator further contains preferably an electron-donating polymerization initiator and more preferably both an electron-donating polymerization initiator and the electron-donating polymerization initiator described above.

Examples of the electron-donating polymerization initiator include the following 5 kinds of agents.

(i) Alkyl or arylate complex: It is considered that a carbon-hetero bond is cleaved by oxidation to generate an active radical. Specific examples thereof include a borate compound.
(ii) Aminoacetic acid compound: It is considered that a C-X bond on a carbon adjacent to nitrogen is cleaved by oxidation to generate an active radical. It is preferable that X represents a hydrogen atom, a carboxy group, a trimethylsilyl group, or a benzyl group. Specific examples thereof include N-phenylglycines (the phenyl group may have a substituent) and N-phenyliminodiacetic acid (the phenyl group may have a substituent).
(iii) Sulfur-containing compound: The nitrogen atom of the above-described aminoacetic acid compound can be replaced with a sulfur atom to generate an active radical by the same action as described above. Specific examples thereof include phenylthioacetic acid (the phenyl group may have a substituent).
(iv) Tin-containing compound: The nitrogen atom of the above-described aminoacetic acid compound can be replaced with a tin atom to generate an active radical by the same action as described above.
(v) Sulfinates: An active radical can be generated by oxidation. Specific examples thereof include sodium arylsulfinate.

Among these electron-donating polymerization initiators, it is preferable that the image recording layer contains a borate compound. As the borate compound, a tetraaryl borate compound or a monoalkyl triaryl borate compound is preferable. Further, from the viewpoint of the stability of the compound, a tetraaryl borate compound is more preferable, and a tetraphenyl borate compound is particularly preferable.
The counter cation of the borate compound is not particularly limited, and an alkali metal ion or a tetraalkylammonium ion is preferable, and a sodium ion, a potassium ion, or a tetrabutylammonium ion is more preferable.
Specific preferred examples of the borate compound include sodium tetraphenyl borate.
Further, from the viewpoints of the chemical resistance and the UV printing durability, the highest occupied molecular orbital (HOMO) of the electron-donating polymerization initiator used in the present invention is preferably -6.00 eV or greater, more preferably -5.95 eV or greater, and still more preferably -5.93 eV or greater.
Further, the upper limit thereof is preferably -5.00 eV or less and more preferably -5.40 eV or less.
In the present specification, the highest occupied molecular orbital (HOMO) and the lowest unoccupied molecular orbital (LUMO) are calculated by the following method.
First, the counter anion in the compound to be calculated is ignored.
Quantum chemistry calculation software Gaussian09 is used, and structural optimization is performed by DFT (B3LYP/6 - 31G (d)).
The molecular orbital (MO) energy calculation is performed by DFT (B3LYP/6 - 31 + G (d, p)/CPCM (solvent = methanol)) using the structure obtained by the structural optimization described above.
The MO energy Ebare (unit: hartree) obtained by the MO energy calculation is converted to Escaled (unit: eV) used as the values of HOMO and LUMO in the present specification according to the following equation.

$$\text{Escaled} = 0.823168 \times 27.2114 \times \text{Ebare} - 1.07634$$

Further, 27.2114 is a coefficient for simply converting hartree to eV, 0.823168 and -1.07634 are adjustment coefficients for determining the calculation of HOMO and LUMO of the compound to be calculated so as to match measured values.
B-1 to B-8 and other compounds are shown below as specific preferred examples of the electron-donating polymerization initiator, but it goes without saying that the present invention is not limited thereto. Further, in the following chemical formulae, Bu represents an n-butyl group, and Z represents a counter cation.
Examples of the counter cation represented by $Z^+$ include $Na^+$, $K^+$, and $N^+(Bu)_4$. Further, Bu represents an n-butyl group.
Further, suitable examples of the counter cation represented by $Z^+$ include an onium ion in the electron-accepting polymerization initiator described above.

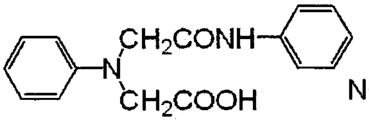

B-1

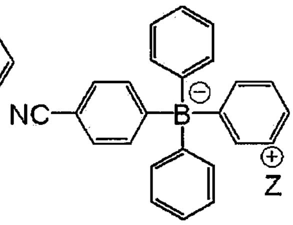

B-2
HOMO=-6.052eV

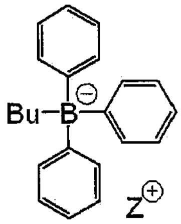

B-3
HOMO=-5.772eV

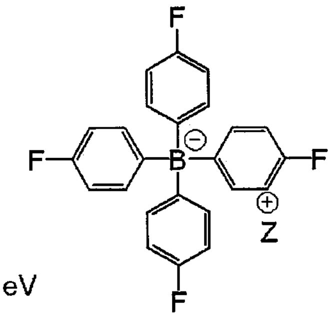

B-4
HOMO=-5.957eV

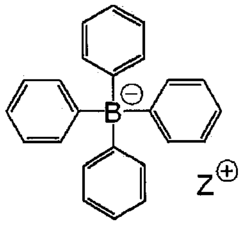

B-5
HOMO=-5.905eV

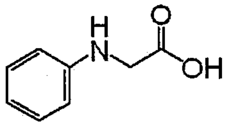

B-6

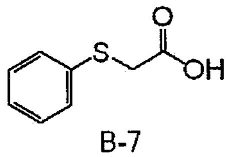

B-7

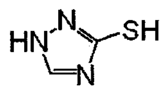

B-8

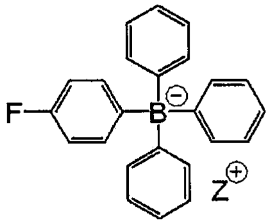

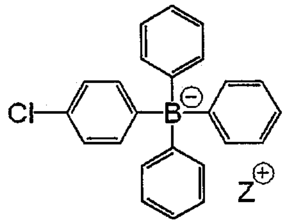

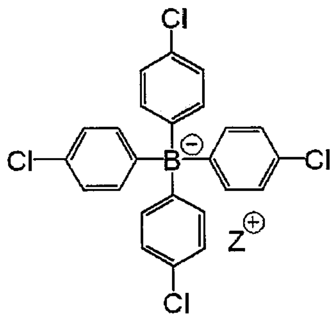

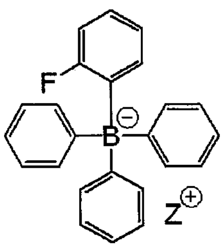

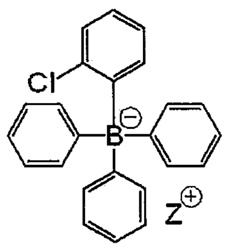

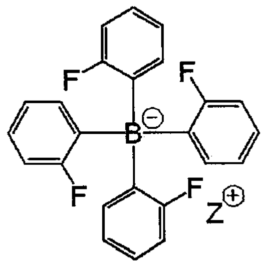

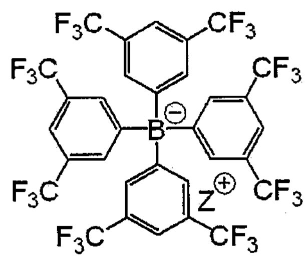

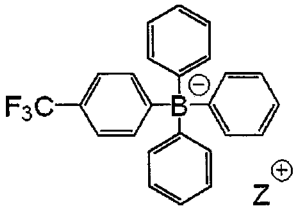

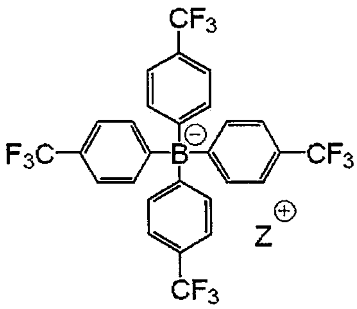

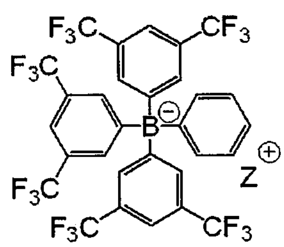

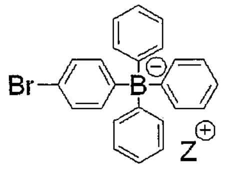
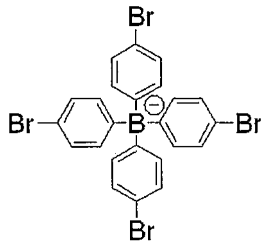
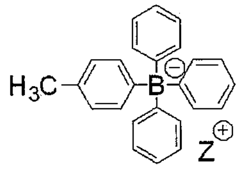
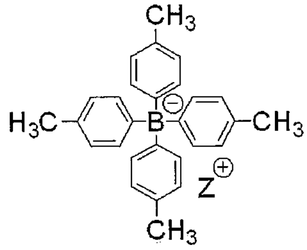

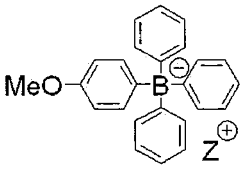
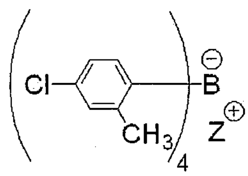
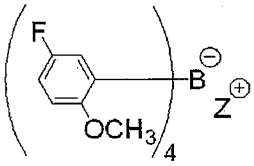
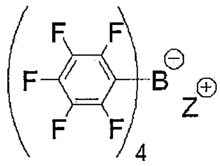

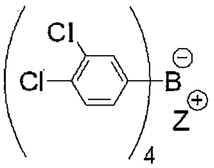
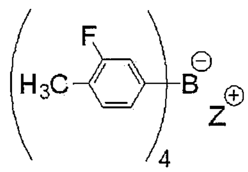
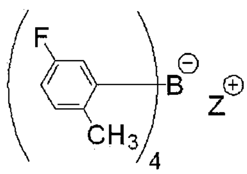
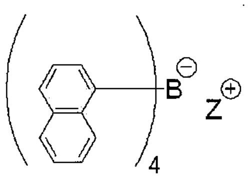

The electron-donating polymerization initiator may be used alone or in combination of two or more kinds thereof.

The content of the electron-donating polymerization initiator is preferably in a range of 0.01% by mass to 30% by mass, more preferably in a range of 0.05% by mass to 25% by mass, and still more preferably in a range of 0.1% by mass to 20% by mass with respect to the total mass of the image recording layer.

Further, one preferable aspect in the present invention is an aspect in which the electron-accepting polymerization initiator and the electron-donating polymerization initiator form a salt.

Specific examples thereof include an aspect in which the onium compound is a salt of an onium ion and an anion (for example, a tetraphenyl borate anion) in the electron-donating polymerization initiator. Further, more preferred examples thereof include an iodonium borate compound in which an iodonium cation (for example, a di-p-tolyl iodonium cation) in the iodonium salt compound and a borate anion in the electron-donating polymerization initiator form a salt.

Specific examples of the aspect in which the electron-accepting polymerization initiator and the electron-donating polymerization initiator form a salt are shown below, but the present invention is not limited thereto.

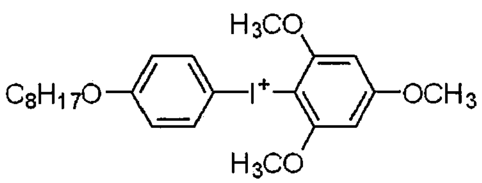

BF4-

(IA-1)

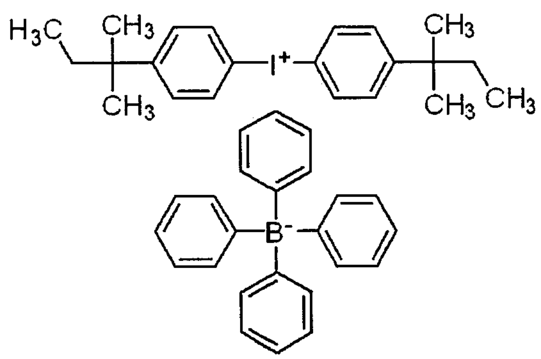

(IA-2)

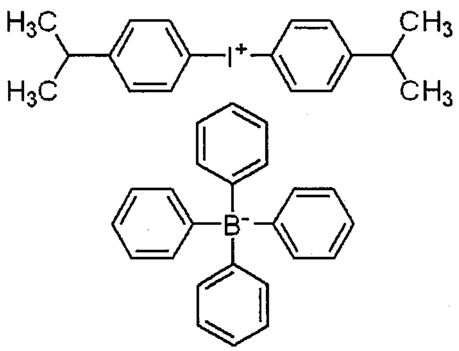

(IA-3)

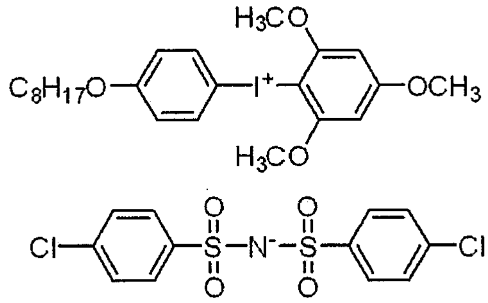

(IA-4)

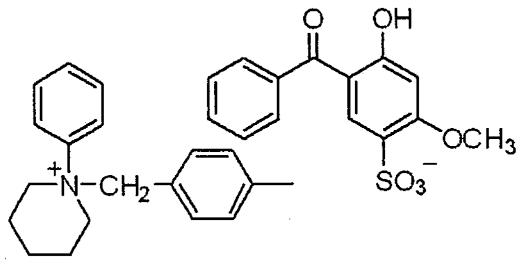

(IA-5)

The content of the polymerization initiator is preferably in a range of 0.1% to 50% by mass and more preferably in a range of 0.5% to 30% by mass with respect to the total mass of the image recording layer 16.

In the present invention, from the viewpoints of the UV printing durability and the chemical resistance, a difference between the HOMO of the electron-donating polymerization initiator and the HOMO of the infrared absorbing agent is preferably 1.00 eV or less and more preferably 0.700 eV or less. Further, from the same viewpoint as described above, the difference between the HOMO of the electron-donating polymerization initiator and the HOMO of the infrared absorbing agent is preferably -0.200 eV or greater and more preferably -0.100 eV or greater.

Further, from the same viewpoint as described above, the difference between the HOMO of the electron-donating polymerization initiator and the HOMO of the infrared absorbing agent is preferably in a range of 1.00 eV to -0.200 eV and more preferably in a range of 0.700 eV to -0.100 eV. Further, the negative values indicate that the HOMO of the electron-donating polymerization initiator is greater than the HOMO of the infrared absorbing agent.

Further, in the present invention, from the viewpoints of the UV printing durability and the chemical resistance, a difference between the LUMO of the infrared absorbing agent and the LUMO of the electron-accepting polymerization initiator is preferably 1.00 eV or less and more preferably 0.700 eV or less. Further, from the same viewpoint as described above, the difference between the LUMO of the infrared absorbing agent and the LUMO of the electron-accepting polymerization initiator is preferably -0.200 eV or greater and more preferably -0.100 eV or greater.

Further, from the same viewpoint as described above, the difference between the LUMO of the infrared absorbing agent and the LUMO of the electron-accepting polymerization initiator is preferably in a range of 1.00 eV to -0.200 eV and more preferably in a range of 0.700 eV to -0.100 eV. Further, the negative values indicate that the LUMO of the infrared absorbing agent is greater than the LUMO of the electron-accepting polymerization initiator.

<Polymerizable compound>

It is preferable that the image recording layer 16 contains a polymerizable compound.

As the polymerizable compound, an addition-polymerizable compound having at least one ethylenically unsaturated bond is preferable. Among the examples, a compound having at least one (preferably two) terminal ethylenically unsaturated bond is more preferable. A so-called radically polymerizable compound is more preferable.

Examples of the polymerizable compound include the polymerizable compounds described in paragraphs [0142] to [0163] of JP2009-255434A.

In the present invention, from the viewpoint of the UV printing durability, the image recording layer contains preferably a tri- or higher functional polymerizable compound, more preferably a hepta- or higher functional polymerizable group, and still more preferably a deca- or higher functional polymerizable group, as the polymerizable compound.

Further, from the viewpoint of the UV printing durability of the lithographic printing plate to be obtained, the polymerizable compound contains preferably a tri- or higher functional (preferably hepta- or higher functional and more preferably deca- or higher functional) ethylenically unsaturated compound and more preferably a tri- or higher functional (preferably hepta- or higher functional and more preferably deca- or higher functional) (meth)acrylate compound.

Further, a urethane-based addition-polymerizable compound produced using the addition reaction between isocyanate and a hydroxyl group is also suitable. Specific examples thereof include a vinyl urethane compound containing two or more polymerizable vinyl groups in one molecule which is obtained by adding a vinyl monomer that contains a hydroxyl group represented by Formula (A) to a polyisocyanate compound containing two or more isocyanate groups in one molecule described in JP1973-41708B (JP-S48-41708B).

$$CH_2=C(R^4)COOCH_2CH(R^5)OH \qquad (A)$$

(Here, $R^4$ and $R^5$ represent H or $CH_3$.)

The content of the polymerizable compound is preferably in a range of 3% to 80% by mass and more preferably in a range of 10% to 75% by mass with respect to the total mass of the image recording layer 16.

<Binder polymer>

It is preferable that the image recording layer 16 further contains a binder polymer.

Examples of the binder polymer include known binder polymers. Specific examples of the binder polymer include an acrylic resin, a polyvinyl acetal resin, a polyurethane resin, a polyurea resin, a polyimide resin, a polyamide resin, an epoxy resin, a methacrylic resin, a polystyrene-based resin, a novolak type phenol-based resin, a polyester resin, synthetic rubber, and natural rubber.

The binder polymer may have crosslinking properties in order to improve coated-film hardness of an image area. In order to allow the binder polymer to have the crosslinking property, a crosslinkable functional group such as an ethylenically unsaturated bond may be introduced to the main chain or a side chain of the polymer. The crosslinkable functional group may be introduced by copolymerization.

As the binder polymer, for example, the binder polymers disclosed in paragraphs [0165] to [0172] of JP2009-255434A can be used.

The binder polymer may be a polymer compound in the form of fine particles. In other words, the binder polymer may be polymer particles.

Examples of the polymer compound in the form of fine particles (polymer constituting polymer particles) include homopolymers or copolymers of monomers such as acrylate or methacrylate having structures of ethylene, styrene, vinyl chloride, methyl acrylate, ethyl acrylate, methyl methacrylate, ethyl methacrylate, vinylidene chloride, acrylonitrile, vinyl carbazole, and polyalkylene, and mixtures thereof. More specific examples thereof include a copolymer of a styrene-(meth)acrylonitrile-poly(ethylene glycol)monoalkyl ether (meth)acrylate compound.

The content of the binder polymer is preferably in a range of 5% to 90% by mass and more preferably in a range of 5% to 70% by mass with respect to the total mass of the image recording layer 16.

<Surfactant>

The image recording layer 16 may contain a surfactant in order to promote the on-press developability in a case of start of printing and improve the state of the coated surface.

Examples of the surfactant include a nonionic surfactant, an anionic surfactant, a cationic surfactant, an amphoteric surfactant, and a fluorine-based surfactant.

As the surfactant, the surfactants disclosed in paragraphs [0175] to [0179] of JP2009-255434A can be used.

The content of the surfactant is preferably in a range of 0.001% to 10% by mass and more preferably in a range of 0.01% to 5% by mass with respect to the total mass of the image recording layer 16.

The image recording layer 16 may further contain other compounds in addition to those described above as necessary.

Examples of other compounds include the coloring agent, the printing-out agent, the polymerization inhibitor, the higher fatty acid derivative, the plasticizer, the inorganic particles, and the low-molecular-weight hydrophilic compound disclosed in paragraphs [0181] to [0190] of JP2009-255434A.

Examples of other components further include the hydrophobic precursor (fine particles capable of converting an image recording layer to be hydrophobic at the time addition of heat), the low-molecular-weight hydrophilic compound, the oil sensitizing agent (for example, a phosphonium compound, a nitrogen-containing low-molecular-weight compound, or an ammonium group-containing polymer), and the chain transfer agent disclosed in paragraphs [0191] to [0217] of JP2012-187907A.

Further, examples of other compounds include an acid color developing agent.

The "acid color developing agent" denotes a compound that exhibits a color-developing property by being heated in a state of accepting an electron-accepting compound (for example, a proton such as an acid). As the acid color developing agent, a colorless compound which has a partial skeleton such as a lactone, a lactam, a sultone, a spiropyran, an ester, or an amide and in which these partial skeletons are rapidly ring-opened or cleaved in a case of being brought into contact with an electron-accepting compound is particularly preferable.

As the acid color developing agent, at least one compound selected from the group consisting of a spiropyran compound, a spirooxazine compound, a spirolactone compound, and a spirolactam compound is preferable.

[Other components]

The lithographic printing plate precursor according to the embodiment of the present invention may include layers other than the aluminum support 12a, the undercoat layer 14, and the image recording layer 16 described above.

For example, for the purpose of preventing occurrence of scratches on the image recording layer 16, oxygen blocking oxygen, and preventing ablation in a case of exposure to a high illuminance laser, a protective layer may be provided on the image recording layer 16 as necessary.

Examples of the material used for the protective layer include the materials (such as a water-soluble polymer compound and an inorganic layered compound) described in paragraphs [0213] to [0227] of JP2009-255434A.

[Method of producing lithographic printing plate precursor]

The lithographic printing plate precursor can be produced by combining known methods.

Among such methods, it is preferable that the lithographic printing plate precursor is produced by a production method of performing the following steps in order.

(Roughening treatment step) A step of performing a roughening treatment on an aluminum plate
(Anodization treatment step) A step of anodizing the aluminum plate which has been subjected to the roughening treatment
(Pore widening treatment step) A step of widening the diameters of micropores in the anodized film by bringing the aluminum plate having the anodized film obtained in the anodization treatment step into contact with an acid aqueous solution or an alkaline aqueous solution
(Undercoat layer forming step) A step of forming an undercoat layer on the aluminum support obtained in the pore widening treatment step
(Image recording layer forming step) A step of forming an image recording layer on the undercoat layer

Hereinafter, the procedures of each step will be described in detail.

<Roughening treatment step>

The roughening treatment step is a step of performing a roughening treatment including an electrochemical roughening treatment on a surface of an aluminum plate. It is preferable that the present step is performed before the anodization treatment step described below, but may not be performed in a case where the surface of the aluminum plate already has a preferable surface shape.

The roughening treatment may be carried out by performing only an electrochemical roughening treatment, but may be carried out by combining an electrochemical roughening treatment and a mechanical roughening treatment and/or a chemical roughening treatment.

In a case where the mechanical roughening treatment and the electrochemical roughening treatment are used in combination, it is preferable that the electrochemical roughening treatment is performed after the mechanical roughening treatment.

It is preferable that the electrochemical roughening treatment is performed in an aqueous solution mainly containing nitric acid or hydrochloric acid using a direct current or an alternating current.

The method of performing the mechanical roughening treatment is not particularly limited, and the methods described in JP1975-40047B (JP-S50-40047B) are exemplified.

The chemical roughening treatment is also not particularly limited, and known methods are exemplified.

It is preferable that a chemical etching treatment described below is performed after the mechanical roughening treatment.

The chemical etching treatment to be performed after the mechanical roughening treatment is performed in order to smooth an edge portion of the uneven shape of the surface of the aluminum plate, prevent the ink from being

caught during printing, improve the stain resistance of the lithographic printing plate, and remove unnecessary matter such as polishing material particles remaining on the surface.

As the chemical etching treatment, etching carried out using an acid and etching carried out using an alkali are known, and a chemical etching treatment (hereinafter, also referred to as an "alkali etching treatment") carried out using an alkaline solution is exemplified as a particularly excellent method in terms of etching efficiency.

An alkali agent used for the alkaline solution is not particularly limited, and examples thereof include caustic soda, caustic potash, sodium metasilicate, soda carbonate, soda aluminate, and soda gluconate.

The alkaline solution may contain aluminum ions.

The concentration of the alkali agent in the alkaline solution is preferably 0.01% by mass or greater and more preferably 3% by mass or greater. Further, the concentration thereof is preferably 30% by mass or less and more preferably 25% by mass or less.

In a case where the alkali etching treatment is performed, it is preferable that the chemical etching treatment (hereinafter, also referred to as a "desmutting treatment") is performed using an acidic aqueous solution at a low temperature in order to remove a product generated due to the alkali etching treatment.

The acid used for the acidic aqueous solution is not particularly limited, and examples thereof include sulfuric acid, nitric acid, and hydrochloric acid. The concentration of the acid in the acidic aqueous solution is preferably in a range of 1% by mass to 50% by mass. Further, the temperature of the acidic aqueous solution is preferably in a range of 20 to 80°C.

As the roughening treatment step, a method of performing the treatments in the aspect A or the aspect B in order described below is preferable, and a method of performing the treatments in the aspect B in order described below is more preferable.

(Aspect A)

(2) A chemical etching treatment carried out using an alkaline aqueous solution (first alkali etching treatment)
(3) A chemical etching treatment carried out using an acidic aqueous solution (first desmutting treatment)
(4) An electrochemical roughening treatment carried out using an aqueous solution that mainly contains nitric acid (first electrochemical roughening treatment)
(5) A chemical etching treatment carried out using an alkaline aqueous solution (second alkali etching treatment)
(6) A chemical etching treatment carried out using an acidic aqueous solution (second desmutting treatment)
(7) Electrochemical roughening treatment carried out in aqueous solution mainly containing hydrochloric acid (second electrochemical roughening treatment)
(8) A chemical etching treatment carried out using an alkaline aqueous solution (third alkali etching treatment)
(9) A chemical etching treatment carried out using an acidic aqueous solution (third desmutting treatment)

(Aspect B)

(10) A chemical etching treatment carried out using an alkaline aqueous solution (fourth alkali etching treatment)
(11) A chemical etching treatment carried out using an acidic aqueous solution (fourth desmutting treatment)
(12) An electrochemical roughening treatment carried out using an aqueous solution that mainly contains hydrochloric acid (third electrochemical roughening treatment)
(13) A chemical etching treatment carried out using an alkaline aqueous solution (fifth alkali etching treatment)
(14) A chemical etching treatment carried out using an acidic aqueous solution (fifth desmutting treatment)

The mechanical roughening treatment (1) may be performed before the treatment (2) of the A aspect described above or before the treatment (10) of the B aspect described above, as necessary.

The amount of the aluminum plate to be dissolved in the first alkali etching treatment and the fourth alkali etching treatment is preferably in a range of 0.5 to 30 $g/m^2$ and more preferably in a range of 1.0 to 20 $g/m^2$.

As the aqueous solution that mainly contains nitric acid used for the first electrochemical roughening treatment according to the A aspect, an aqueous solution used for an electrochemical roughening treatment carried out using the direct current or the alternating current is exemplified. For example, an aqueous solution obtained by adding aluminum nitrate, sodium nitrate, or ammonium nitrate to 1 to 100 g/L of a nitric acid aqueous solution is exemplified.

As the aqueous solution that mainly contains hydrochloric acid used for the second electrochemical roughening treatment according to the A aspect and the third electrochemical roughening treatment according to the B aspect, a

typical aqueous solution used for an electrochemical roughening treatment carried out using the direct current or the alternating current is exemplified. For example, an aqueous solution obtained by adding 0 to 30 g/L of sulfuric acid to a 1 to 100 g/L hydrochloric acid aqueous solution is exemplified. Further, nitrate ions such as aluminum nitrate, sodium nitrate, and ammonium nitrate; and hydrochloride ions such as aluminum chloride, sodium chloride, and ammonium chloride may be added to this solution.

In particular, in the present invention, as the aqueous solution mainly containing hydrochloric acid used in the third electrochemical roughening treatment in the aspect B, an aqueous solution obtained by adding 0.5 to 5 g/L of sulfuric acid to a 5 to 20 g/L hydrochloric acid aqueous solution is preferably used, and an aqueous solution obtained by further adding aluminum chloride to this aqueous solution and adding 5 to 20 g/L of aluminum ions thereto is more preferably used.

The AC power source waveform of the electrochemical roughening treatment may use a sine wave, a square wave, a trapezoidal wave, and a triangular wave. The frequency is preferably in a range of 0.1 to 250 Hz.

Fig. 3 is a graph showing an example of an alternating waveform current waveform diagram used for the electrochemical roughening treatment.

In Fig. 3, ta represents an anodic reaction time, tc represents a cathodic reaction time, tp represents a time taken for the current to reach the peak from 0, Ia represents the peak current on an anode cycle side, and Ic represents the peak current on a cathode cycle side. In the trapezoidal wave, the time tp taken for the current to reach the peak from 0 is preferably in a range of 1 to 10 msec. As the preferable conditions for one cycle of the alternating current used for the electrochemical roughening, a ratio tc/ta of the cathodic reaction time tc to the anodic reaction time ta of the aluminum plate is in a range of 1 to 20, a ratio Qc/Qa of an electric quantity Qc in a case of the aluminum plate serving as an anode to an electric quantity Qa in a case of the aluminum plate serving as an anode is in a range of 0.3 to 20, and the anodic reaction time ta is in a range of 5 msec to 1000 msec. The current density is preferably in a range of 10 to 200 $A/dm^2$ in both an anode cycle side Ia and a cathode cycle side Ic of the current in terms of the peak value of the trapezoidal wave. The value of Ic/Ia is preferably in a range of 0.3 to 20. The total electric quantity of the aluminum plate used for the anodic reaction in a case where the electrochemical roughening is completed is preferably in a range of 25 to 1000 $C/dm^2$.

In particular, in the present invention, in the third electrochemical roughening treatment in the aspect B, the total electric quantity of the aluminum plate used for the anodic reaction in a case where the electrochemical roughening is completed is preferably in a range of 150 to 500 $C/dm^2$.

A device illustrated in Fig. 4 can be used for the electrochemical roughening carried out using the alternating current.

Fig. 4 is a side view illustrating an example of a radial type cell in the electrochemical roughening treatment carried out using the alternating current.

In Fig. 4, 50 represents a main electrolytic cell, 51 represents an AC power source, 52 represents a radial drum roller, 53a and 53b represent a main pole, 54 represents an electrolytic solution supply port, 55 represents an electrolytic solution, 56 represents a slit, 57 represents an electrolytic solution passage, 58 represents an auxiliary anode, 60 represents an auxiliary anode cell, and W represents an aluminum plate. In a case where two or more electrolytic cells are used, the electrolysis conditions may be the same as or different from each other.

The aluminum plate W is wound around the radial drum roller 52 disposed by being immersed in the main electrolytic cell 50 and is subjected to the electrolytic treatment by the main poles 53a and 53b connected to the AC power source 51 in the transport process. The electrolytic solution 55 is supplied to the electrolytic solution passage 57 disposed between the radial drum roller 52 and the main pole 53a and between the radial drum roller 52 and the main pole 53b through the slit 56 from the electrolytic solution supply port 54. The aluminum plate W which has been treated in the main electrolytic cell 50 is electrolyzed in the auxiliary anode cell 60. The auxiliary anode 58 is disposed in the auxiliary anode cell 60 so as to face the aluminum plate W and the electrolytic solution 55 is supplied so as to flow through the space between the auxiliary anode 58 and the aluminum plate W.

From the viewpoint of easily producing a predetermined lithographic printing plate precursor, the amount of the aluminum plate to be dissolved in the second alkali etching treatment is preferably 1.0 $g/m^2$ or greater and more preferably in a range of 2.0 $g/m^2$ to 10 g/m2.

From the viewpoint of easily producing a predetermined printing plate precursor, the amount of the aluminum plate to be dissolved in the third alkali etching treatment and the five alkali etching treatment is preferably in a range of 0.01 to 0.8 $g/m^2$ and more preferably in a range of 0.05 to 0.3 $g/m^2$.

In the chemical etching treatments (first to fifth desmutting treatments) carried out using an acidic aqueous solution, an acidic aqueous solution containing phosphoric acid, nitric acid, sulfuric acid, chromic acid, hydrochloric acid, or mixed acids obtained by mixing two or more of these acids is suitably used.

The concentration of the acid in the acidic aqueous solution is preferably in a range of 0.5% to 60% by mass.

<Anodization treatment step>

The procedures of the anodization treatment step are not particularly limited as long as the above-described micropores are obtained, and known methods are exemplified.
In the anodization treatment step, an aqueous solution containing sulfuric acid, phosphoric acid, oxalic acid, and the like can be used as an electrolytic cell. For example, the concentration of the sulfuric acid is in a range of 100 to 300 g/L.
The conditions for the anodization treatment are appropriately set depending on the electrolytic solution. As an example of the conditions, the liquid temperature is in a range of 5 to 70°C (preferably in a range of 10 to 60°C), the current density is in a range of 0.5 to 60 $A/dm^2$ (preferably in a range of 5 to 60 $A/dm^2$), the voltage is in a range of 1 to 100 V (preferably in a range of 5 to 50 V), the electrolysis time is in a range of 1 to 100 seconds (preferably in a range of 5 to 60 seconds), and the coated film amount is in a range of 0.1 to 5 $g/m^2$ (preferably in a range of 0.2 to 3 $g/m^2$). In particular, in the present invention, the current density is preferably in a range of 5 to 20 $A/dm^2$.

<Pore widening treatment>

The pore widening treatment is a treatment (the pore diameter widening treatment) of expanding the diameter (the pore diameter) of micropores present in the anodized film formed by the above-described anodization treatment step.
The pore widening treatment can be performed by bringing the aluminum plate obtained in the anodization treatment step into contact with an acid aqueous solution or an alkaline aqueous solution. The method of bringing the aluminum plate into contact with the solution is not particularly limited, and examples thereof include an immersion method and a spray method.

<Undercoat layer forming step>

The undercoat layer forming step is a step of forming an undercoat layer on the aluminum support obtained in the pore widening treatment step.
The method of producing the undercoat layer is not particularly limited, and examples thereof include a method of coating the anodized film of the aluminum support with a coating solution for forming an undercoat layer which contains a predetermined compound (such as a compound having a betaine structure).
It is preferable that the coating solution for forming an undercoat layer contains a solvent. Examples of the solvent include water and an organic solvent.
Examples of the method of coating the film with the coating solution for forming an undercoat layer include various known methods. Examples of the known methods include bar coater coating, spin coating, spray coating, curtain coating, dip coating, air knife coating, blade coating, and roll coating.
The coating amount (solid content) of the undercoat layer is preferably in a range of 0.1 to 100 $mg/m^2$ and more preferably in a range of 1 to 50 $mg/m^2$.

<Image recording layer forming step>

The image recording layer forming step is a step of forming an image recording layer on the undercoat layer.
The method of forming the image recording layer is not particularly limited, and examples thereof include a method of coating the undercoat layer with a coating solution for forming an image recording layer that contains a predetermined component (such as the infrared absorbing agent, the polymerization initiator, or the polymerizable compound described above).
It is preferable that the coating solution for forming an image recording layer contains a solvent. Examples of the solvent include water and an organic solvent.
Examples of the method of applying the coating solution for forming an image recording layer include the methods exemplified as the method of applying the coating solution for forming an undercoat layer.
The coating amount (solid content) of the image recording layer varies depending on the purpose thereof, but is typically preferably in a range of 0.3 to 3.0 $g/m^2$.
In a case where a protective layer is provided on the image recording layer, the method of producing the protective layer is not particularly limited, and examples thereof include a method of coating the image recording layer with a coating solution for forming a protective layer which contains a predetermined component.
In the above-described embodiment, the embodiment in which the micropores 22a in the anodized film 20a have a substantially straight tubular shape has been described, but the micropores may have another structure as long as the average diameter of the micropores in the surface of the anodized film is in a predetermined range.
For example, as illustrated in Fig. 5, the aluminum support 12b may include an aluminum plate 18 and an

anodized film 20b having micropores 22b formed of large-diameter pores 24 and small-diameter pores 26.

The micropores 22b in the anodized film 20b are formed of large-diameter pores 24 extending to a position at a depth (depth D: see Fig. 5) of 10 to 1000 nm from the surface of the anodized film and small-diameter pores 26 communicating with the bottom portions of large-diameter pores 24 and extending from a position at a depth of 20 to 2000 nm from the communication positions.

Hereinafter, the large-diameter pores 24 and the small-diameter pores 26 will be described in detail.

The average diameter of the large-diameter pores 24 on the surface of the anodized film 20b is the same as the average diameter of the micropores 22a in the surface of the anodized film 20a described above, and is preferably in a range of 15 to 100 nm and more preferably in a range of 30 to 100 nm.

The method of measuring the average diameter of the large-diameter pores 24 in the surface of the anodized film 20b is the same as the method of measuring the average diameter of the micropores 22a in the surface of the anodized film 20a.

The bottom portions of the large-diameter pores 24 are positioned at a depth of 10 to 1000 nm (hereinafter, also referred to as "depth D") from the surface of the anodized film. In other words, the large-diameter pores 24 are pores extending from the surface of the anodized film to a position at a depth of 10 nm to 1000 nm in the depth direction (thickness direction). The depth is preferably in a range of 10 to 130 nm.

Further, the depth thereof is a value obtained by capturing (at a magnification of 150000) an image of a cross section of the anodized film 20b, measuring the depth of 25 or more large-diameter pores 24, and averaging the obtained values.

The shape of the large-diameter pores 24 is not particularly limited, and examples thereof include a substantially straight tubular shape (substantially columnar shape) and a conical shape whose diameter decreases toward the depth direction (thickness direction). Among these, a substantially straight tubular shape is preferable.

The small-diameter pores 26, as illustrated in Fig. 5, are pores communicating with the bottom portions of the large-diameter pores 24 and further extending from the communication positions to the depth direction (thickness direction).

The average diameter of the small-diameter pores 26 at the communication positions is preferably 13 nm or less, more preferably 11 nm or less, and still more preferably 10 nm or less. The lower limit thereof is not particularly limited, but is 5 nm or greater in many cases.

The average diameter of small-diameter pores 26 is obtained by observing 4 sheets (N = 4) of the surfaces of the anodized film 20a using a FE-SEM at a magnification of 150000, measuring the diameters of micropores (small-diameter pores) present in a range of 400 × 600 $nm^2$ in the obtained four sheets of images, and averaging the values. Further, in a case where the depth of the large-diameter pores is large, the average diameter of the small-diameter pores may be acquired by cutting the upper portion (that is, a region where large-diameter pores are present) of the anodized film 20b (for example, cutting the portion by argon gas) as necessary and observing the surface of the anodized film 20b using the above-described FE-SEM.

Further, in a case where the shape of the small-diameter pores 26 is not circular, an equivalent circle diameter is used. The "equivalent circle diameter" is a diameter of a circle obtained by assuming the shape of an opening portion of a micropore as a circle having the same projected area as the projected area of the opening portion.

The bottom portions of the small-diameter pores 26 are in a position extending from the communication position with the large-diameter pores 24 to a depth of 20 to 2000 nm in the depth direction. In other words, the small-diameter pores 26 are pores extending from the communication positions with the large-diameter pores 24 to the depth direction (thickness direction), and the depth of the small-diameter pores 26 is in a range of 20 to 2000 nm. Further, the depth is preferably in a range of 650 to 2000 nm.

In addition, the depth thereof is a value obtained by capturing (50000 times) an image of a cross section of the anodized film 20b, measuring the depth of 25 or more small-diameter pores, and averaging the obtained values.

The shape of the small-diameter pores 26 is not particularly limited, and examples thereof include a substantially straight tubular shape (substantially columnar shape) and a conical shape whose diameter decreases toward the depth direction. Among these, a substantially straight tubular shape is preferable.

Further, the method of producing the aluminum support 12b is not particularly limited, but a production method of sequentially performing the following steps is preferable.

(Roughening treatment step) A step of performing a roughening treatment on an aluminum plate

(First anodization treatment step) A step of anodizing the aluminum plate which has been subjected to the roughening treatment

(Pore widening treatment step) A step of widening the diameters of micropores in the anodized film by bringing the aluminum plate having the anodized film obtained in the first anodization treatment step into contact with an acid aqueous solution or an alkaline aqueous solution

(Second anodization treatment step) a step of anodizing the aluminum plate obtained by the pore widening treatment

step

Hereinafter, the procedures of each step will be described in detail.

Further, the aspect of the lithographic printing plate precursor using the undercoat layer 14 has been described in Fig. 1. However, as described above, the lithographic printing plate precursor may not include the undercoat layer.

In a case where the undercoat layer is not provided, an image recording layer may be formed after a hydrophilization treatment is performed on the aluminum support.

Examples of the hydrophilization treatment include known methods described in paragraphs 0109 to 0114 of JP2005-254638A. Among the examples, it is preferable that the hydrophilization treatment is performed using a method of immersing the support in an aqueous solution of alkali metal silicate such as sodium silicate or potassium silicate or a method of coating the support with a hydrophilic vinyl polymer of a hydrophilic compound to form a hydrophilic undercoat layer.

The hydrophilization treatment using an aqueous solution of alkali metal silicate such as sodium silicate or potassium silicate can be performed according to the procedures and the methods described in UP2714066A and US3181461A.

[Method of producing lithographic printing plate]

Next, a method of producing a lithographic printing plate using the lithographic printing plate precursor will be described.

The method of producing a lithographic printing plate typically includes an exposing step of imagewise-exposing (image-exposing) the lithographic printing plate precursor to form an exposed portion and an unexposed portion and a step of removing the unexposed portion of the imagewise-exposed lithographic printing plate precursor.

More specifically, according to an aspect of the method of producing a lithographic printing plate, a method of producing a lithographic printing plate which includes an exposing step of imagewise-exposing (image-exposing) the lithographic printing plate precursor to form an exposed portion and an unexposed portion and a removing step of removing the unexposed portion of the lithographic printing plate precursor using a developer with a pH of 2 to 12 is exemplified.

Further, according to another aspect of the method of producing a lithographic printing plate, a method of producing a lithographic printing plate which includes a step of imagewise-exposing (image-exposing) the lithographic printing plate precursor to form an exposed portion and an unexposed portion and an on-press developing step of supplying at least one of printing ink or dampening water and removing the unexposed portion of the imagewise-exposed lithographic printing plate precursor on a printing press is exemplified.

Hereinafter, these embodiments will be described.

The method of producing a lithographic printing plate includes a step of imagewise-exposing (image-exposing) the lithographic printing plate precursor. The image exposure is performed by laser exposure through a transparent original picture having a line image, a halftone image, and the like or by laser beam scanning using digital data.

The wavelength of a light source is preferably in a range of 750 to 1,400 nm. In case of the light source that emits light having a wavelength of 750 nm to 1400 nm, an image recording layer containing an infrared absorbing agent which is a sensitizing dye having absorption in this wavelength range is preferably used.

As the light source having a wavelength of 750 to 1,400 nm, a solid-state laser or a semiconductor laser that radiates infrared rays is exemplified. The output of the infrared laser is preferably 100 mW or greater, the exposure time per one pixel is preferably less than 20 microseconds, and the irradiation energy quantity is preferably in a range of 10 to 300 $mJ/cm^2$. For the purpose of reducing the exposure time, it is preferable to use a multi-beam laser device. The exposure mechanism may be any of an internal drum system, an external drum system, and a flat bed system.

The image exposure can be performed by a known method using a plate setter. In a case of the on-press development method described below, the lithographic printing plate precursor may be image-exposed on the printing press after the lithographic printing plate precursor is mounted on the printing press.

The image-exposed lithographic printing plate precursor is subjected to a development treatment according to a method (developer treatment method) of removing the unexposed portion using a developer with a pH of 2 to 12 or a method (on-press development method) of removing the unexposed portion using at least one of printing ink or dampening water on the printing press.

(Developer treatment method)

In the developer treatment method, the image-exposed lithographic printing plate precursor is treated by a developer with a pH of 2 to 14, and the image recording layer of the unexposed portion is removed to produce a lithographic printing plate.

As the developer, a developer with a pH of 5 to 10 which contains at least one acid group selected from the group consisting of a phosphoric acid group, a phosphonic acid group, and a phosphinic acid group and a compound (specific compound) containing one or more carboxyl groups is preferable.

In a case where the development treatment is carried out manually, a method of allowing sponge or absorbent cotton to sufficiently contain a developer, performing the treatment while rubbing the entire lithographic printing plate precursor, and sufficiently drying the developer after completion of the treatment is exemplified. In a case of an immersion treatment, a method of immersing the lithographic printing plate precursor in a tray, a deep tank, or the like containing a developer therein for approximately 60 seconds, stirring the solution, and sufficiently drying the solution while rubbing the lithographic printing plate precursor with absorbent cotton or sponge is exemplified.

It is preferable that a device capable of simplifying the structure and the steps is used in the development treatment.

In a development treatment of the related art, a protective layer is removed by the pre-water washing step, development is performed using an alkaline developer, an alkali is removed by the post-water washing step, the gum treatment is performed by a gum coating step, and drying is performed by a drying step.

In addition, development and gum coating can be simultaneously performed using one liquid. As the gum, a polymer is preferable, and a water-soluble polymer compound or a surfactant is more preferable.

Further, it is preferable that removal of the protective layer, development, and gum coating are simultaneously performed using one liquid without performing the pre-water washing step. Further, it is preferable that the excessive developer is removed using a squeeze roller after the development and the gum coating and then drying is performed.

The present treatment may be performed according to a method of performing immersion in a developer once or a method of performing immersion twice or more times. Among these, a method of performing immersion in the developer once or twice is preferable.

The immersion may be carried out by passing the exposed lithographic printing plate precursor through a developing tank in which the developer is stored or spraying the developer onto the plate surface of the exposed lithographic printing plate precursor using a spray or the like.

Further, the development treatment is performed using one liquid (one liquid treatment) even in a case where the printing plate precursor is immersed in the developer twice or more times or in a case where the printing plate precursor is immersed, twice or more times, in the same developer as described above or a developer (fatigue liquid) obtained by dissolving or dispersing components of the image recording layer using the developer and the development treatment.

In the development treatment, it is preferable to use a rubbing member and also preferable that a rubbing member such as a brush is installed in a developing bath which removes a non-image area of the image recording layer.

The development treatment can be performed by immersing the lithographic printing plate precursor which has been subjected to the exposure treatment and rubbing the plate surface with brushes or pumping up the treatment liquid added to an external tank using a pump, spraying the developer from a spray nozzle, and rubbing the plate surface with brushes, at a temperature of preferably 0°C to 60°C and more preferably 15°C to 40°C using a known method. These development treatments can be continuously performed plural times. For example, the development treatment can be performed by pumping up the developer added to an external tank using a pump, spraying the developer from a spray nozzle, rubbing the plate surface with brushes, spraying the developer from the spray nozzle again, and rubbing the plate surface with the brushes. In a case where the development treatment is performed using an automatic development device, since the developer becomes fatigued as the treatment amount increases, it is preferable that the treatment capability is recovered using a replenisher or a fresh developer.

The development treatment of the present invention can also be performed using a gum coater or an automatic development device which has been known to be used for a presensitized (PS) plate and CTP in the related art. In a case where an automatic development device is used, for example, any method from among a method of performing the treatment by pumping the developer added to a developing tank or the developer added to an external tank using a pump and spraying the developer from a spray nozzle, a method of performing the treatment by immersing a printing plate in a tank filled with the developer and transporting the printing plate using a guide roller in the developer, and a so-called disposable treatment method, which is a method of performing the treatment by supplying the substantially unused developer by an amount required for each plate can be employed. In all methods, it is more preferable that a rubbing mechanism using brushes or a molleton is provided. For example, commercially available automatic development devices (Clean Out Unit C85/C125, Clean-Out Unit + C85/120, FCF 85V, FCF 125V, FCF News (manufactured by Glunz & Jensen); and Azura CX85, Azura CX125, and Azura CX150 (manufactured by AGFA GRAPHICS) can be used. In addition, a device in which a laser exposure portion and an automatic developing device portion are integrally incorporated can also be used.

(On-press development method)

In the on-press development method, printing ink and dampening water are supplied on the printing press, and the image recording layer of the non-image area is removed to produce a lithographic printing plate using the image-exposed lithographic printing plate precursor.

In other words, the lithographic printing plate precursor is image-exposed, and the lithographic printing plate precursor is directly mounted on the printing press without performing any developer treatment or the printing plate precursor is mounted on the printing press, image-exposed on the printing press, and printed by supplying printing ink and dampening water. At the initial stage of the printing, the image recording layer of the unexposed portion is dissolved or dispersed and removed by the supplied printing ink and/or dampening water in the non-image area, and thus the hydrophilic surface in the removed portion is exposed. Meanwhile, the image recording layer cured by exposure forms an oil-based ink receiving unit having a lipophilic surface in the exposed portion. Printing ink or dampening water may be initially supplied to the plate surface, but it is preferable that printing ink is supplied thereto from the viewpoint of preventing contamination due to the components of the image recording layer from which dampening water has been removed.

In this manner, the lithographic printing plate precursor is on-press developed on the printing press and used as it is for printing a plurality of sheets. That is, according to an aspect of the printing method according to the embodiment of the present invention, a printing method including an exposing step of imagewise-exposing the lithographic printing plate precursor to form an exposed portion and an unexposed portion, and a printing step of performing printing by supplying at least one of printing ink or dampening water and removing the unexposed portion of the imagewise-exposed lithographic printing plate precursor on a printing press is exemplified.

In the method of producing a lithographic printing plate from the lithographic printing plate precursor according to the embodiment of the present invention, regardless of the development method, the entire surface of the lithographic printing plate precursor may be heated before the image exposure, during the image exposure, or during the time period from the image exposure to the development treatment as necessary.

Examples

Hereinafter, the present invention will be described in more detail with reference to examples. The materials, the amounts of materials used, the proportions, the treatment details, the treatment procedure, and the like shown in the examples below can be appropriately changed within a range not departing from the gist of the present invention. Therefore, the scope of the present invention should not be limitatively interpreted by the following examples.

[Examples 1 to 30 and Comparative Examples 1 to 7]

[Production of aluminum support]

An aluminum plate (1050-H18 material, Cu: 0.0014% by mass, Fe: 0.345% by mass, Si: 0.082% by mass) made of a material IS with a thickness of 0.3 mm was subjected to an alkali etching treatment, a desmutting treatment using an acidic aqueous solution, an electrochemical roughening treatment, an alkali etching treatment, a desmutting treatment using an acidic aqueous solution, a first-stage anodization treatment (first anodization treatment), a pore widening treatment, and a second-stage anodization treatment (second anodization treatment), thereby producing an aluminum support.

(1) Alkali etching treatment

An aluminum plate was subjected to an etching treatment by spraying a caustic soda aqueous solution in which the concentration of caustic soda was 26% by mass and the concentration of aluminum ions was 6.5% by mass using a spray at a temperature of 70°C. Thereafter, the aluminum plate was washed with water using a spray. The amount of aluminum dissolved in the surface to be subsequently subjected to an electrochemical roughening treatment was 5 g/$m^2$.

(2) Desmutting treatment using acidic aqueous solution

Next, a desmutting treatment was performed using an acidic aqueous solution. Specifically, the desmutting treatment was performed by spraying the acidic aqueous solution to the aluminum plate for 3 seconds using a spray. As the acidic aqueous solution used for the desmutting treatment, an aqueous solution containing 150 g/L of sulfuric acid was used. The liquid temperature was 30°C.

(3) Electrochemical roughening treatment

Next, an electrochemical roughening treatment was performed using an alternating current using a hydrochloric acid electrolytic solution having the concentration and the liquid temperature listed in Table 1. The aluminum ion concentration was adjusted by adding aluminum chloride. The alternating current waveform was a sine wave with symmetrical positive and negative waveforms, the frequency was set to 50 Hz, the ratio between the anodic reaction time and the cathodic reaction time in one alternating current cycle was set to 1: 1, and a carbon electrode was used for the counter electrode of the aluminum plate. Thereafter, a water washing treatment was performed. In the current density in the electrochemical roughening treatment, the peak value of the AC current waveform was adjusted to the value listed in Table 1, and the total electric quantity of the aluminum plate used for the anodic reaction in a case where the electrochemical roughening treatment is completed was adjusted to the value listed in Table 1.

(4) Alkali etching treatment

The aluminum plate after being subjected to the electrochemical roughening treatment was subjected to an etching treatment by spraying a caustic soda aqueous solution in which the concentration of caustic soda was 5% by mass and the concentration of aluminum ions was 0.5% by mass using a spray at a temperature of 45°C. Thereafter, a water washing treatment was performed. The amount of aluminum dissolved in the surface subjected to the electrochemical roughening treatment was adjusted to the value listed in Table 1.

(5) Desmutting treatment using acidic aqueous solution

Next, a desmutting treatment was performed using an acidic aqueous solution. Specifically, the desmutting treatment was performed by spraying the acidic aqueous solution to the aluminum plate for 3 seconds using a spray. As the acidic aqueous solution used for the desmutting treatment, an aqueous solution having a sulfuric acid concentration of 170 g/L and an aluminum ion concentration of 5 g/L was used. The liquid temperature was 35°C.

(6) First-stage anodization treatment (first anodization treatment)

A first-stage anodization treatment was performed by an anodization device having a structure illustrated in Fig. 6 using direct current electrolysis. Further, the anodization treatment was performed under the conditions listed in Table 1 to form an anodized film having a predetermined film thickness.

(7) Pore widening treatment

The aluminum plate after being subjected to the anodization treatment was subjected to a pore widening treatment by being immersed in a caustic soda aqueous solution having a caustic soda concentration of 5% by mass and an aluminum ion concentration of 0.5% by mass at a temperature of 40°C. Thereafter, the aluminum plate was washed with water using a spray.

(8) Second -stage anodization treatment (second anodization treatment)

A first-stage anodization treatment was performed by an anodization device having a structure illustrated in Fig. 6 using direct current electrolysis. Further, the anodization treatment was performed under the conditions listed in Table 1 to form an anodized film having a predetermined film thickness, thereby preparing an aluminum support.

[Table 1]

| | Alkali etching treatment (g/m²) | Hydrochloric acid electrolytic treatment | | | | | | Alkali etching treatment (g/m²) | First anodization treatment | | | | Pore widening treatment | | Second anodization treatment | | | | Coating solution for forming image recording layer |
|---|---|---|---|---|---|---|---|---|---|---|---|---|---|---|---|---|---|---|---|
| | | Concentration of hydrochloric acid (g/l) | Concentration of sulfuric acid (g/l) | Concentration of A1 (g/l) | Liquid temperature (°C) | Current densityPeak value of AC current waveform ($A/dm^2$) | Electric quantity ($C/dm^2$) | | Concentration of sulfuric acid of electrolytic solution ($A/dm^2$) | Temperature (°C) | Current density ($A/dm^2$) | Coating amount ($g/m^2$) | Temperature (°C) | Time (sec) | Concentration of sulfuric acid of electrolytic solution ($A/dm^2$) | Temperature (°C) | Current density ($A/dm^2$) | Coating amount ($g/m^2$) | |
| Example 1 | 5 | 11.5 | 1.5 | 12 | 35 | 90 | 435 | 0.2 | 170 | 40 | 10 | 0.5 | 35 | 3 | 170 | 40 | 30 | 3.1 | A |
| Example 2 | 5 | 11.5 | 1.5 | 12 | 35 | 90 | 200 | 0.2 | 170 | 40 | 10 | 0.5 | 35 | 3 | 170 | 40 | 30 | 3.1 | A |
| Example 3 | 5 | 11.5 | 1.5 | 12 | 35 | 90 | 200 | 0.1 | 170 | 40 | 10 | 0.5 | 35 | 3 | 170 | 40 | 30 | 3.1 | A |
| Example 4 | 5 | 11.5 | 1.5 | 12 | 35 | 90 | 320 | 0.2 | 170 | 40 | 10 | 0.5 | 35 | 3 | 170 | 40 | 30 | 3.1 | A |
| Example 5 | 5 | 11.5 | 1.5 | 12 | 35 | 90 | 385 | 0.2 | 170 | 40 | 10 | 0.5 | 35 | 3 | 170 | 40 | 30 | 3.1 | A |
| Example 6 | 5 | 11.5 | 1.5 | 12 | 35 | 90 | 470 | 0.5 | 170 | 40 | 10 | 0.5 | 35 | 3 | 170 | 40 | 30 | 3.1 | A |
| Example 7 | 5 | 11.5 | 1.5 | 12 | 35 | 90 | 470 | 0.2 | 170 | 40 | 10 | 0.5 | 35 | 3 | 170 | 40 | 30 | 3.1 | A |
| Example 8 | 5 | 11.5 | 1.5 | 12 | 35 | 90 | 435 | 0.1 | 170 | 40 | 10 | 0.5 | 35 | 3 | 170 | 40 | 30 | 3.1 | A |
| Example 9 | 5 | 11.5 | 1.5 | 12 | 35 | 90 | 435 | 0.25 | 170 | 40 | 10 | 0.5 | 35 | 3 | 170 | 40 | 30 | 3.1 | A |
| Example 10 | 5 | 11.5 | 1.5 | 12 | 35 | 90 | 435 | 0 | 170 | 40 | 10 | 0.5 | 35 | 3 | 170 | 40 | 30 | 3.1 | A |

(continued)

| | Alkali etching treatment ($g/m^2$) | Hydrochloric acid electrolytic treatment | | | | | | Alkali etching treatment ($g/m^2$) | First anodization treatment | | | | Pore widening treatment | | Second anodization treatment | | | | Coating solution for forming image recording layer |
|---|---|---|---|---|---|---|---|---|---|---|---|---|---|---|---|---|---|---|---|
| | | Concentration of hydrochloric acid (g/l) | Concentration of sulfuric acid (g/l) | Concentration of A1 (g/l) | Liquid temperature (°C) | Current density Peak value of AC current waveform ($A/dm^2$) | Electric quantity ($C/dm^2$) | | Concentration of sulfuric acid of electrolytic solution ($A/dm^2$) | Temperature (°C) | Current density ($A/dm^2$) | Coating amount ($g/m^2$) | Temperature (°C) | Time (sec) | Concentration of sulfuric acid of electrolytic solution ($A/dm^2$) | Temperature (°C) | Current density ($A/dm^2$) | Coating amount ($g/m^2$) | |
| Example 11 | 5 | 11.5 | 1.5 | 12 | 35 | 90 | 435 | 0.2 | 170 | 40 | 10 | 0.5 | 22 | 3 | 170 | 40 | 30 | 3.1 | A |
| Example 12 | 5 | 11.5 | 1.5 | 12 | 35 | 90 | 435 | 0.2 | 170 | 40 | 10 | 0.5 | 28 | 3 | 170 | 40 | 30 | 3.1 | A |
| Example 13 | 5 | 11.5 | 1.5 | 12 | 35 | 90 | 435 | 0.2 | 170 | 40 | 10 | 0.5 | 33 | 3 | 170 | 40 | 30 | 3.1 | A |
| Example 14 | 5 | 11.5 | 1.5 | 12 | 35 | 90 | 435 | 0.2 | 170 | 40 | 10 | 0.5 | 37 | 3 | 170 | 40 | 30 | 3.1 | A |
| Example 15 | 5 | 11.5 | 1.5 | 12 | 35 | 90 | 435 | 0.2 | 170 | 40 | 50 | 0.5 | 35 | 3 | 170 | 40 | 30 | 3.1 | A |
| Example 16 | 5 | 11.5 | 1.5 | 12 | 35 | 90 | 435 | 0.2 | 170 | 40 | 40 | 0.5 | 35 | 3 | 170 | 40 | 30 | 3.1 | A |
| Example 17 | 5 | 11.5 | 1.5 | 12 | 35 | 90 | 435 | 0.2 | 170 | 40 | 40 | 0.5 | 39 | 3 | 170 | 40 | 30 | 3.1 | A |
| Example 18 | 5 | 11.5 | 1.5 | 12 | 35 | 90 | 435 | 0.2 | 170 | 40 | 40 | 0.5 | 45 | 3 | 170 | 40 | 30 | 3.1 | A |
| Example 19 | 5 | 11.5 | 1.5 | 12 | 35 | 90 | 435 | 0.2 | 170 | 40 | 30 | 0.5 | 35 | 3 | 170 | 40 | 30 | 3.1 | A |

(continued)

| | Alkali etching treatment ($g/m^2$) | Hydrochloric acid electrolytic treatment | | | | | | Alkali etching treatment ($g/m^2$) | First anodization treatment | | | | Pore widening treatment | | Second anodization treatment | | | | Coating solution for forming image recording layer |
|---|---|---|---|---|---|---|---|---|---|---|---|---|---|---|---|---|---|---|---|
| | | Concentration of hydrochloric acid (g/l) | Concentration of sulfuric acid (g/l) | Concentration of A1 (g/l) | Liquid temperature (°C) | Current density Peak value of AC current waveform ($A/dm^2$) | Electric quantity ($C/dm^2$) | | Concentration of sulfuric acid of electrolytic solution ($A/dm^2$) | Temperature (°C) | Current density ($A/dm^2$) | Coating amount (g/m2) | Temperature (°C) | Time (sec) | Concentration of sulfuric acid of electrolytic solution ($A/dm^2$) | Temperature (°C) | Current density ($A/dm^2$) | Coating amount ($g/m^2$) | |
| Example 20 | 5 | 11.5 | 1.5 | 12 | 35 | 90 | 435 | 0.2 | 170 | 40 | 20 | 0.5 | 35 | 3 | 170 | 40 | 30 | 3.1 | A |
| Example 21 | 5 | 11.5 | 1.5 | 12 | 35 | 90 | 435 | 0.2 | 170 | 40 | 6 | 0.5 | 27 | 3 | 170 | 40 | 30 | 3.1 | A |
| Example 22 | 5 | 11.5 | 1.5 | 12 | 35 | 90 | 435 | 0.2 | 170 | 40 | 3 | 0.5 | 24 | 3 | 170 | 40 | 30 | 3.1 | A |
| Example 23 | 5 | 11.5 | 1.5 | 12 | 35 | 90 | 435 | 0.2 | 170 | 40 | 10 | 1.5 | 35 | 3 | 170 | 40 | 30 | 3.1 | A |
| Example 24 | 5 | 11.5 | 1.5 | 12 | 35 | 90 | 435 | 0.2 | 170 | 40 | 10 | 1.1 | 35 | 3 | 170 | 40 | 30 | 3.1 | A |
| Example 25 | 5 | 11.5 | 1.5 | 12 | 35 | 90 | 435 | 0.2 | 170 | 40 | 10 | 0.6 | 35 | 3 | 170 | 40 | 30 | 3.1 | A |
| Example 26 | 5 | 11.5 | 1.5 | 12 | 35 | 90 | 435 | 0.2 | 170 | 40 | 10 | 0.3 | 35 | 3 | 170 | 40 | 30 | 3.1 | A |
| Example 27 | 5 | 11.5 | 1.5 | 12 | 35 | 90 | 435 | 0.2 | 170 | 40 | 10 | 0.1 | 35 | 3 | 170 | 40 | 30 | 3.1 | A |
| Example 28 | 5 | 11.5 | 0.9 | 12 | 35 | 90 | 435 | 0.2 | 170 | 40 | 10 | 0.1 | 35 | 3 | 170 | 40 | 30 | 3.1 | A |

(continued)

| | | Hydrochloric acid electrolytic treatment | | | | | | | First anodization treatment | | | | Pore widening treatment | | Second anodization treatment | | | | |
|---|---|---|---|---|---|---|---|---|---|---|---|---|---|---|---|---|---|---|---|
| | Alkali etching treatment ($g/m^2$) | Concentration of hydrochloric acid (g/l) | Concentration of sulfuric acid (g/l) | Concentration of A1 (g/l) | Liquid temperature (°C) | Current density Peak value of AC current waveform ($A/dm^2$) | Electric quantity ($C/dm^2$) | Alkali etching treatment ($g/m^2$) | Concentration of sulfuric acid of electrolytic solution ($A/dm^2$) | Temperature (°C) | Current density ($A/dm^2$) | Coating amount (g/m2) | Temperature (°C) | Time (sec) | Concentration of sulfuric acid of electrolytic solution ($A/dm^2$) | Temperature (°C) | Current density ($A/dm^2$) | Coating amount ($g/m^2$) | Coating solution for forming image recording layer |
| Example 29 | 5 | 11.5 | 3.0 | 12 | 35 | 90 | 435 | 0.2 | 170 | 40 | 10 | 0.65 | 35 | 3 | 170 | 40 | 30 | 2.5 | B |
| Example 30 | 5 | 11.5 | 3.0 | 12 | 35 | 90 | 435 | 0.2 | 170 | 40 | 10 | 1.0 | 35 | 3 | 170 | 40 | 30 | 3.1 | B |
| Comparative Example 1 | 5 | 11.5 | 1.5 | 12 | 35 | 90 | 550 | 0.2 | 170 | 40 | 10 | 0.5 | 35 | 3 | 170 | 40 | 30 | 3.1 | A |
| Comparative Example 2 | 5 | 11.5 | 1.5 | 12 | 35 | 90 | 200 | 0 | 170 | 40 | 10 | 0.5 | 35 | 3 | 170 | 40 | 30 | 3.1 | A |
| Comparative Example 3 | 5 | 13 | 0.6 | 15 | 30 | 75 | 435 | 0.2 | 170 | 40 | 10 | 0.5 | 35 | 3 | 170 | 40 | 30 | 3.1 | A |
| Comparative Example 4 | 5 | 13 | 0.3 | 15 | 30 | 75 | 435 | 0.2 | 170 | 40 | 10 | 0.5 | 35 | 3 | 170 | 40 | 30 | 3.1 | A |
| Comparative Example 5 | 5 | 11.5 | 1.5 | 12 | 35 | 90 | 435 | 1.0 | 170 | 40 | 10 | 0.5 | 35 | 3 | 170 | 40 | 30 | 3.1 | A |

(continued)

| | Alkali etching treatment (g/m²) | Hydrochloric acid electrolytic treatment | | | | | | Alkali etching treatment (g/m²) | First anodization treatment | | | | Pore widening treatment | | Second anodization treatment | | | | Coating solution for forming image recording layer |
|---|---|---|---|---|---|---|---|---|---|---|---|---|---|---|---|---|---|---|---|
| | | Concentration of hydrochloric acid (g/l) | Concentration of sulfuric acid (g/l) | Concentration of A1 (g/l) | Liquid temperature (°C) | Current density Peak value of AC current waveform (A/dm²) | Electric quantity (C/dm²) | | Concentration of sulfuric acid of electrolytic solution (A/dm²) | Temperature (°C) | Current density (A/dm²) | Coating amount (g/m2) | Temperature (°C) | Time (sec) | Concentration of sulfuric acid of electrolytic solution (A/dm²) | Temperature (°C) | Current density (A/dm²) | Coating amount (g/m²) | |
| Comparative Example 6 | 5 | 11.5 | 1.5 | 12 | 35 | 90 | 435 | 0.2 | 170 | 40 | 6 | 0.5 | 45 | 3 | 170 | 40 | 30 | 3.1 | A |
| Comparative Example 7 | 5 | 11.5 | 1.5 | 12 | 35 | 90 | 435 | 0.2 | 170 | 40 | 10 | 0.5 | 23 | 3 | 170 | 40 | 30 | 3.1 | A |

The arithmetic average roughness Ra of the surface of the anodized film on a side opposite to a side where the aluminum plate was provided, the steepness a45, the density of specific recesses, the ratio (a45/Ra), the opening ratio of micropores, the density of micropores, the average diameter and depth of the large-diameter pores, and the average diameter and depth of the small-diameter pores were measured by the methods described above with the prepared aluminum support. These results are listed in Table 2.

[Formation of undercoat layer]

The surface of the anodized film of each aluminum support prepared above was coated with a coating solution 1 for forming an undercoat layer such that the dry coating amount was set to 20 mg/$m^2$, thereby forming an undercoat layer.
The coating solution 1 for forming an undercoat layer contained a polymer (0.5 g) represented by the following structural formula, a 1 mass% aqueous solution (0.86 g) of a surfactant (EMALEX 710, manufactured by Nihon Emulsion Co., Ltd.), and water (500 g). The numerical value on the lower right side of the parentheses of each constitutional unit indicates % by mass.

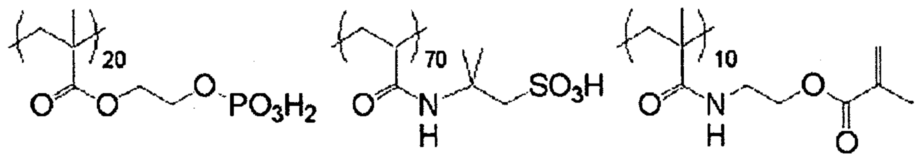

[Formation of image recording layer (Examples 1 to 28 and Comparative Examples 1 to 7)]

The aluminum support on which the undercoat layer had been formed was bar-coated with a coating solution A for forming an image recording layer with the following composition and dried in an oven at 100°C for 60 seconds, thereby forming an image recording layer having a dry coating amount of 1.0 g/$m^2$.
The coating solution A for forming an image recording layer was obtained by mixing a photosensitive liquid (1) and a microgel solution (1) described below immediately before the coating and then stirring the solution.

<Photosensitive liquid>

· Binder polymer (1) [shown below]: 0.240 g
· Polymerization initiator (2) [shown below]: 0.245 g
· Infrared absorbing agent (2) [shown below]: 0.046 g
· Borate compound: 0.010 g

Sodium tetraphenyl borate

· Radically polymerizable compound

Tris (acryloyloxyethyl) isocyanurate
(NK ESTER A-9300 (manufactured by Shin-Nakamura Chemical Co., Ltd.): 0.192 g

· Low-molecular-weight hydrophilic compound: 0.062 g tris(2-hydroxyethyl) isocyanurate
· Low-molecular-weight hydrophilic compound (1) [shown below]: 0.050 g
· Oil sensitizing agent: 0.055 g

Phosphonium compound (1) [shown below]

· Oil sensitizing agent: 0.018 g

Benzyl dimethyl octyl ammonium·$PF_6$ salt

· Oil sensitizing agent: 0.035 g

Ammonium group-containing polymer (1)
[hereafter, reduced specific viscosity of 44 ml/g]

· Fluorine-based surfactant (1) [shown below]: 0.008 g
. 2-Butanone: 1.091 g
· 1-Methoxy-2-propanol: 8.609 g

<Microgel solution>

· Microgel (1): 2.640 g
· Distilled water: 2.425 parts

The structures of the binder polymer (1), the polymerization initiator (2), the infrared absorbing agent (2), the low-molecular-weight hydrophilic compound (1), the phosphonium compound (1), the ammonium group-containing polymer (1), and the fluorine-based surfactant (1), used for the photosensitive liquid, are shown below.

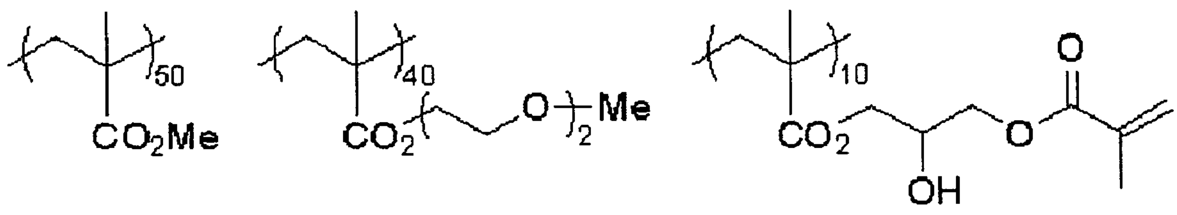

(Mw 70, 000)

Binder polymer (1)

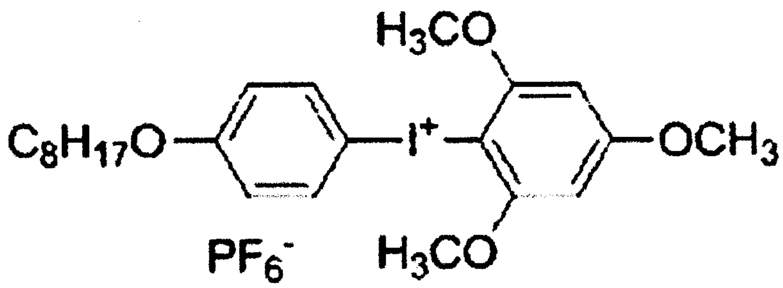

Polymerization initiator (2)

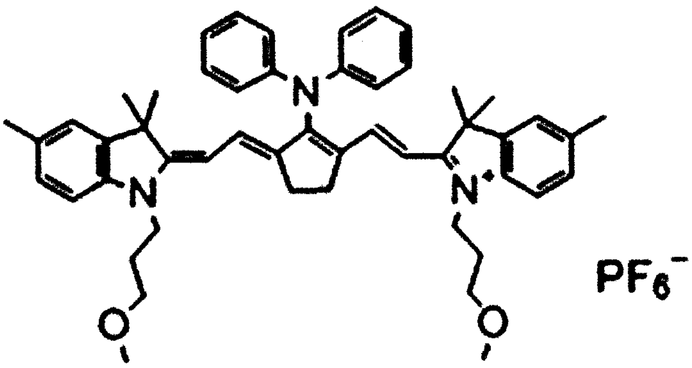

Infrared absorbing agent (2)

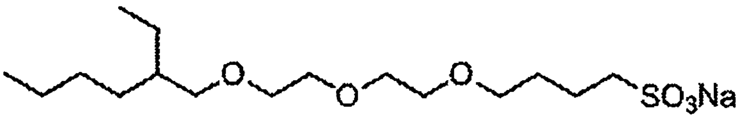

Low-molecular-weight hydrophilic compound (1)

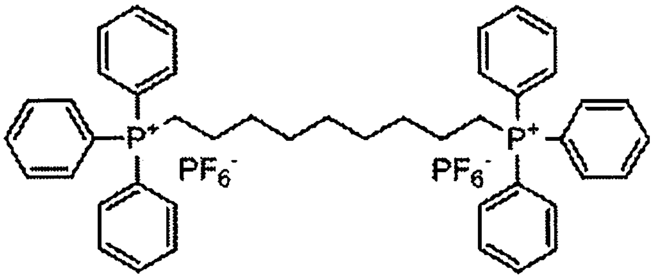

Phosphonium compound (1)

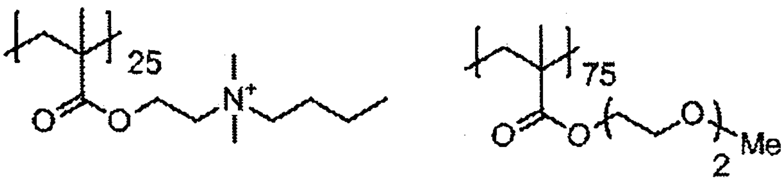

Ammonium group-containing polymer (1)

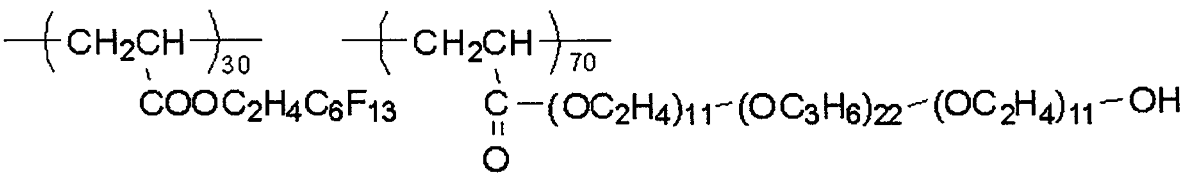

Fluorine-based surfactant (1) (Mw13,000)

- Synthesis of microgel (1) -

10 g of an adduct (manufactured by Mitsui Chemicals, Inc., 50 mass% ethyl acetate solution) obtained by adding 4.46 g of polyfunctional isocyanate (manufactured by Mitsui Chemicals, Inc., 75 mass% ethyl acetate solution) having the following structure, trimethylolpropane (6 moles), and xylene diisocyanate (18 moles) and further adding methyl one-terminal polyoxyethylene (1 mole, repetition number of oxyethylene units: 90), 3.15 g of pentaerythritol triacrylate (SR444, manufactured by Nippon Kayaku Co., Ltd.), and 0.1 g of PIONIN A-41C (manufactured by TAKEMOTO OIL & FAT Co., Ltd.) were dissolved in 17 g of ethyl acetate, thereby obtaining an oil phase component. Further, 40 g of polyvinyl alcohol (PVA-205 manufactured by Kuraray Co., Ltd.) in a 4 mass% aqueous solution polyvinyl alcohol was prepared to obtain a water phase component.

The oil phase component and the water phase component were mixed with each other and emulsified at 12000 rpm for 10 minutes using a homogenizer. The obtained emulsion was added to 25 g of distilled water, and the obtained solution was stirred at room temperature for 30 minutes and further stirred at 50°C for 3 hours. The obtained microgel was diluted with distilled water such that the concentration of solid contents reached 15% by mass, and the resultant was used as a microgel (1). The average particle diameter of the microgel (1) was measured by a light scattering method, and the average particle diameter thereof was 0.2 μm.

Polyfunctional isocyanate

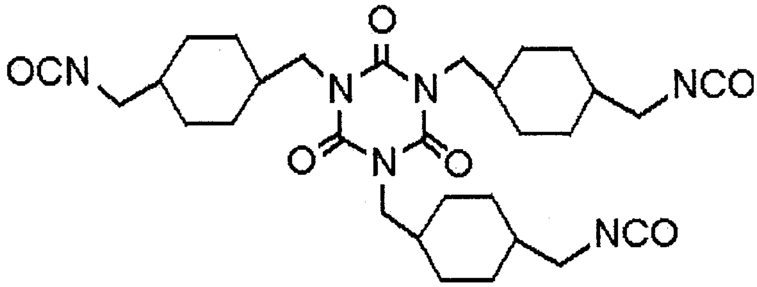

[Formation of image recording layer (Examples 29 and 30)]

The aluminum support on which the undercoat layer had been formed was bar-coated with a coating solution B for forming an image recording layer with the following composition and dried in an oven at 100°C for 60 seconds, thereby forming an image recording layer having a dry coating amount of 1.0 g/m$^2$.

<Coating solution B for forming image recording layer>

Electron-accepting polymerization initiator Int-3 [shown below]: 0.041 parts
Infrared absorbing agent IR-4 [shown below]: 0.027 parts
Infrared absorbing agent IR-5 [shown below]: 0.015 parts
Polymerizable compound M-4 [shown below]: 0.100 parts
Polymerizable compound M-5 [shown below]: 0.096 parts
Polymerizable compound M-6 [shown below]: 0.096 parts
Polymer particles 1 [shown below]: 0.300 parts
Color developing agent (leuco coloring agent) S-2 [shown below]: 0.041 parts
Hydroxypropyl cellulose: 0.030 parts
n-Propanol: 5.168 parts
2-Butanone: 6.460 parts
1-Methoxy-2-propanol: 1.615 parts
Methanol: 2.907 parts

Electron-accepting polymerization initiator Int-3

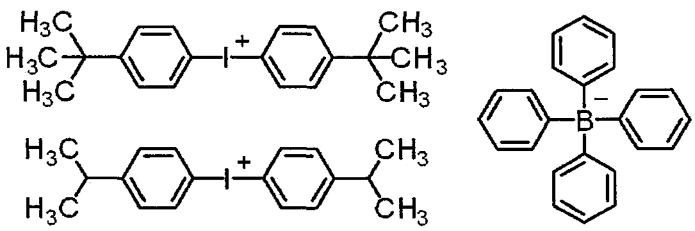

Int - 3

Further, Int-3 is a salt formed such that the two kinds of cations were respectively 0.5 molar equivalents and one anion described above was 1 molar equivalent.

Infrared absorbing agent IR-4 and infrared absorbing agent IR-5

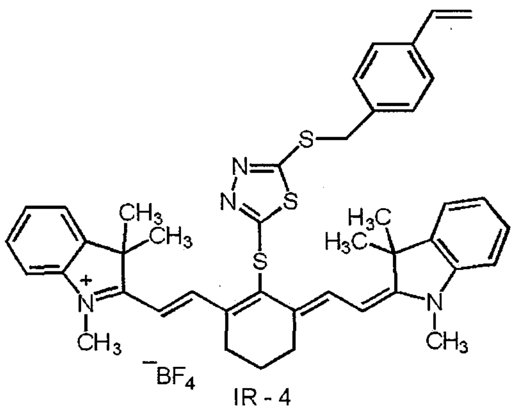

IR - 4

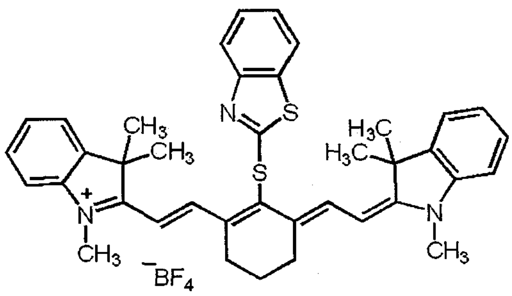

IR - 5

Polymerizable compound M-4 and polymerizable Compound M-5

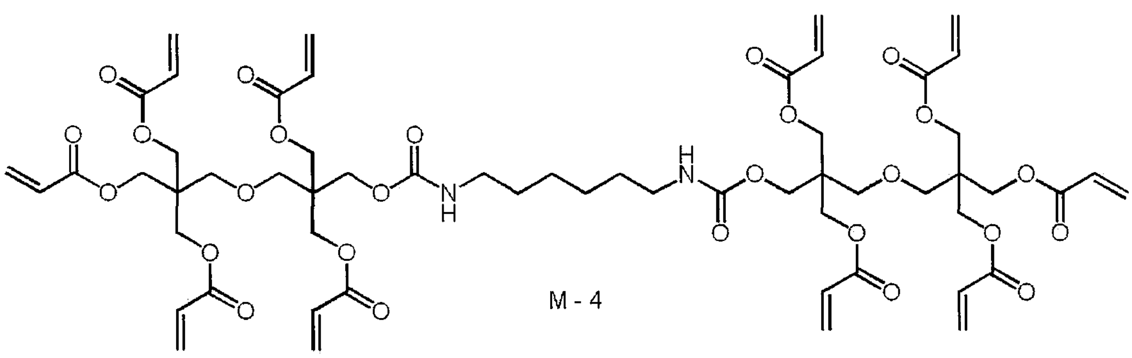

M - 4

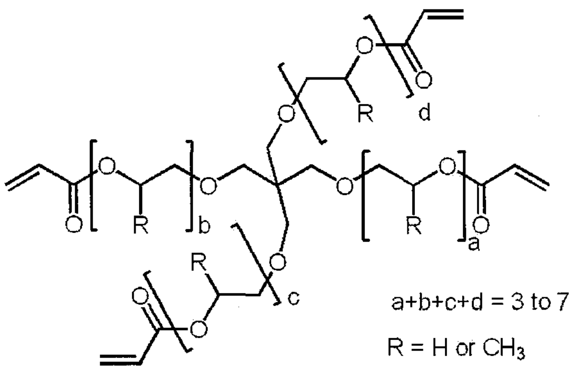

a+b+c+d = 3 to 7

R = H or $CH_3$

M - 5

Polymerizable compound M-6

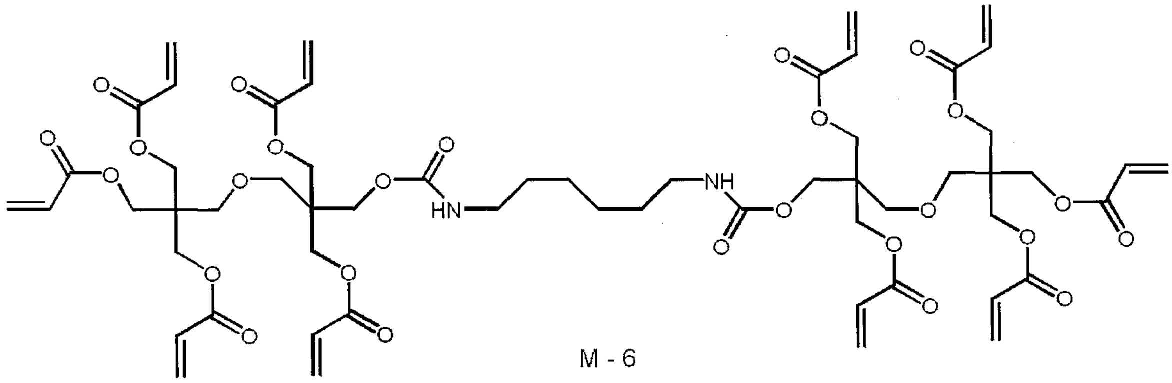

M - 6

Polymer particles 1: resin particles consisting of resin shown below (n = 45, Mw = 50000)

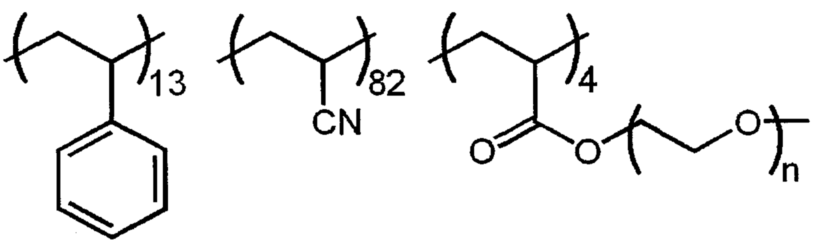

- Synthesis of polymer particles 1 -

Dispersion units, 10.0 parts of the compound B-1 (n = 45) shown below, 85.0 parts of distilled water, and 240.0 parts of n-propanol were added to a four-neck flask, and the mixture was heated and stirred at 70°C in a nitrogen atmosphere.

Next, a mixture of 20.0 parts of the compound A-1 shown below, 70.0 parts of the compound A-2 shown below, and 0.7 parts of 2,2'-azobisisobutyronitrile mixed in advance was added dropwise to the four-neck flask for 2 hours.

After the completion of the dropwise addition, the reaction was allowed to continue for 5 hours, 0.5 part of 2,2'-azobisisobutyronitrile was added to the solution, and the solution was heated to 80°C. 0.4 parts of 2,2'-azobisisobutyronitrile was added thereto every 6 hours, and the solution was allowed to react for a total of 19 hours.

The reaction solution was allowed to be naturally cooled to room temperature (25°C), thereby obtaining a dispersion liquid of polymer particles 1 (solid content of 23%).

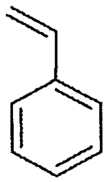

A-1

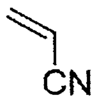

A-2

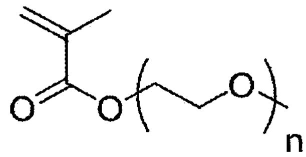

B-1

The median diameter of the polymer particles 1 was 150 nm, and the coefficient of variation was 23%.

Further, as a result of confirmation of the dispersibility of the polymer particles 1 by the method described above, the polymer particles 1 were particles having dispersibility in water and having dispersibility in an organic solvent.

Color developing agent (leuco coloring agent) S-2

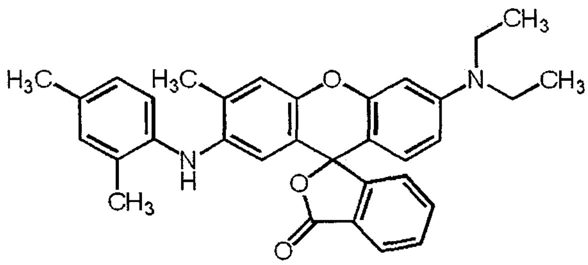

S - 2

[Formation of protective layer]

The image recording layer was further coated with a protective layer coating solution (1) with the following composition using a bar coater and dried in an oven at 120°C for 60 seconds to form a protective layer having a dry coating amount of 0.15 $g/m^2$, thereby preparing a lithographic printing plate precursor.

<Protective layer coating solution (1)>

· Inorganic layered compound dispersion liquid (1): 1.5 g

· 6 mass% aqueous solution of polyvinyl alcohol (CKS50, manufactured by Nippon Synthetic Chemical Industry Co., Ltd., sulfonic acid-modified, saponification degree of 99% by mole or greater, degree of polymerization of 300): 0.55 g

· 6 mass% aqueous solution of polyvinyl alcohol (PVA-405, manufactured by Kuraray Co., Ltd., saponification degree of 81.5% by mole, degree of polymerization of 500): 0.03 g

- Preparation of inorganic layered compound dispersion liquid (1) -

6.4 parts by mass of synthetic mica (SOMASIF ME-100, manufactured by CO-OP CHEMICAL CO., LTD.) was added to 193.6 parts by mass of ion exchange water and dispersed such that the average particle diameter (laser scattering method) was set to 3 $\mu m$ using a homogenizer. The aspect ratio of the obtained dispersed particles was 100 or greater.

[Evaluation method]

[Printing durability]

Each of the obtained lithographic printing plate precursors was exposed by an exposure device (Luxel PLATESETTER T-6000III, manufactured by Fujifilm Corporation) equipped with an infrared semiconductor laser under conditions of an external drum rotation speed of 1000 rpm, a laser output of 70%, and a resolution of 2400 dpi (dot per inch). The exposed image had a solid image, a 3% halftone dot chart of TAFFET A20 (FM screen), and an outline character chart of 7 points of Mincho font. In addition, 1 inch is 25.4 mm.

The obtained exposed lithographic printing plate precursor was attached to the plate cylinder of a printing press Diamond IF2 (manufactured by a Mitsubishi Heavy Industries, Ltd.) without performing a development treatment. The on-press development was performed by supplying dampening water and ink by the standard automatic printing start method of Diamond IF2 using dampening water of IF102 (manufactured by FUJIFILM Corporation)/tap water = 3/97 (volume ratio) and GE carton black ink (manufactured by T&K TOKA Co., Ltd.), and printing was performed on Tokubishi Art (ream weight of 76.5 kg) paper at a printing speed of 10000 sheets per hour.

After the above-described on-press development, printing was further continued. As the number of printed sheets increased, the image recording layer was gradually worn, and thus the ink density on the printed material decreased. The number of printed sheets in a case where the value obtained by measuring the halftone dot area ratio of FM screen 3% halftone dots a Gretag densitometer in the printed material was decreased by 5% than the measured value of the 100th printed sheet was defined as the number of completely printed sheets, and the printing durability was evaluated. The results are listed in Table 2.

[Slip stains]

Printing was performed under the following conditions using a printing press SX-74 (manufactured by Heidelberg) by turning Vario system on (slip dampener mechanism), and reducing the rotation speed of the watering roller with respect to the rotation speed of the plate cylinder, stains on the paper surface after printing was performed on 500 sheets of paper was measured using a spectrophotometer (eXact), and the a value in the color difference Lab was measured.

<Printing conditions>

Ink: DIC Fusion G Red S
Ink density: 1.45 ± 0.05
Dampening water: IF102 (4%)
Temperature control setting: 25°C
Blanket: Day3000-4 (1.95)
Paper: Tokubishi Art (manufactured by Mitsubishi Paper Mills Ltd.)

<Evaluation standards>

The evaluation was performed according to the following standards in order from the plate with excellent slip stain resistance. The results are listed in Table 2.

10 points: the a value is 0.4 or less
9 points: the a value is 0.5 or greater and 0.6 or less
8 points: the a value is 0.7 or greater and 0.8 or less
7 points: the a value is 0.9 or greater and 1.0 or less
6 points: the a value is 1.0 or greater and 1.1 or less
5 points: the a value is 1.1 or greater and 1.2 or less
4 points: the a value is 1.3 or greater and 1.4 or less
3 points: the a value is 1.5 or greater and 1.6 or less
2 points: the a value is 1.7 or greater and 1.8 or less
1 point: the a value is 1.9 or greater

[On-press developability]

Each lithographic printing plate precursor was exposed by an exposure device (Luxel PLATESETTER T-6000III,manufactured by Fujifilm Corporation) equipped with an infrared semiconductor laser under conditions of an external drum rotation speed of 1000 rpm, a laser output of 70%, and a resolution of 2400 dpi. The exposed image had a solid image and a 50% halftone dot chart of a 20 μm dot frequency modulation (FM) screen.

The obtained exposed lithographic printing plate precursor was attached to the plate cylinder of a printing press

LITHRONE26 (manufactured by KOMORI Corporation) without performing a development treatment. Dampening water and ink were supplied using a standard automatic printing start method for LITHRONE26 using dampening water, in which the volume ratio of Ecolity-2 (manufactured by Fujifilm Corporation) to tap water was 2:98, and Values-G (N) black ink (manufactured by DIC Corporation) to perform on-press development, and then printing was performed on 100 sheets of Tokubishi Art (76.5 kg) paper at a printing speed of 10000 sheets per hour. The number of sheets of waste paper required until the on-press development of the unexposed portion of the 50% halftone dot chart was completed on the printing press and the ink was not transferred to the halftone dot non-image area was measured as the on-press developability, and the evaluation was performed according to the following standards in order from the printed sheet with excellent on-press developability. The results are listed in Table 2.

10 points: the number of sheets of waste paper is 5 or less
9 points: the number of sheets of waste paper is in a range of 6 to 10
8 points: the number of sheets of waste paper is in a range of 11 to 15
7 points: the number of sheets of waste paper is in a range of 16 to 19
6 points: the number of sheets of waste paper is in a range of 20 to 25
5 points: the number of sheets of waste paper is in a range of 26 to 29
4 points: the number of sheets of waste paper is in a range of 30 to 34
3 points: the number of sheets of waste paper is in a range of 35 to 39
2 points: the number of sheets of waste paper is in a range of 40 to 50
1 point: the number of sheets of waste paper is 51 or greater

[Table 2]

| | Aluminum support | | | | | | | | | | Evaluation | | |
|---|---|---|---|---|---|---|---|---|---|---|---|---|---|
| | Ra (μm) | Steepness a45 (%) | Density of specific recesses (pc/400 μm) | Ratio a45/Ra | Opening ratio of micropores (%) | Density of micropores (pc/μm$^2$) | Average diameter of large-diameter pores (nm) | Depth of large-diameter pores (nm) | Average diameter of small-diameter pores (nm) | Depth of small-diameter pores (nm) | Printing durability (10000 sheets) | Slip stains (points) | On-press developability (points) |
| Example 1 | 0.5 | 16 | 820 | 32 | 60 | 1050 | 27 | 100 | 10 | 900 | 5.0 | 7 | 7 |
| Example 2 | 0.25 | 8 | 410 | 32 | 60 | 1050 | 27 | 100 | 10 | 900 | 5.8 | 10 | 5 |
| Example 3 | 0.25 | 20 | 420 | 80 | 60 | 1050 | 27 | 100 | 10 | 900 | 5.8 | 6 | 5 |
| Example 4 | 0.31 | 20 | 510 | 65 | 60 | 1050 | 27 | 100 | 10 | 900 | 5.4 | 8 | 6 |
| Example 5 | 0.39 | 14 | 590 | 36 | 60 | 1050 | 27 | 100 | 10 | 900 | 5.4 | 8 | 6 |
| Example 6 | 0.58 | 4 | 780 | 7 | 60 | 1050 | 27 | 100 | 10 | 900 | 4.1 | 6 | 8 |
| Example 7 | 0.58 | 25 | 810 | 43 | 60 | 1050 | 27 | 100 | 10 | 900 | 4.1 | 6 | 8 |
| Example 8 | 0.5 | 19 | 800 | 38 | 60 | 1050 | 27 | 100 | 10 | 900 | 5.2 | 7 | 7 |
| Example 9 | 0.5 | 12 | 780 | 24 | 60 | 1050 | 27 | 100 | 10 | 900 | 4.3 | 9 | 7 |
| Example 10 | 0.5 | 23 | 810 | 46 | 60 | 1050 | 27 | 100 | 10 | 900 | 5.6 | 6 | 7 |
| Example 11 | 0.5 | 16 | 820 | 32 | 21 | 1050 | 16 | 100 | 10 | 900 | 4.4 | 7 | 8 |
| Example 12 | 0.5 | 16 | 820 | 32 | 40 | 1050 | 22 | 100 | 10 | 900 | 4.9 | 7 | 7 |
| Example 13 | 0.5 | 16 | 820 | 32 | 56 | 1050 | 26 | 100 | 10 | 900 | 4.7 | 7 | 8 |
| Example 14 | 0.5 | 16 | 820 | 32 | 65 | 1050 | 28 | 100 | 10 | 900 | 5.1 | 7 | 7 |
| Example 15 | 0.5 | 16 | 820 | 32 | 21 | 370 | 27 | 100 | 10 | 900 | 4.2 | 7 | 7 |
| Example 16 | 0.5 | 16 | 820 | 32 | 25 | 430 | 27 | 100 | 10 | 900 | 4.6 | 7 | 7 |
| Example 17 | 0.5 | 16 | 820 | 32 | 30 | 430 | 30 | 100 | 10 | 900 | 4.4 | 7 | 7 |
| Example 18 | 0.5 | 16 | 820 | 32 | 41 | 430 | 35 | 100 | 10 | 900 | 5.1 | 7 | 7 |
| Example 19 | 0.5 | 16 | 820 | 32 | 39 | 680 | 27 | 100 | 10 | 900 | 4.7 | 7 | 7 |
| Example 20 | 0.5 | 16 | 820 | 32 | 51 | 890 | 27 | 100 | 10 | 900 | 4.9 | 7 | 7 |
| Example 21 | 0.5 | 16 | 820 | 32 | 69 | 1980 | 21 | 100 | 10 | 900 | 5.2 | 7 | 6 |

(continued)

| | Aluminum support | | | | | | | | | | Evaluation | | |
|---|---|---|---|---|---|---|---|---|---|---|---|---|---|
| | Ra (μm) | Steepness a45 (%) | Density of specific recesses (pc/400 μm) | Ratio a45/Ra | Opening ratio of micropores (%) | Density of micropores (pc/μm²) | Average diameter of large-diameter pores (nm) | Depth of large-diameter pores (nm) | Average diameter of small-diameter pores (nm) | Depth of small-diameter pores (nm) | Printing durability (10000 sheets) | Slip stains (points) | On-press developability (points) |
| Example 22 | 0.5 | 16 | 820 | 32 | 58 | 2300 | 18 | 100 | 10 | 900 | 5.1 | 7 | 4 |
| Example 23 | 0.5 | 16 | 820 | 32 | 60 | 1050 | 27 | 300 | 10 | 700 | 5.9 | 7 | 4 |
| Example 24 | 0.5 | 16 | 820 | 32 | 60 | 1050 | 27 | 210 | 10 | 790 | 5.7 | 7 | 5 |
| Example 25 | 0.5 | 16 | 820 | 32 | 60 | 1050 | 27 | 125 | 10 | 875 | 5.3 | 7 | 6 |
| Example 26 | 0.5 | 16 | 820 | 32 | 60 | 1050 | 27 | 57 | 10 | 943 | 4.4 | 7 | 8 |
| Example 27 | 0.5 | 16 | 820 | 32 | 60 | 1050 | 27 | 20 | 10 | 980 | 4.0 | 7 | 9 |
| Example 28 | 0.5 | 16 | 820 | 32 | 60 | 1050 | 27 | 20 | 10 | 980 | 4.0 | 7 | 9 |
| Example 29 | 0.5 | 10 | 860 | 20 | 60 | 1050 | 27 | 160 | 10 | 980 | 4.2 | 9 | 8 |
| Example 30 | 0.5 | 10 | 860 | 20 | 60 | 1050 | 27 | 200 | 10 | 1300 | 4.5 | 9 | 7 |
| Comparative Example 1 | 0.65 | 16 | 910 | 25 | 60 | 1050 | 27 | 100 | 10 | 900 | 3.2 | 5 | 8 |
| Comparative Example 2 | 0.24 | 28 | 390 | 117 | 60 | 1050 | 27 | 100 | 10 | 900 | 5.0 | 4 | 3 |
| Comparative Example 3 | 0.5 | 28 | 880 | 11 | 60 | 1050 | 27 | 100 | 10 | 900 | 5.0 | 4 | 8 |
| Comparative Example 4 | 0.5 | 28 | 920 | 56 | 60 | 1050 | 27 | 100 | 10 | 900 | 5.0 | 4 | 8 |
| Comparative Example 5 | 0.5 | 2 | 820 | 4 | 65 | 1050 | 28 | 100 | 10 | 900 | 1.5 | 9 | 8 |
| Comparative Example 6 | 0.5 | 16 | 820 | 32 | 83 | 1700 | 25 | 100 | 10 | 900 | 3.4 | 7 | 8 |
| Comparative Example 7 | 0.5 | 16 | 820 | 32 | 19 | 1050 | 15 | 100 | 10 | 900 | 3.1 | 7 | 8 |

As shown in Table 2, it was found that in a case where the arithmetic average roughness Ra of the surface of the anodized film was greater than 0.60 μm, the printing durability was degraded and generation of slip stains was not able to be sufficiently suppressed (Comparative Example 1).

Further, it was found that in a case where the steepness a45 of the surface of the anodized film was greater than 25% and the arithmetic average roughness Ra thereof was less than 0.25 μm, the on-press developability was degraded and generation of slip stains was not able to be sufficiently suppressed (Comparative example 2).

Further, it was found that in a case where the steepness a45 of the surface of the anodized film was greater than 25%, generation of slip stains was not able to be sufficiently suppressed (Comparative Examples 3 and 4). Further, Comparative Example 3 is an example corresponding to WO2019/087516A.

Further, it was found that in a case where the steepness a45 of the surface of the anodized film was less than 3%, the printing durability was degraded (Comparative Example 5).

Further, it was found that in a case where the opening ratio of the micropores was out of a range of 20 to 70%, the printing durability was degraded (Comparative Examples 6 and 7).

On the contrary, it was found that in a case where the opening ratio of the micropores was in a range of 20% to 70%, the steepness a45 of the surface of the anodized film was in a range of 3% to 25%, and the arithmetic average roughness Ra was in a range of 0.25 to 0.60 μm, the on-press developability was excellent, the printing durability in a case where a lithographic printing plate was obtained was satisfactory, and generation of slip stains was able to be suppressed (Examples 1 to 30).

Further, based on the comparison between Examples 1 and 8 to 28 and Examples 29 and 30, it was found that in a case where the image recording layer contained a leuco coloring agent having a phthalide structure or a fluorane structure, the generation of slip stains was more likely to be suppressed.

Explanation of References

ta: anodic reaction time
tc: cathodic reaction time
tp: time until current value reaches peak from zero
Ia: peak current on anode cycle side
Ic: peak current on cathode cycle side
10: lithographic printing plate precursor
12a, 12b: aluminum support
14: undercoat layer
16: image recording layer
18: aluminum plate
20a, 20b: anodized film
22a, 22b: micropore
24: large-diameter pore
26: small-diameter pore
50: main electrolytic cell
51: AC power source
52: radial drum roller
53a, 53b: main pole
54: electrolytic solution supply port
55: electrolytic solution
56: auxiliary anode
60: auxiliary anode cell
W: aluminum plate
610: anodization treatment device
612: power supply tank
614: electrolytic treatment tank
616: aluminum plate
618, 626: electrolytic solution
620: power supply electrode
622, 628: roller
624: nip roller
630: electrolytic electrode

632: cell wall
634: DC power source

## Claims

1. A lithographic printing plate precursor comprising:

   an aluminum support; and
   an image recording layer,
   wherein the aluminum support includes an aluminum plate and an anodized aluminum film disposed on the aluminum plate,
   the anodized film is positioned on a side of the image recording layer with respect to the aluminum plate,
   the anodized film has micropores extending from a surface of the anodized film on the side of the image recording layer in a depth direction,
   the micropores have an opening ratio of 20% to 70%,
   a steepness a45 indicating an area ratio of a portion having an inclining degree of 45° or greater on the surface of the anodized film on the side of the image recording layer, which is obtained by extracting a component having a wavelength of 0.2 to 2 μm, is in a range of 3% to 25%, and
   an arithmetic average roughness Ra on the surface of the anodized film on the side of the image recording layer is in a range of 0.25 to 0.60 μm.

2. The lithographic printing plate precursor according to claim 1, wherein a density of the micropores is 400 to 2000 pc/$\mu m^2$.

3. The lithographic printing plate precursor according to claim 1 or 2, wherein a ratio of a value of the steepness a45 to a value of the arithmetic average roughness Ra is in a range of 9 to 80.

4. The lithographic printing plate precursor according to any one of claims 1 to 3, wherein a density of recesses having a depth of 0.7 μm or greater from a center line, which is obtained by measurement in a range of 400 μm × 400 μm on the surface of the anodized film on the side of the image recording layer using a non-contact three-dimensional roughness meter, is 900 recesses or more.

5. The lithographic printing plate precursor according to any one of claims 1 to 4,

   wherein Al-Fe-based intermetallic compounds are precipitated on the surface of the anodized film on the side of the image recording layer,
   an equivalent circle diameter of the Al-Fe-based intermetallic compounds on the surface of the anodized film on the side of the image recording layer is in a range of 0.5 to 3.0 μm, and
   among the Al-Fe-based intermetallic compounds, a density of intermetallic compounds having an equivalent circle diameter of 0.2 μm or greater on the surface of the anodized film on the side of the image recording layer is 3000 pc/$mm^2$ or greater.

6. The lithographic printing plate precursor according to any one of claims 1 to 5, wherein the aluminum plate contains 0.05% by mass or less of Cu, 0.1% to 0.4% by mass of Fe, and 0.02% to 0.3% by mass of Si, and a remainder consists of Al and inevitable impurities.

7. The lithographic printing plate precursor according to any one of claims 1 to 6,

   wherein the micropores are formed of large-diameter pores extending to a position at a depth of 10 to 1000 nm from the surface of the anodized film on the side of the image recording layer and small-diameter pores communicating with bottom portions of the large-diameter pores and extending to a position at a depth of 20 to 2000 nm from communication positions,
   an average diameter of the large-diameter pores in the surface of the anodized film on the side of the image recording layer is in a range of 15 to 100 nm, and
   an average diameter of the small-diameter pores at the communication positions is 13 nm or less.

8. The lithographic printing method according to claim 7,

wherein a depth of the large-diameter pores is in a range of 10 to 130 nm.

**9.** The lithographic printing method according to claim 7 or 8, wherein the average diameter of the large-diameter pores in the surface of the anodized film on the side of the image recording layer is in a range of 30 to 100 nm.

**10.** The lithographic printing plate precursor according to any one of claims 7 to 9, wherein a depth of the small-diameter pores is in a range of 650 to 2000 nm.

**11.** The lithographic printing plate precursor according to any one of claims 1 to 10,

wherein the image recording layer contains a leuco coloring agent, and
wherein the leuco coloring agent is a leuco coloring agent having a phthalide structure or a fluorane structure.

**12.** The lithographic printing plate precursor according to claim 11,

wherein the leuco coloring agent is a compound represented by any of Formulae (Le-1) to (Le-3),

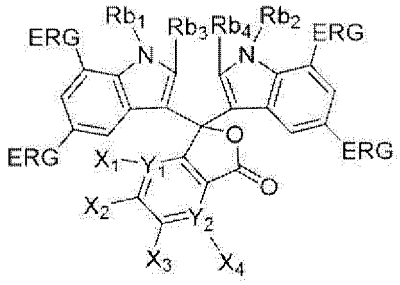
(Le - 1)

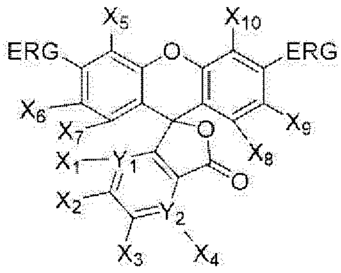
(Le - 2)

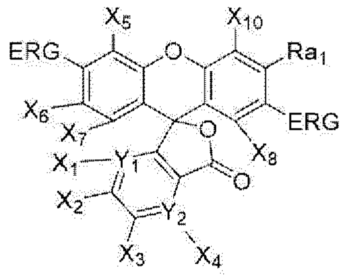
(Le - 3)

in Formulae (Le-1) to (Le-3),
ERG's each independently represent an electron-donating group, $X_1$ to $X_4$ each independently represent a hydrogen atom, a halogen atom, or a dialkylanilino group, $X_5$ to $X_{10}$ each independently represent a hydrogen atom, a halogen atom, or a monovalent organic group, $Y_1$ and $Y_2$ each independently represent C or N, $X_1$ is not present in a case where $Y_1$ represents N, and $X_4$ is not present in a case where $Y_2$ represents N, $Ra_1$ represents a hydrogen atom, an alkyl group, or an alkoxy group, and $Rb_1$ to $Rb_4$ each independently represent a hydrogen atom, an alkyl group, or an aryl group.

**13.** The lithographic printing plate precursor according to any one of claims 1 to 12,

wherein the image recording layer contains an infrared absorbing agent, a polymerization initiator, and a polymerizable compound, and
the polymerization initiator includes an electron-accepting polymerization initiator and an electron-donating polymerization initiator.

**14.** The lithographic printing plate precursor according to claim 13, wherein a difference between HOMO of the infrared absorbing agent and HOMO of the electron-donating polymerization initiator is 0.70 eV or less.

**15.** The lithographic printing plate precursor according to claim 13 or 14, wherein a difference between LUMO of the electron-accepting polymerization initiator and LUMO of the infrared absorbing agent is 0.70 eV or less.

**16.** A method of producing a lithographic printing plate, comprising:

an exposing step of imagewise-exposing the lithographic printing plate precursor according to any one of claims 1 to 15 to form an exposed portion and an unexposed portion; and
a removing step of removing the unexposed portion of the imagewise-exposed lithographic printing plate precursor.

17. A printing method of producing a lithographic printing plate, comprising:

an exposing step of imagewise-exposing the lithographic printing plate precursor according to any one of claims 1 to 15 to form an exposed portion and an unexposed portion; and
a printing step of performing printing by supplying at least one of printing ink or dampening water to remove the unexposed portion of the imagewise-exposed lithographic printing plate precursor on a printing press.

**Patentansprüche**

1. Lithografischer Druckplattenvorläufer, umfassend:

einen Aluminiumträger; und
eine Bildaufzeichnungsschicht,
wobei der Aluminiumträger eine Aluminiumplatte und einen auf der Aluminiumplatte angeordneten eloxierten Aluminiumfilm beinhaltet,
der eloxierte Film auf einer Seite der Bildaufzeichnungsschicht in Bezug auf die Aluminiumplatte positioniert ist,
der eloxierte Film Mikroporen aufweist, die sich von einer Oberfläche des eloxierten Films auf der Seite der Bildaufzeichnungsschicht in einer Tiefenrichtung erstrecken,
die Mikroporen ein Öffnungsverhältnis von 20 % bis 70 % aufweisen,
eine Steilheit a45, die ein Flächenverhältnis eines Abschnitts mit einem Neigungsgrad von 45° oder größer auf der Oberfläche des eloxierten Films auf der Seite der Bildaufzeichnungsschicht angibt, das durch Extrahieren einer Komponente mit einer Wellenlänge von 0,2 bis 2 μm erhalten wird, in einem Bereich von 3 % bis 25 % liegt, und
eine arithmetische mittlere Rauheit Ra auf der Oberfläche des eloxierten Films auf der Seite der Bildaufzeichnungsschicht in einem Bereich von 0,25 bis 0,60 μm liegt.

2. Lithografischer Druckplattenvorläufer nach Anspruch 1,
wobei eine Dichte der Mikroporen 400 bis 2000 pc/$\mu m^2$ beträgt.

3. Lithografischer Druckplattenvorläufer nach Anspruch 1 oder 2,
wobei ein Verhältnis eines Werts der Steilheit a45 zu einem Wert der arithmetischen mittleren Rauheit Ra in einem Bereich von 9 bis 80 liegt.

4. Lithografischer Druckplattenvorläufer nach einem der Ansprüche 1 bis 3,
wobei eine Dichte von Vertiefungen mit einer Tiefe von 0,7 μm oder größer von einer Mittellinie, die durch Messung in einem Bereich von 400 μm × 400 μm auf der Oberfläche des eloxierten Films auf der Seite der Bildaufzeichnungsschicht unter Verwendung eines berührungslosen dreidimensionalen Rauheitsmessgeräts erhalten wird, 900 Vertiefungen oder mehr beträgt.

5. Lithografischer Druckplattenvorläufer nach einem der Ansprüche 1 bis 4,

wobei Al-Fe-basierte intermetallische Verbindungen auf der Oberfläche des eloxierten Films auf der Seite der Bildaufzeichnungsschicht ausgefällt werden,
ein äquivalenter Kreisdurchmesser der Al-Fe-basierten intermetallischen Verbindungen auf der Oberfläche des eloxierten Films auf der Seite der Bildaufzeichnungsschicht in einem Bereich von 0,5 bis 3,0 μm liegt, und,
unter den Al-Fe-basierten intermetallischen Verbindungen, eine Dichte von intermetallischen Verbindungen mit einem äquivalenten Kreisdurchmesser von 0,2 μm oder größer auf der Oberfläche des eloxierten Films auf der Seite der Bildaufzeichnungsschicht 3000 pc/$mm^2$ oder größer ist.

6. Lithografischer Druckplattenvorläufer nach einem der Ansprüche 1 bis 5,
wobei die Aluminiumplatte 0,05 Massen-% oder weniger an Cu, 0,1 bis 0,4 Massen-% an Fe und 0,02 bis 0,3 Massen-% Si enthält und ein Rest aus Al und unvermeidlichen Verunreinigungen besteht.

7. Lithografischer Druckplattenvorläufer nach einem der Ansprüche 1 bis 6,

wobei die Mikroporen aus Poren mit großem Durchmesser, die sich zu einer Position in einer Tiefe von 10 bis 1000 nm von der Oberfläche des eloxierten Films auf der Seite der Bildaufzeichnungsschicht erstrecken, und Poren mit kleinem Durchmesser, die mit unteren Abschnitten der Poren mit großem Durchmesser kommunizieren und sich zu einer Position in einer Tiefe von 20 bis 2000 nm von Kommunikationspositionen erstrecken, gebildet sind,
ein mittlerer Durchmesser der Poren mit großem Durchmesser in der Oberfläche des eloxierten Films auf der Seite der Bildaufzeichnungsschicht in einem Bereich von 15 bis 100 nm liegt, und
ein mittlerer Durchmesser der Poren mit kleinem Durchmesser an den Kommunikationspositionen 13 nm oder weniger beträgt.

**8.** Lithografisches Druckverfahren nach Anspruch 7,
wobei eine Tiefe der Poren mit großem Durchmesser in einem Bereich von 10 bis 130 nm liegt.

**9.** Lithografisches Druckverfahren nach Anspruch 7 oder 8,
wobei der mittlere Durchmesser der Poren mit großem Durchmesser in der Oberfläche des eloxierten Films auf der Seite der Bildaufzeichnungsschicht in einem Bereich von 30 bis 100 nm liegt.

**10.** Lithografischer Druckplattenvorläufer nach einem der Ansprüche 7 bis 9,
wobei eine Tiefe der Poren mit kleinem Durchmesser im Bereich von 650 bis 2000 nm liegt.

**11.** Lithografischer Druckplattenvorläufer nach einem der Ansprüche 1 bis 10,

wobei die Bildaufzeichnungsschicht einen Leukofarbstoff enthält und
wobei der Leukofarbstoff ein Leukofarbstoff mit einer Phthalidstruktur oder einer Fluoranstruktur ist.

**12.** Lithografischer Druckplattenvorläufer nach Anspruch 11,

wobei der Leukofarbstoff eine Verbindung ist, die dargestellt ist durch eine beliebige der Formeln (Le-1) bis (Le-3),

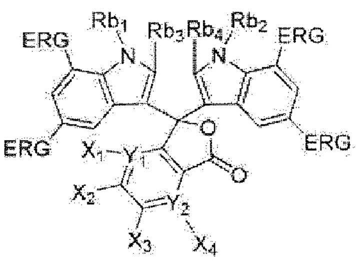
(Le-1)

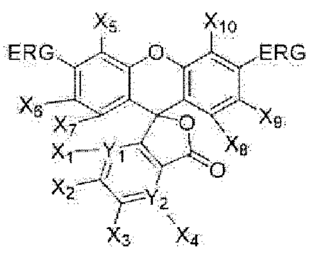
(Le-2)

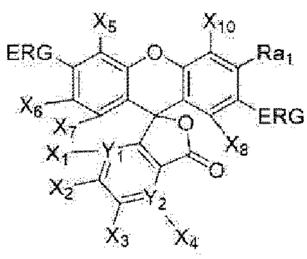
(Le-3)

in Formeln (Le-1) bis (Le-3),
ERGs jeweils unabhängig eine elektronenspendende Gruppe darstellen, $X_1$ bis $X_4$ jeweils unabhängig ein Wasserstoffatom, ein Halogenatom oder eine Dialkylanilinogruppe darstellen, $X_5$ bis $X_{10}$ jeweils unabhängig ein Wasserstoffatom, ein Halogenatom oder eine monovalente organische Gruppe darstellen, $Y_1$ und $Y_2$ jeweils unabhängig C oder N darstellen, $X_1$ nicht vorhanden ist, falls $Y_1$ N darstellt, und $X_4$ nicht vorhanden ist, falls $Y_2$ N darstellt, $Ra_1$ ein Wasserstoffatom, eine Alkylgruppe oder eine Alkoxygruppe darstellt und $Rb_1$ bis $Rb_4$ jeweils unabhängig ein Wasserstoffatom, eine Alkylgruppe oder eine Arylgruppe darstellen.

**13.** Lithografischer Druckplattenvorläufer nach einem der Ansprüche 1 bis 12,

wobei die Bildaufzeichnungsschicht ein Infrarot-Absorptionsmittel, einen Polymerisationsinitiator und eine polymerisierbare Verbindung enthält, und
der Polymerisationsinitiator einen elektronenaufnehmenden Polymerisationsinitiator und einen elektronenspendenden Polymerisationsinitiator beinhaltet.

**14.** Lithografischer Druckplattenvorläufer nach Anspruch 13,
wobei eine Differenz zwischen HOMO des Infrarot-Absorptionsmittels und HOMO des elektronenspendenden Polymerisationsinitiators 0,70 eV oder weniger beträgt.

**15.** Lithografischer Druckplattenvorläufer nach Anspruch 13 oder 14,
wobei eine Differenz zwischen LUMO des elektronenaufnehmenden Polymerisationsinitiators und LUMO des Infrarot-Absorptionsmittels 0,70 eV oder weniger beträgt.

**16.** Verfahren zum Herstellen einer lithografischen Druckplatte, umfassend:

einen Belichtungsschritt zum bildweisen Belichten des lithografischen Druckplattenvorläufers nach einem der Ansprüche 1 bis 15, um einen belichteten Abschnitt und einen unbelichteten Abschnitt zu bilden; und
einen Entfernungsschritt zum Entfernen des unbelichteten Abschnitts des bildweise belichteten lithografischen Druckplattenvorläufers.

**17.** Druckverfahren zum Herstellen einer lithografischen Druckplatte, umfassend:

einen Belichtungsschritt zum bildweisen Belichten des lithografischen Druckplattenvorläufers nach einem der Ansprüche 1 bis 15, um einen belichteten Abschnitt und einen unbelichteten Abschnitt zu bilden; und
einen Druckschritt zum Durchführen des Druckens durch Zuführen mindestens eines von Druckfarbe oder Befeuchtungswasser, um den unbelichteten Abschnitt des bildweise belichteten lithografischen Druckplattenvorläufers auf einer Druckerpresse zu entfernen.

## Revendications

**1.** Précurseur de plaque d'impression lithographique comprenant :

un support d'aluminium ; et
une couche d'enregistrement d'image,
ledit support d'aluminium comprenant une plaque d'aluminium et un film d'aluminium anodisé disposé sur la plaque d'aluminium,
ledit film anodisé étant positionné sur un côté de la couche d'enregistrement d'image par rapport à la plaque d'aluminium,
ledit film anodisé comportant des micropores s'étendant d'une surface du film anodisé sur le côté de la couche d'enregistrement d'image dans un sens de la profondeur,
lesdits micropores comportant un rapport d'ouverture de 20 % à 70 %,
une pente a45 indiquant un rapport de surface d'une partie comportant un degré d'inclinaison supérieur ou égal à 45° sur la surface du film anodisé sur le côté de l'image d'enregistrement d'image, qui est obtenu par extraction d'un composant comportant une longueur d'onde de 0,2 à 2 $\mu$m, se trouvant dans une plage de 3 % à 25 %, et
une rugosité moyenne arithmétique Ra sur la surface du film anodisé sur le côté de la couche d'enregistrement d'image se trouvant dans une plage de 0,25 à 0,60 $\mu$m.

**2.** Précurseur de plaque d'impression lithographique selon la revendication 1,
une densité des micropores étant de 400 à 2000 pc/$\mu m^2$.

**3.** Précurseur de plaque d'impression lithographique selon la revendication 1 ou 2,
un rapport d'une valeur de la pente a45 jusqu'à une valeur de la rugosité moyenne arithmétique Ra se trouvant dans une plage de 9 à 80.

**4.** Précurseur de plaque d'impression lithographique selon l'une quelconque des revendications 1 à 3,
une densité des creux comportant une profondeur supérieure ou égale à 0,7 $\mu$m depuis la ligne médiane, qui est obtenue par la mesure dans une plage de 400 $\mu$m $\times$ 400 $\mu$m sur la surface du film anodisé sur le côté de la couche d'enregistrement d'image à l'aide d'un appareil de mesure de rugosité tridimensionnel sans contact, étant supérieure ou égale à 900 creux.

**5.** Précurseur de plaque d'impression lithographique selon l'une quelconque des revendications 1 à 4,

lesdits composés intermétalliques à base d'Al et de Fe étant précipités sur la surface du film anodisé sur le côté de la couche d'enregistrement d'image,
un diamètre de cercle équivalent des composés intermétalliques à base d'Al et de Fe sur la surface du film anodisé sur le côté de la couche d'enregistrement d'image se trouvant dans une plage de 0,5 à 3,0 $\mu$m, et

parmi les composés intermétalliques à base d'Al et de Fe, une densité des composés intermétalliques comportant un diamètre de cercle équivalent supérieur ou égal à 2 $\mu$m sur la surface du film anodisé sur le côté de la couche d'enregistrement d'image étant supérieure ou égale à 3000 pc/mm$^2$.

**6.** Précurseur de plaque d'impression lithographique selon l'une quelconque des revendications 1 à 5, ladite plaque d'aluminium contenant 0,05 % en masse ou moins de Cu, 0,1 % à 0,4 % en masse de Fe, et 0,02 % à 0,3 % en masse de Si, et un reste étant constitué d'Al et des impuretés inévitables.

**7.** Précurseur de plaque d'impression lithographique selon l'une quelconque des revendications 1 à 6,

lesdits micropores étant formés de pores de grand diamètre s'étendant jusqu'à une position à une profondeur de 10 à 1000 nm de la surface du film anodisé sur le côté de la couche d'enregistrement d'image et de pores de petit diamètre communiquant avec les parties inférieures des pores de grand diamètre et s'étendant jusqu'à une position à une profondeur de 20 à 2000 nm par rapport aux positions de communication,
un diamètre moyen des pores de grand diamètre dans la surface du film anodisé sur le côté de la couche d'enregistrement d'image se trouvant dans une plage de 15 à 100 nm, et
un diamètre moyen des pores de petit diamètre au niveau des positions de communication étant inférieur ou égal à 13 nm.

**8.** Procédé d'impression lithographique selon la revendication 7, une profondeur des pores de grand diamètre se trouvant dans une plage de 10 à 130 nm.

**9.** Procédé d'impression lithographique selon la revendication 7 ou 8, ledit diamètre moyen des pores de grand diamètre dans la surface du film anodisé sur le côté de la couche d'enregistrement d'image se trouvant dans une plage de 30 à 100 nm.

**10.** Précurseur de plaque d'impression lithographique selon l'une quelconque des revendications 7 à 9, une profondeur des pores de petit diamètre se trouvant dans une plage de 650 à 2000 nm.

**11.** Précurseur de plaque d'impression lithographique selon l'une quelconque des revendications 1 à 10,

ladite couche d'enregistrement d'image contenant un agent colorant leuco, et
ledit agent colorant leuco étant un agent colorant leuco comportant une structure de phtalide ou une structure de fluorane.

**12.** Précurseur de plaque d'impression lithographique selon la revendication 11,

ledit agent colorant leuco étant un composé représenté par l'une quelconque des formules (Le-1) à (Le-3),

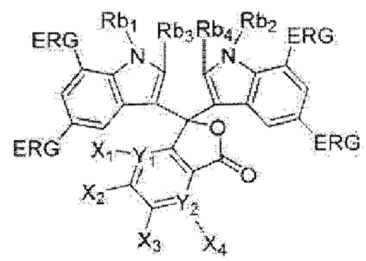
(Le-1)

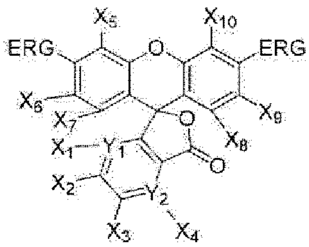
(Le-2)

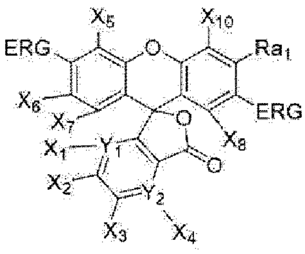
(Le-3)

dans les formules (Le-1) à (Le-3),
les groupes ERG représentent chacun indépendamment un groupe donneur d'électrons, $X_1$ à $X_4$ représentent chacun indépendamment un atome d'hydrogène, un atome d'halogène ou un groupe dialkylanilino, $X_5$ à $X_{10}$ représentent chacun indépendamment un atome d'hydrogène, un atome d'halogène ou un groupe organique monovalent, $Y_1$ à $Y_2$ représentent chacun indépendamment un atome C ou N, $X_1$ n'est pas présent dans un cas où $Y_1$ représente un atome N, et $X_4$ n'est pas présent dans un cas où $Y_2$ représente un atome N, $Ra_1$ représente un atome d'hydrogène, un groupe alkyle ou un groupe alcoxy, et $Rb_1$ à $Rb_4$ représentent chacun indépendamment un atome d'hydrogène, un groupe alkyle ou un groupe aryle.

**13.** Précurseur de plaque d'impression lithographique selon l'une quelconque des revendications 1 à 12,

ladite couche d'enregistrement d'image contenant un agent absorbant les infrarouges, un initiateur de polymérisation et un composé polymérisable, et
ledit initiateur de polymérisation comprenant un initiateur de polymérisation accepteur d'électrons et un initiateur de polymérisation donneur d'électrons.

**14.** Précurseur de plaque d'impression lithographique selon la revendication 13,
une différence entre l'HOMO de l'agent absorbant les infrarouges et l'HOMO de l'initiateur de polymérisation donneur d'électrons étant inférieure ou égale à 0,70 eV.

**15.** Précurseur de plaque d'impression lithographique selon la revendication 13 ou 14,
une différence entre la LUMO de l'initiateur de polymérisation accepteur d'électrons et la LUMO de l'agent absorbant les infrarouges étant inférieure ou égale à 0,70 eV.

**16.** Procédé de production d'une plaque d'impression lithographique, comprenant :

une étape d'exposition permettant l'exposition image par image du précurseur de plaque d'impression lithographique selon l'une quelconque des revendications 1 à 15 pour former une partie exposée et une partie non exposée ; et
une étape de suppression permettant de supprimer la partie non exposée du précurseur de plaque d'impression lithographique exposé image par image.

**17.** Procédé d'impression permettant la production d'une plaque d'impression lithographique comprenant :

une étape d'exposition permettant l'exposition image par image du précurseur de plaque d'impression lithographique selon l'une quelconque des revendications 1 à 15 pour former une partie exposée et une partie non exposée ; et
une étape d'impression permettant d'effectuer l'impression en fournissant au moins une parmi une encre d'impression ou de l'eau de mouillage pour supprimer la partie non exposée du précurseur de plaque d'impression lithographique exposé image par image sur une presse d'impression.

FIG. 1

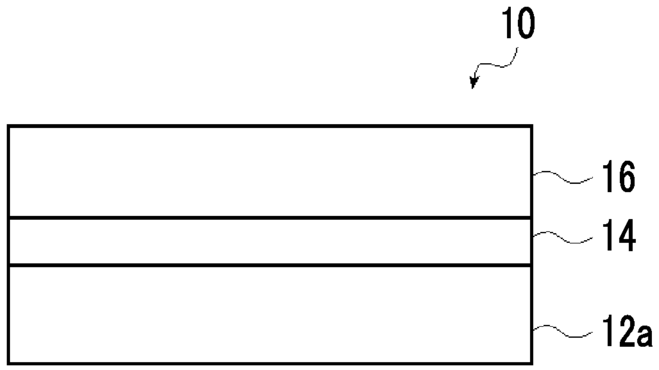


FIG. 2

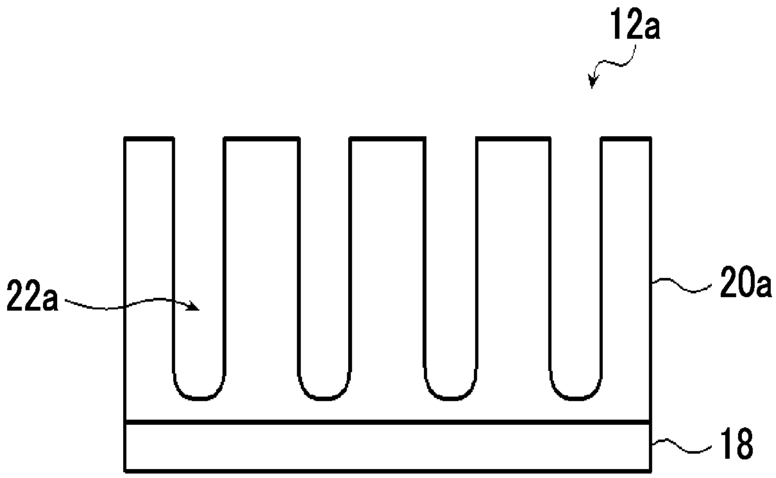

FIG. 3

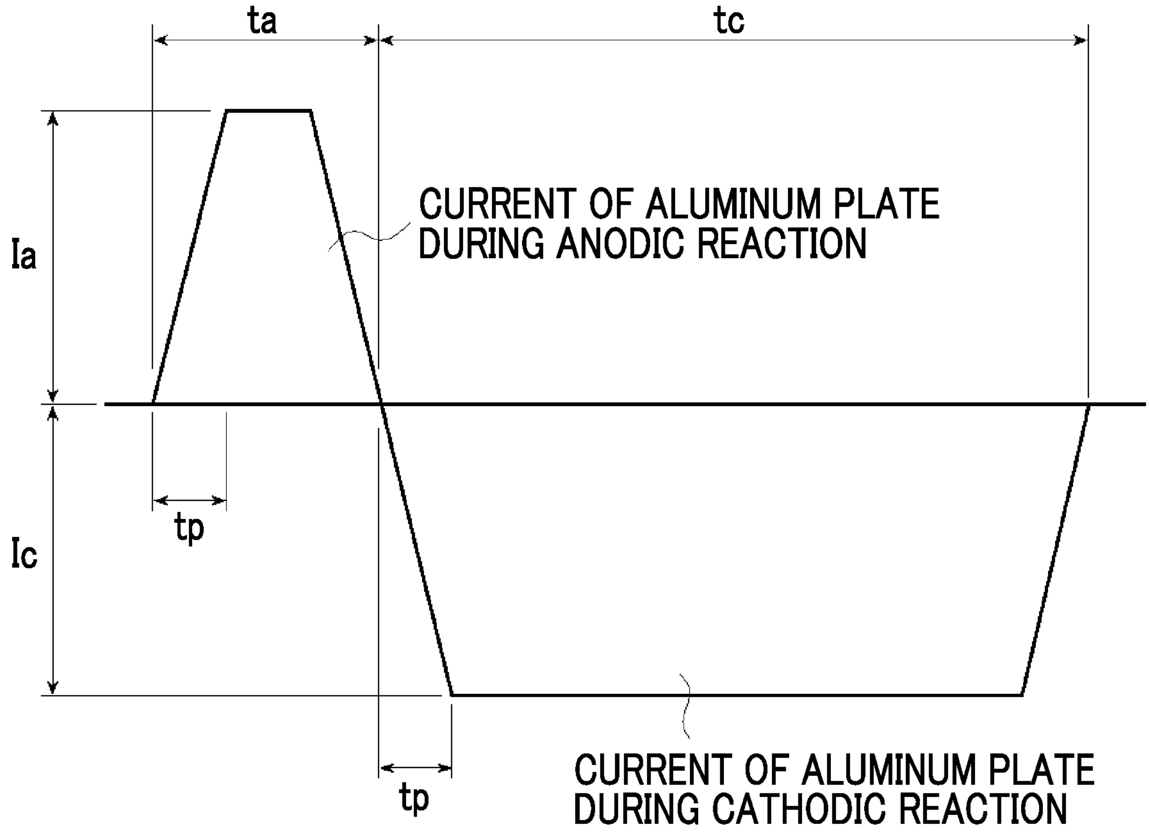
ta
tc
CURRENT OF ALUMINUM PLATE DURING ANODIC REACTION
Ia
Ic
tp
tp
CURRENT OF ALUMINUM PLATE DURING CATHODIC REACTION

FIG. 4

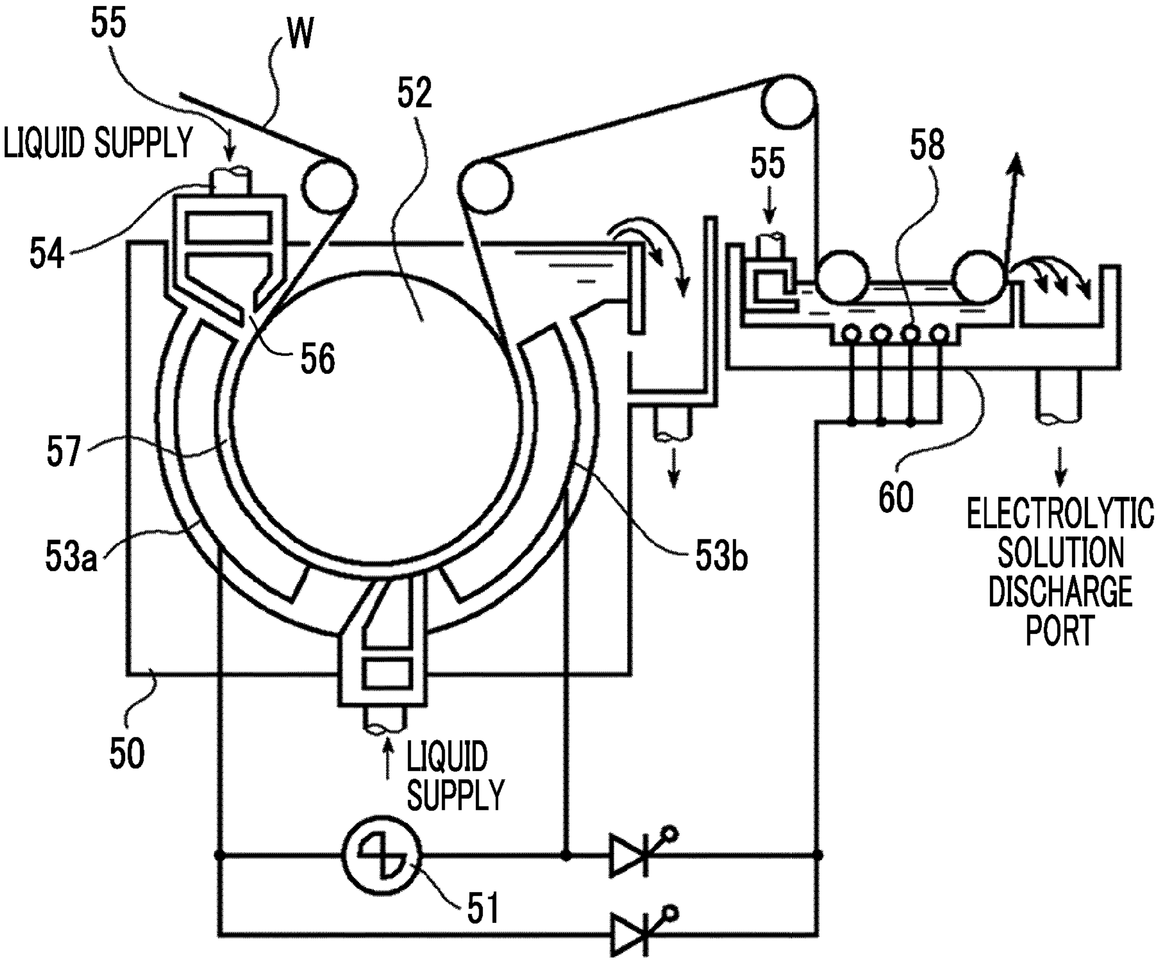
55
W
52
LIQUID SUPPLY
54
55
58
56
57
53a
53b
60
ELECTROLYTIC SOLUTION DISCHARGE PORT
50
LIQUID SUPPLY
51

FIG. 5

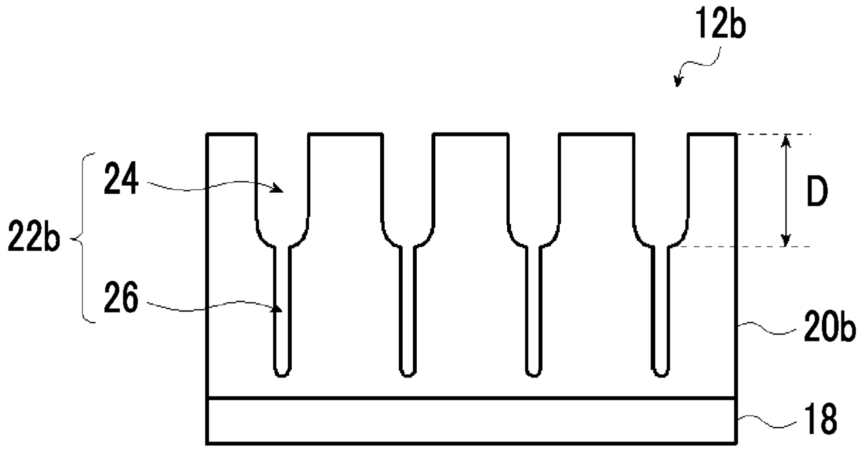
12b
24
22b
26
D
20b
18

FIG. 6

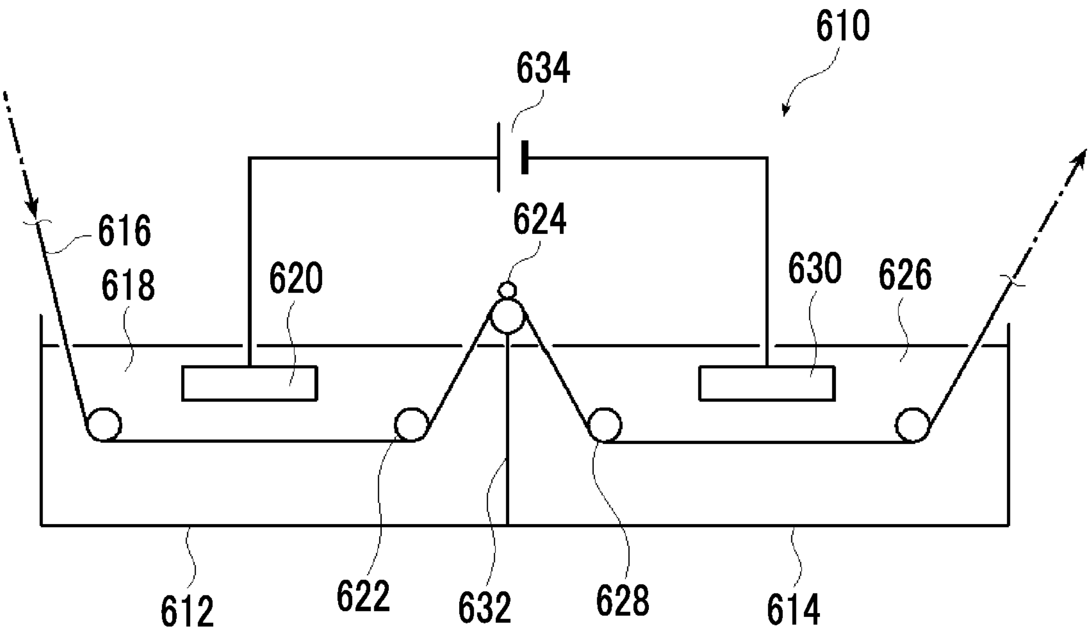

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2019087516 A
- EP 3511172 A1
- JP 2001312068 A
- JP 2008195018 A
- JP 2009255434 A
- JP 8108621 A
- JP H08108621 A
- JP 61166544 A
- JP S61166544 A
- JP 2002328465 A
- JP 2002162741 A
- JP 48041708 B
- JP 2012187907 A
- JP 50040047 B
- JP 2005254638 A
- US 2714066 A
- US 3181461 A


### Non-patent literature cited in the description


- Dye Handbook. The Society of Synthetic Organic Chemistry, 1970